Europäisches Patentamt

European Patent Office

Office européen des brevets

(11) Publication number : **0 480 825 A2**

(12) # EUROPEAN PATENT APPLICATION

(21) Application number : 91402690.1

(22) Date of filing : 08.10.91

(51) Int. Cl.$^5$ : **G01S 5/16, F41G 3/22**

(30) Priority : 09.10.90 US 594172

(43) Date of publication of application :
15.04.92 Bulletin 92/16

(84) Designated Contracting States :
AT BE CH DE ES FR IT LI NL SE

(71) Applicant : **W.W. GAERTNER RESEARCH INC.**
**140 Water Street**
**Norwalk, Connecticut (US)**

(72) Inventor : **Gaertner, Wolfgang W.**
**deceased (US)**
Inventor : **Gaertner, Christopher W.**
**205 Saddle Hill Road**
**Stamford, CT 06903 (US)**

Inventor : **Bostwick, Brian J.**
**19 McIntosh Road**
**Stamford, CT 06903 (US)**
Inventor : **Brady, David E.**
**19 McIntosh Road**
**Stamford, CT 06903 (US)**
Inventor : **Kopke, Thomas C.**
**723 Golden Sunshine Circle**
**Orlando, Fl 32807 (US)**
Inventor : **Cox, Arthur**
**1651 Elk Blvd.**
**Des Plaines, IL 60016 (US)**
Inventor : **Kuipers, Jack**
**3085 Baker Park Drive**
**Grand Rapids, MI 49508 (US)**

(74) Representative : **Bouju, André**
**Cabinet Bouju Derambure (Bugnion) S.A. 38**
**avenue de la Grande Armée**
**F-75017 Paris (FR)**

(54) **Position and orientation measurement system and method.**

(57)  A system and method to measure the relative position and orientation of a remote body, such as a pilot's helmet. At least four high intensity infra red LEDs positioned on the remote body are pulsed one at a time in known sequence. The LEDs are pulsed by diode drivers including NMOS switches. The LEDs have darkened substrates and multiple (nine) heating pads. A multi-element (nine), wide angle, wide aperture, short focal length lens focuses pulsed light spots on a single highly linear, high resolution, two-dimensional duo lateral position sensing diode having a single photoelectric sheet. Low noise transimpedance amplifiers reverse bias the position sensing diode and convert the position sensing diode current signals to voltage signals, then converted by an analog to digital converter to digital signals indicative of the position of pulsed light spots on the position sensing diode. A digital signal processor uses the digital signals to calculate recursively the relative position and orientation of the remote body, in part by comparing calculated sensed and guessed values. Two calculation methods are disclosed for six degrees of freedom, one providing an accuracy generally of around 30 arc seconds and ideally of 3 arc seconds. Update rates of at least several hundred Hz are obtained.

EP 0 480 825 A2

## BACKGROUND OF THE INVENTION

This invention was made with Government support under Contract N61339-89-C-0062 awarded by the Naval Training Systems Center. The Government has certain rights in this invention.

This invention relates to positioning systems and methods to provide for the continuous measurement of the relative position and orientation of a remote body. The invention has particular applicability to a head tracker wherein the position and orientation of an aircraft pilot's helmet in a military cockpit is measured. That determination has numerous uses, for example in helmet or cockpit displays to inform the pilot where to turn his head to observe radar detected objects, to fire missiles at targets in the direction the pilot is looking, etc.

Various kinds of systems have been used in the past for head tracking, but generally have suffered from a number of deficiencies. Accuracies of such systems have often exceeded 5 arc minutes, update rates have been limited to 50-60 Hz, and inherent phase lags have exceeded many milliseconds. The poor accuracy, update rates, resolution, and phase lag of such head trackers place a significant impediment upon the cockpit operation of modern military aircraft.

The prior head tracking systems have included AC and DC magnetic systems, ultrasonic systems and electro-optical systems. AC and DC magnetic head tracker systems have further deficiencies due to their reliance on magnetic properties and the resultant susceptibility to any metal in the cockpit within the sensed environment. Extensive mapping and calibration are required in such systems, and cause inherent inaccuracies. Electro-optical head tracker systems also have encountered difficulties associated with insufficient resolution and inaccurate and hard to maintain arrays of photoelectric elements. Such systems also may include several assemblies of helmet-mounted diode light sources wherein the multiple diodes of each assembly all remain operating at the same time. Among other problems, insufficient light source intensity is obtained.

## SUMMARY OF THE INVENTION

The present invention solves the problems associated with the prior art, and provides a system with great accuracy, high resolution, lower phase lags, and high update rates. Accuracies generally can be obtained lower than 30 arc seconds, and down to 3 arc seconds under ideal conditions. Phase lags of only a few millseconds are obtainable. Update rates of several hundred to thousands of Hz are obtainable.

The present invention includes novel high intensity LED configurations being placed on the pilot's helmet. Each LED configuration is designed and pulsed to enhanced its intensity, and has a novel diode driver associated therewith. The pulsed light is passed through a novel very wide angle, wide aperture, multi-element lens arrangement with a very short focal length, to a novel highly linear two-dimensional position sensing diode comprising a non-arrayed single reflective photoelectric sheet of high resolution. The signals from the position sensing diode are then fed to novel ultra-quiet transimpedance amplifiers, from there to filters and an analog to digital converter, and ultimately to a digital signal processor that carries out novel iterative, recursive computing operations to obtain the desired position and orientation measurements.

## DESCRIPTION OF DRAWINGS

Fig. 1 is a schematic illustration of a head tracker integrated into a typical aircraft system;

Fig. 2 is a schematic illustration showing basic components of the present invention in block diagram format;

Fig. 3 illustrates a possible arrangement of components of the present invention in an aircraft cockpit;

Fig. 4 illustrates an alternative possible arrangement of components of the present invention in an aircraft cockpit;

Fig. 5 is a plan view of an LED configuration of the present invention;

Fig. 6 is an expanded plan view showing heating connections to the LED configuration;

Fig. 7 is a cross-sectional view of the assembled lens of the present invention;

Figs. 7a-7k respectively illustrates the separate optical elements making up the lens of Fig. 7;

Figs. 7l-7m respectively illustrate the two end retaining nuts for the lens of Fig. 7;

Figs. 7n-7s respectively illustrate the spacers used between the optical elements making up the lens of Fig. 7;

Fig. 8 is a generalized showing of a position sensing diode;

Fig. 9 is a schematic of the structure of a duo lateral two dimensional position sensing diode such as used in the present invention;

Fig. 10 illustrates the equivalent circuit of the position sensing diode of Fig. 9;

Fig. 11 illustrates the sensitive surface of the position sensing diode and means from which one can determine the position of a light spot on its surface;

Fig. 12 is a block diagram of a portion of the present invention from the position sensing diode through the digital signal processor;

Fig. 13 is a circuit diagram of the first, pre-amplifier, stage of the transimpedance amplifiers of the present invention;

Fig. 14 is a circuit diagram of the second stage of the transimpedance amplifiers of the present invention;

Fig. 15 illustrates the analog to digital converter of the present invention;

Fig. 16 illustrates an exemplary sample timing diagram of a portion of the present invention;

Fig. 17 illustrates an exemplary timing control of a portion of the present invention;

Fig. 18 is a block diagram of an exemplary digital signal processor of the present invention.

Fig. 19 illustrates an ideal diode driver;

Fig. 20 is a circuit diagram of the diode driver of the present invention;

Fig. 21 is a circuit diagram of the diode driver current source of the present invention;

Fig. 22 is a diagrammatic showing of the processing of information in the present invention; and

Figs. 23-41 illustrate various coordinates, positions and orientations, angles and axes, and other relationships between the remote body (i.e., the helmet), the remote body frame and the sensor or reference frame, to illustrate the computations in the present invention of the relative position and orientation of the remote body.

## DESCRIPTION OF EMBODIMENTS

## Systems and Methods Generally

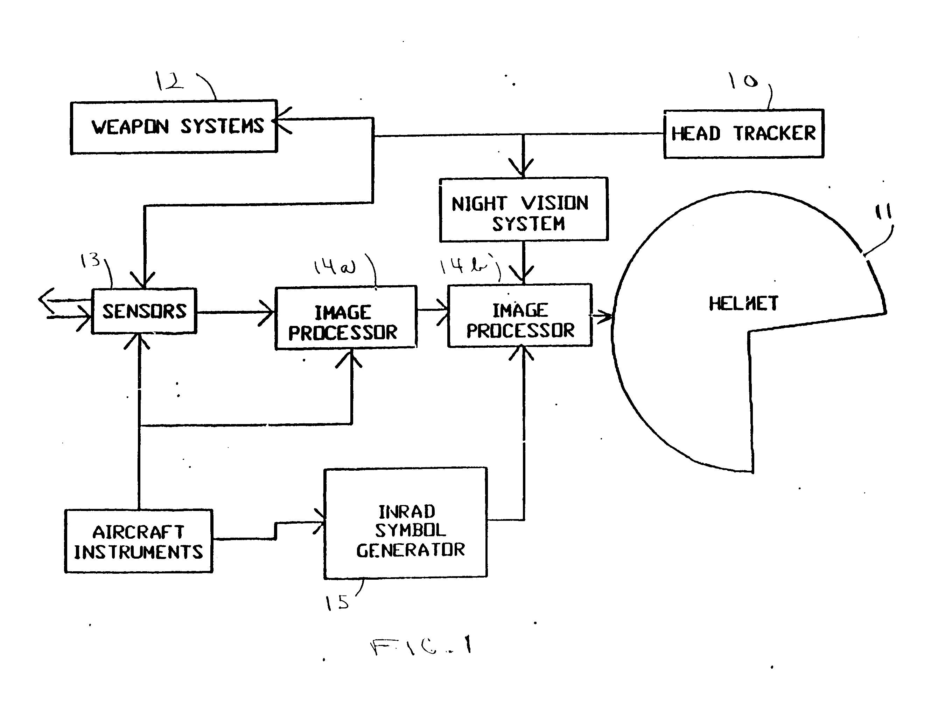

Referring to Fig. 1, a head tracker 10 is shown integrated into a typical aircraft system. Head tracker 10 provides a continuous measure of the relative position and orientation of helmet 11 in three dimensional space. Weapon systems 12 can be controlled by knowing the position and orientation of the pilot's helmet 11. Sensors 13 can provide such parameters as air speed, altitude, thrust, etc. to image processors 14a and 14b, which in turn may provide readings to helmet-mounted display projected in front of the pilot's eyes (so that the pilot does not need to look down at the instrument panel). Head tracker 10 also may provide relevant information to a helmet-mounted display, for example to inform the pilot to look in a given direction, etc. The symbol generator 15 provides real time displays. Such equipment generally is well-known in a military aircraft system.

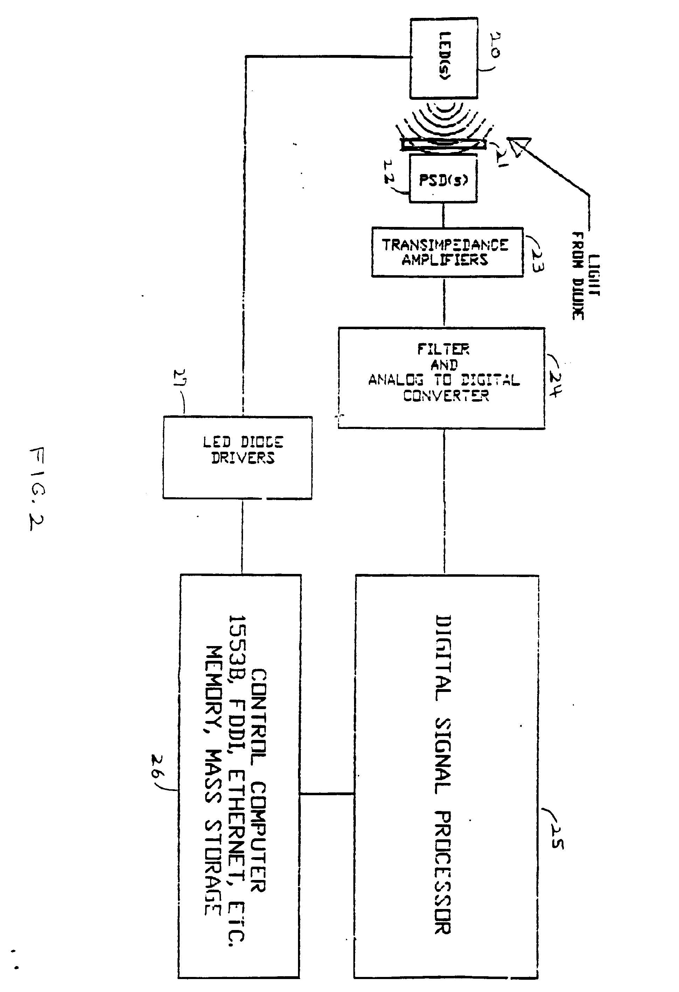

Turning now to Fig. 2, the basis components of the present invention are shown schematically. A plurality of LED configurations 20 are individually pulsed in a known sequence. The light pulses pass through lens 21 to position sensing diode 22. The outputs of the position sensing diode 22 are fed to transimpedance amplifiers 23, the outputs of which are fed to filter and analog to digital converter 24, the further outputs of which are fed to digital signal processor 25 at which novel algorithms continually compute the relative position and orientation of helmet 11. Control computer 26 provides the appropriate control and memory functions. Diode drives 27 are controlled to drive the LED configurations 20 in the known sequence.

The plurality of LED diode configurations 20 are placed on the pilot's helmet 11 at known positional points. The head tracker system of the present invention generally requires six degrees of freedom (X,Y,Z, roll, pitch and yaw). At least four LED configurations 20 are needed for the six degrees of freedom in the head tracker here disclosed, and the plurality of configurations 20 assures constant coverage as the pilot's head is turned. (At its most basic, and for simpler applications, the position and orientation system must have at least one LED configuration 20, at least one position sensing diode 22, and at least three in total of the components 20 and 22 in sight of each other at all times to obtain the six degrees of freedom. Further, the position sensing diode(s) 22 must have an uninterrupted view of the LED configuration(s) 20 whenever positioning is taking place).

In a desirable embodiment of the head tracker of the present invention, twelve LED configurations 20 and one position sensing diode 22 are used. The particular computations utilized in the head tracker require that at least four points (four LED configurations 20) be detected by the position sensing diode 22 under any position or orientation of the pilot's helmet 11.

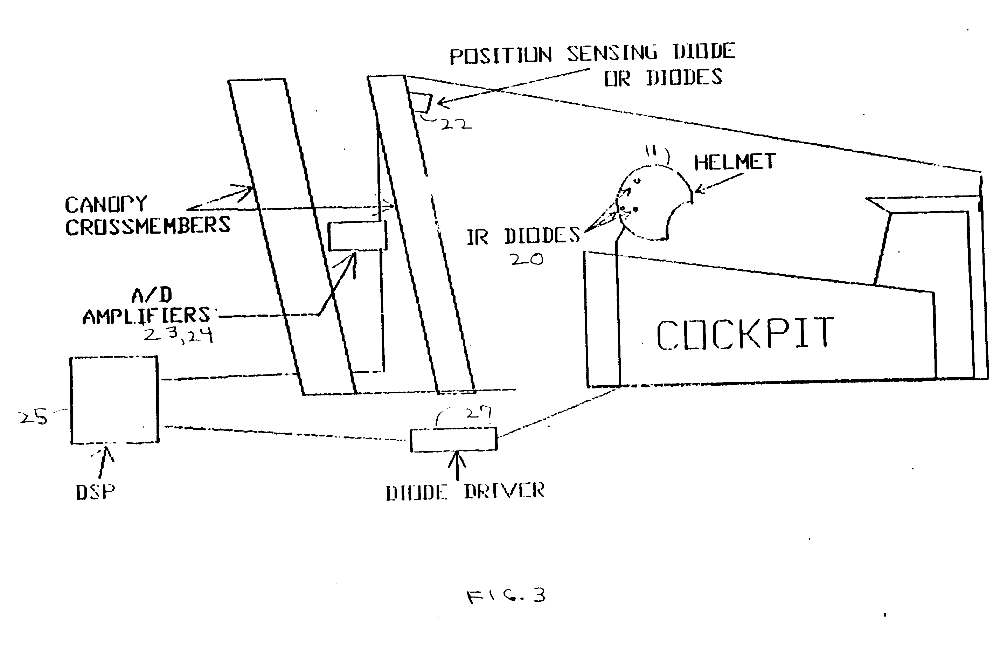

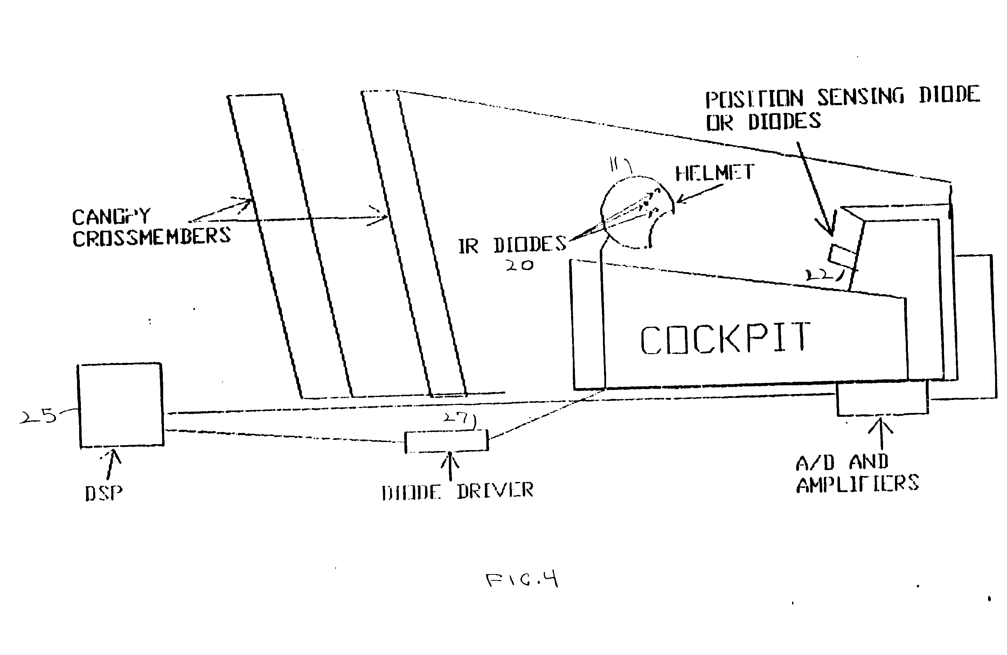

Fig. 2 and 4 illustrate possible exemplary layouts wherein the LED configurations 20 are placed on helmet 11. Fig. 3 shows me helmet placement where the position of the position sensing diode(s) 22 is in the cockpit behind the pilot's head, and Figure 4 shows a different helmet placement where the position of the position sensing diode(s) 22 is in the cockpit in front of the pilot's head.

It should be understood that LED configurations 20 alternatively may be placed in the cockpit and the position sensing diode(s) 22 may be placed on the pilot's helmet 11. This latter arrangement, however, is less desirable for weight considerations.

As previously noted, the LED configurations 20 are individually pulsed one at a time in a known sequence. This multiplexing is appropriate in the described desirable embodiment of the head tracker having the one position sensing diode 22 and six degrees of freedom. The position sensing diode 22 must accurately position each individual light source as it pulses, one at a time. As the position sensing diode 22 "sees" each particular pulsing LED configuration 20, it outputs a current level which is converted to a voltage level by the transimpedance amplifiers 23. This analog voltage is then converted into a digital signal with the analog to digital converter 24. The digital signal is then sent to the digital signal processor 25, which computes the position and orientation of the helmet 11. This digital signal processor 25 outputs its data under command of the control computer 26 (or the digital signal processor 25). The control computer 26 generally directs information transfers of the systems and also dictates the timing of the diode drivers 27. The pulsing of each LED configuration 20 must be done with precision since a "noisy" signal controlling the LED configurations 20 translates into a "noisy" (i.e., inaccurate) sensed position of that configuration. The diode drivers 27 accordingly must be in synchronism with the rest of the system to ensure that when a particular LED configuration 20 is "on", the computational algorithm knows where it is in relation to the other LED configurations 20 it has previously measured.

## The LED Configurations (20)

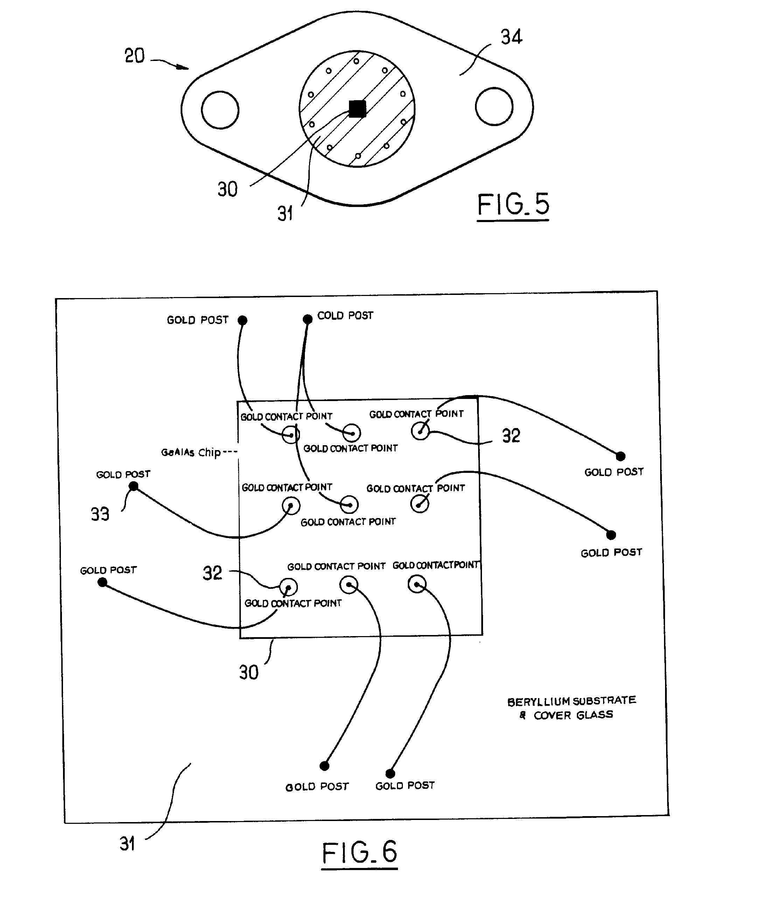

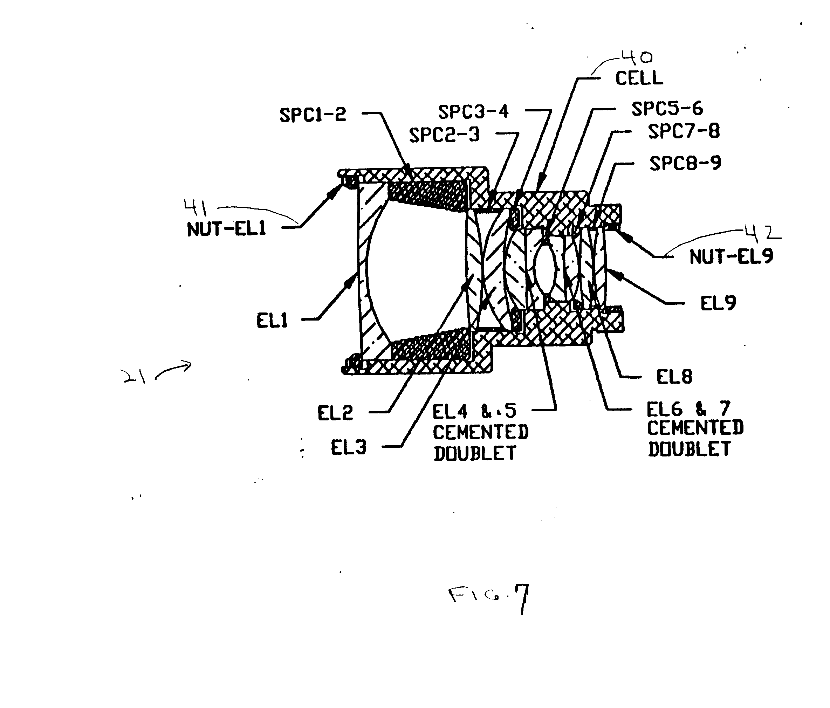

Turning now to the system components of the present invention, a particular individual infra red LED configuration 20 is illustrated in Fig. 5. Each LED configuration 20 incorporates a high-power GaAlAs infra red emitter chip 30 mounted on a beryllium substrate 31. The cross-hatched area of Fig. 5 is the beryllium substrate 31, which is painted black to avoid any reflection and thus provide a precisely-located and very intense light source when the LED 20 is pulsed. Fig. 6 is an expanded view illustrating the top surface of the chip 30, wherein nine gold heating pads (contact points) 32 are placed across the surface of the single chip to provide an even flow of current, uniform heating, and a high power diode. The nine heating pads 32 are in turn connected by gold wires to gold posts 33 as shown. The mechanical holder portion of the diode configuration is shown as 34 in Fig. 5. The particular chip used may be an OD -880-C of Opto Diode. The particular LED configuration 20 here described provides a high-powered intense, uniform light source needed for proper functioning of the system.

As an alternate arrangement to maintaining the plurality of LED configurations 20 on the helmet 11, they may be placed elsewhere in the cockpit and connected by fiber optic cables to sites on the pilot's helmet 11 to still provide the point sources of light at the helmet 11.

## The Lens (21)

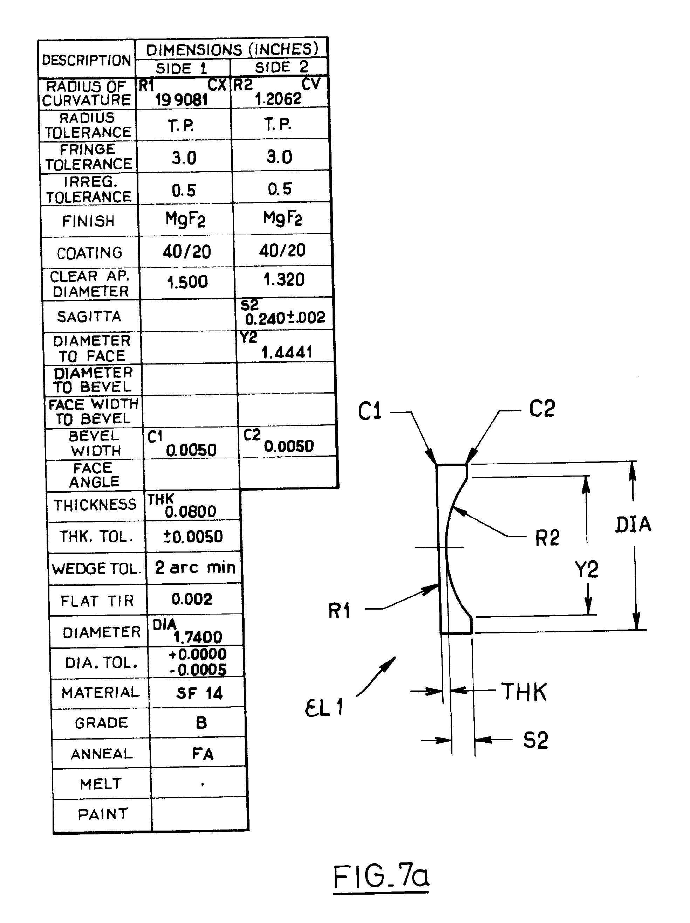

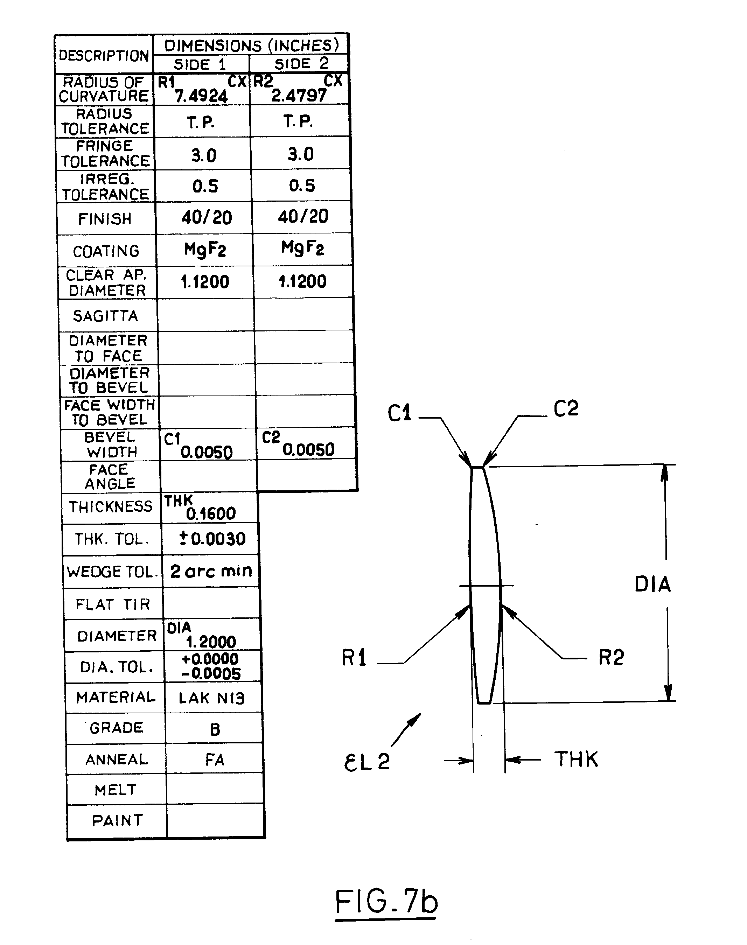

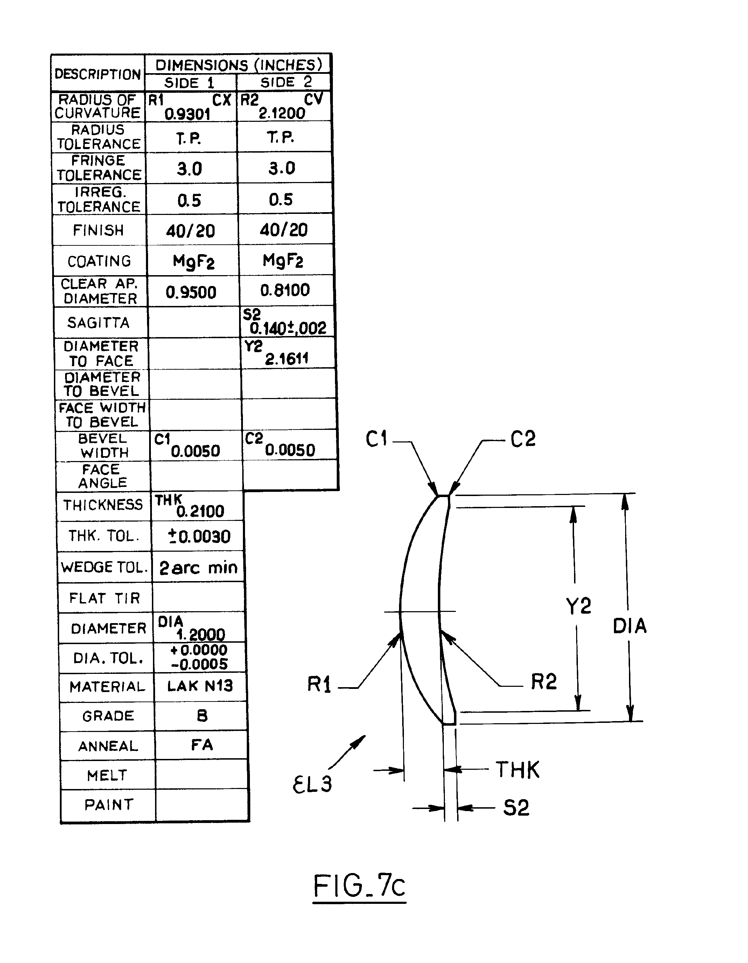

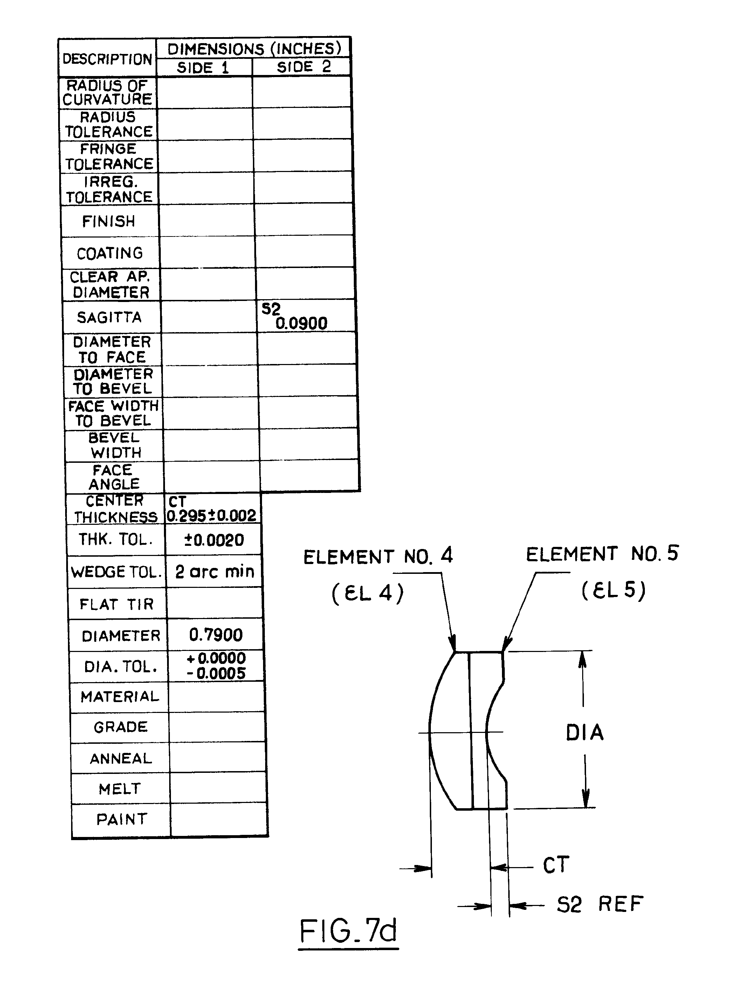

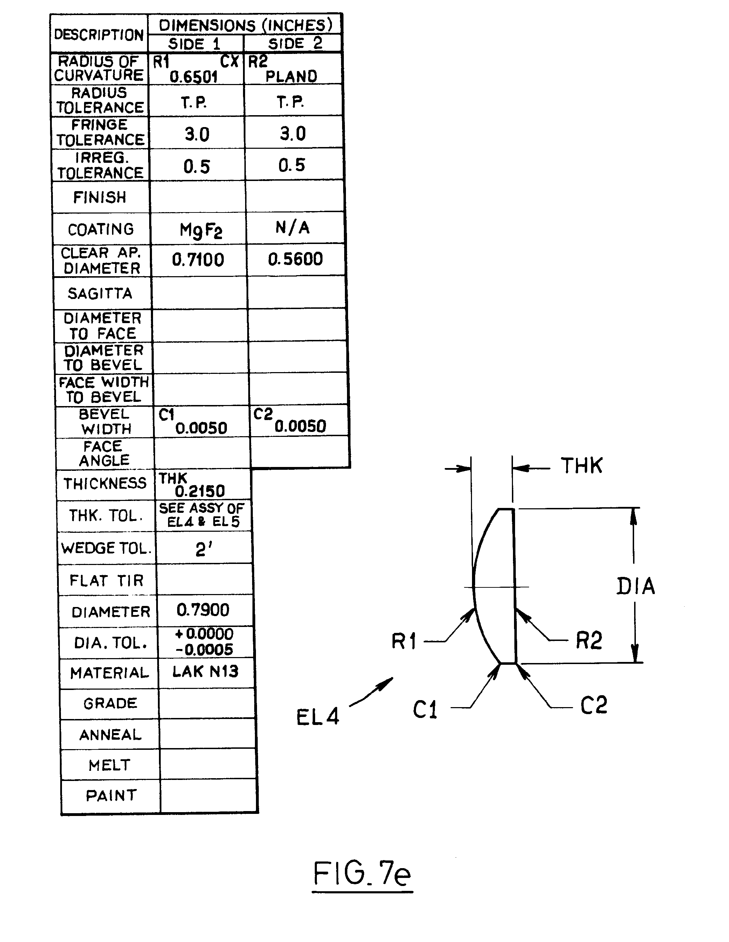

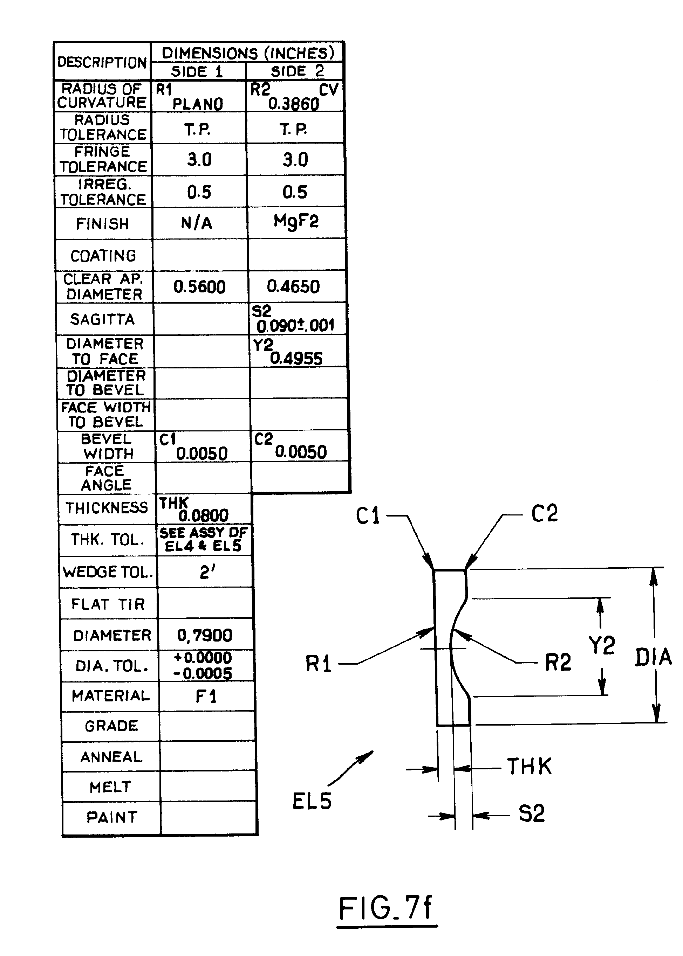

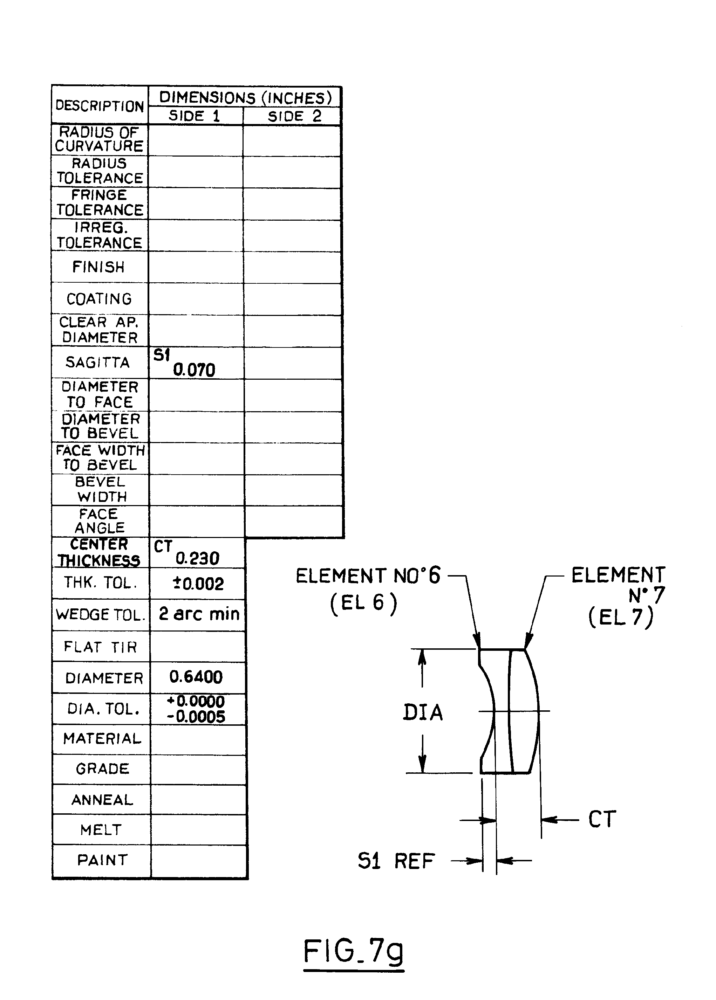

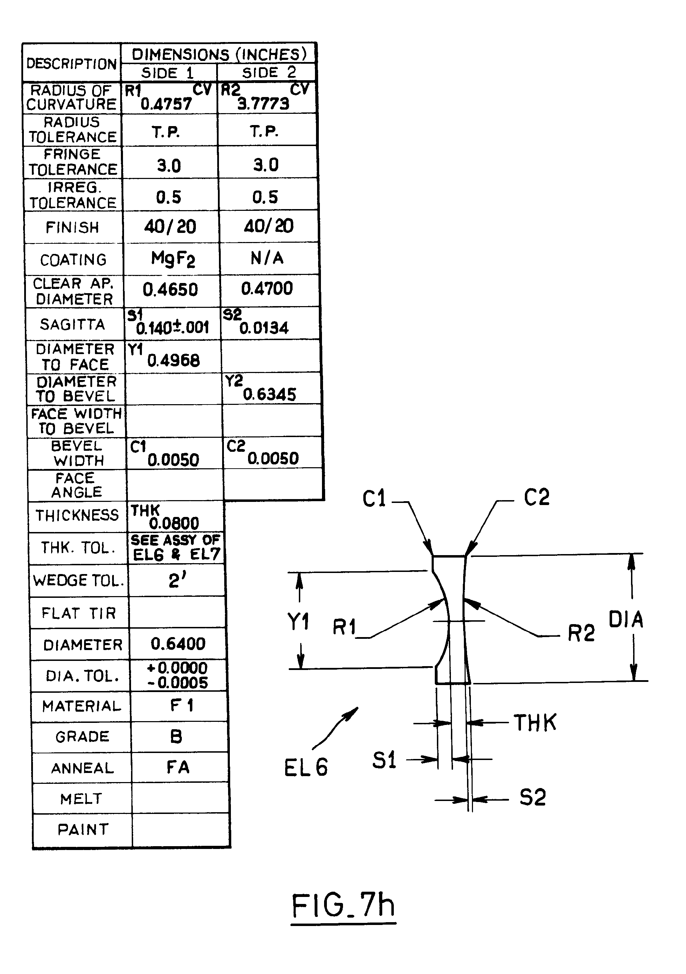

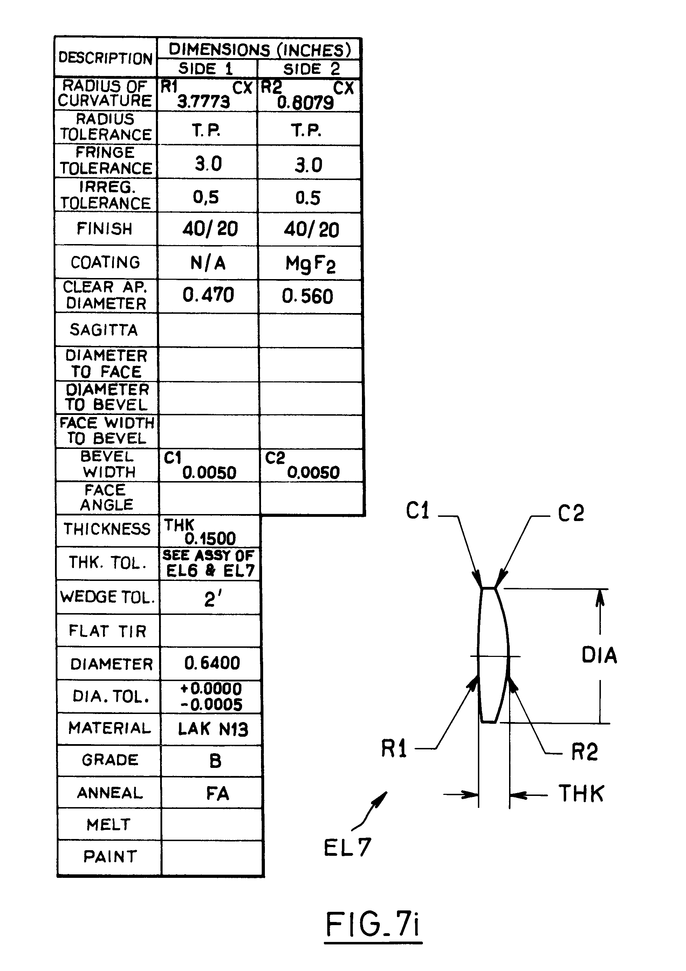

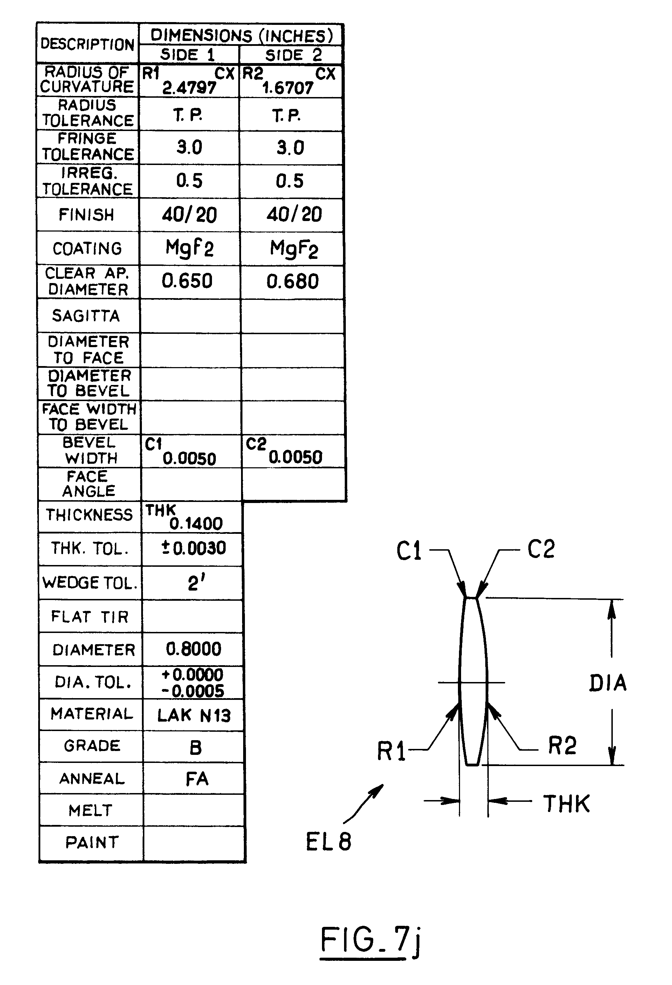

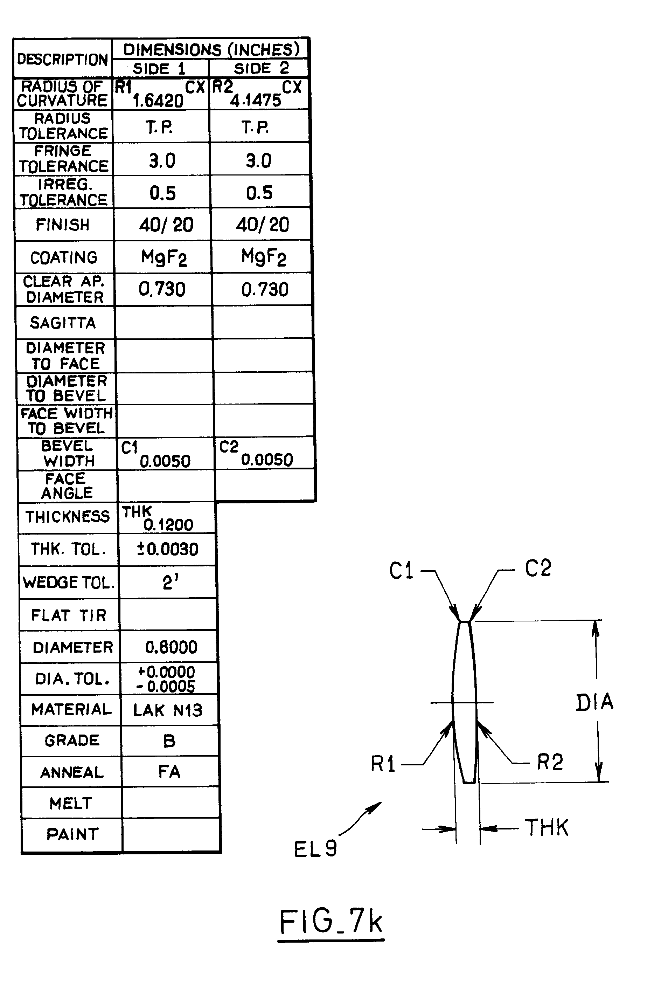

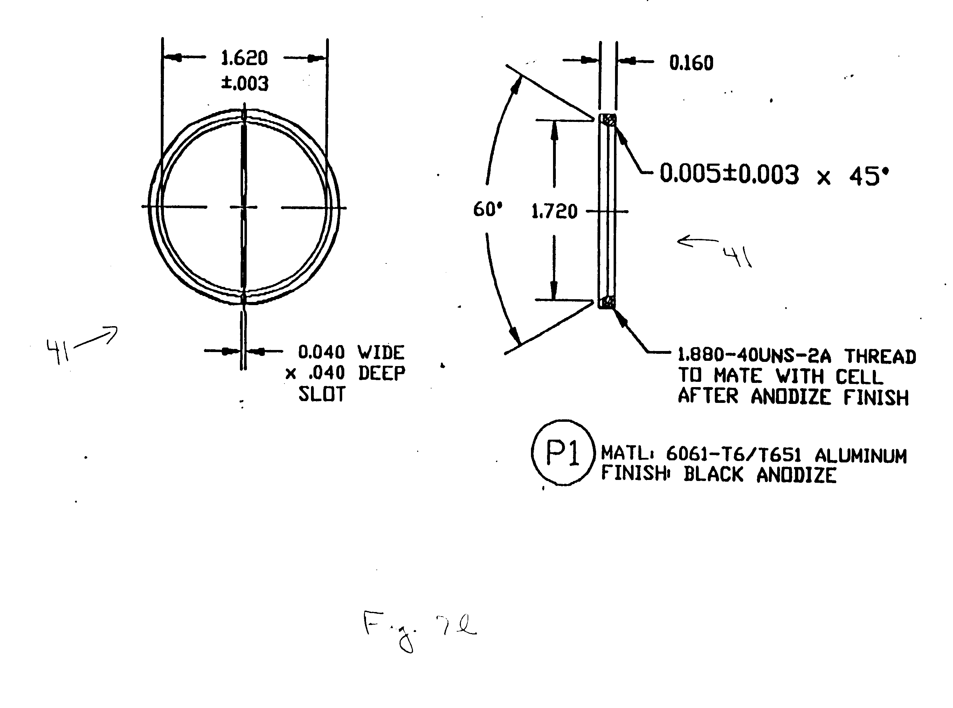

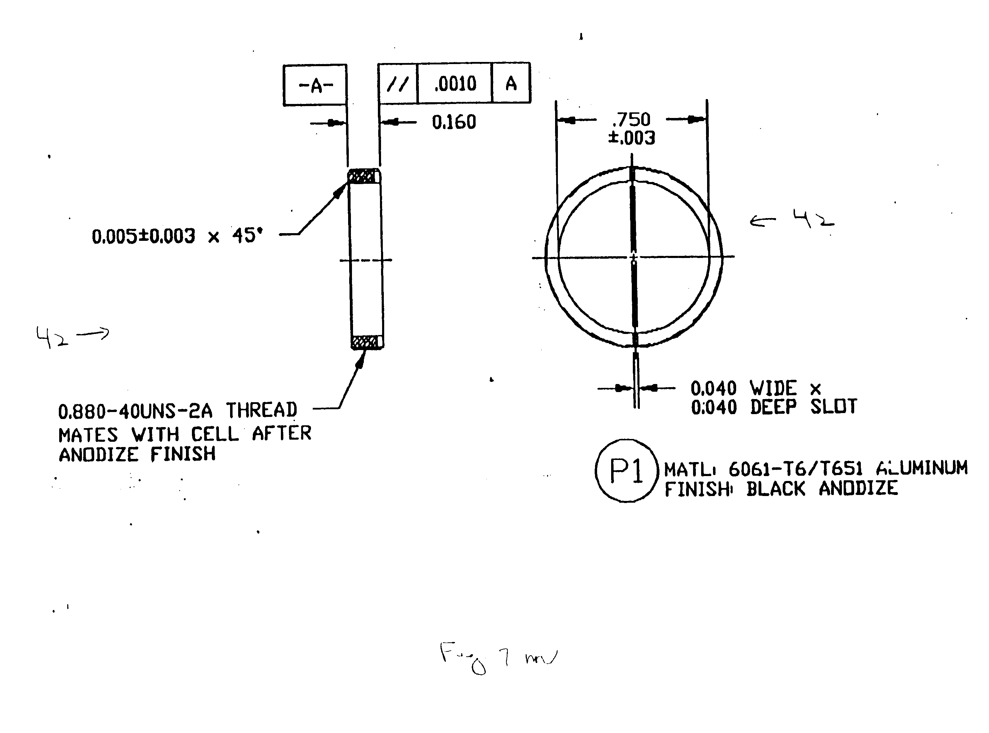

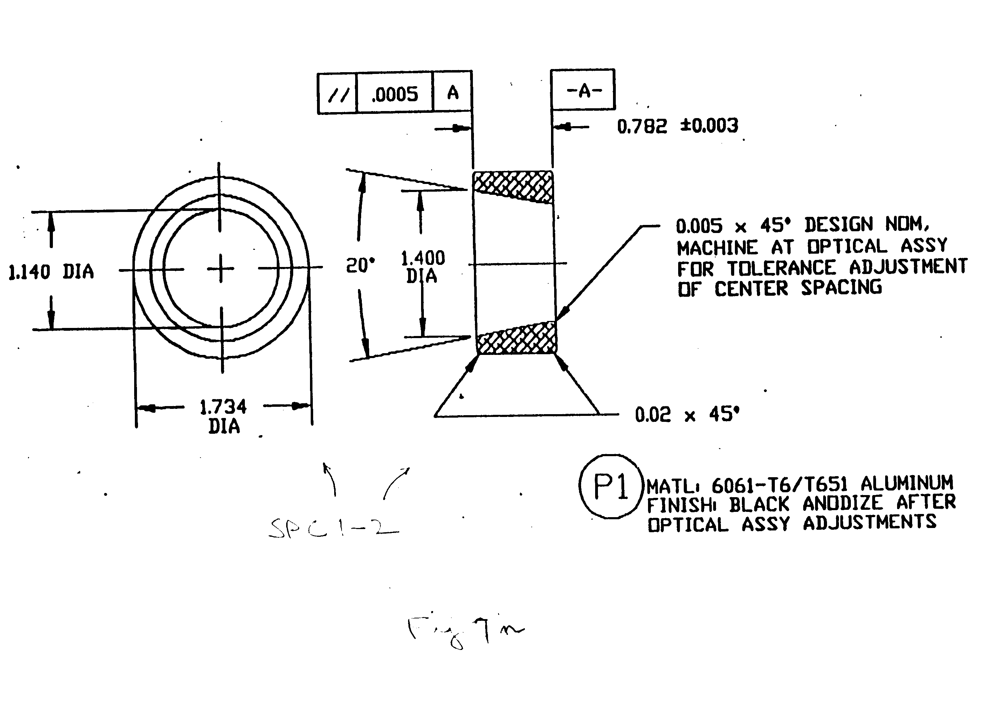

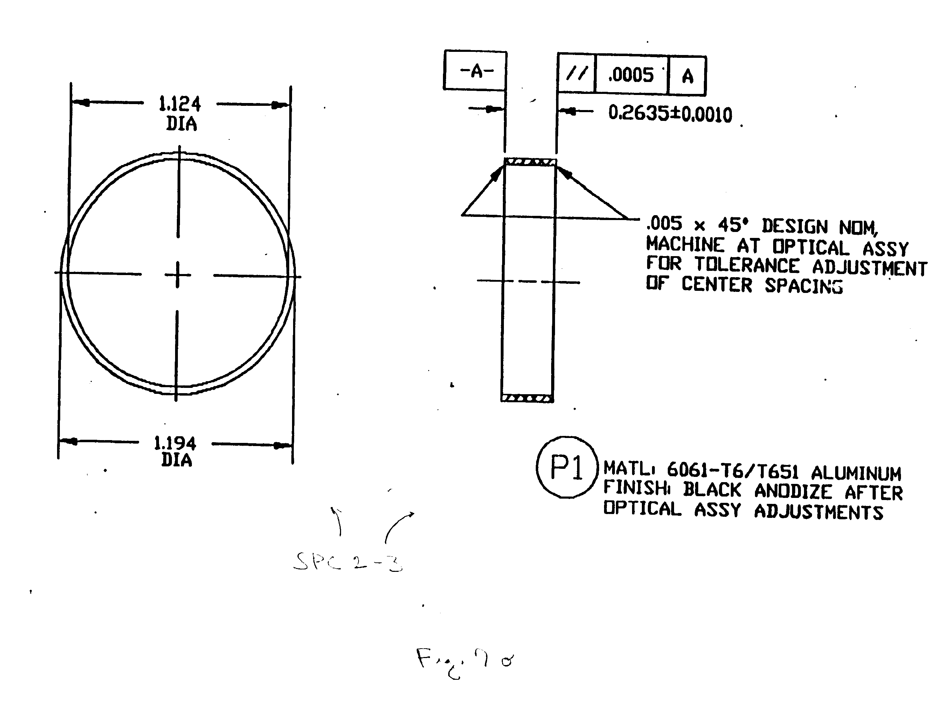

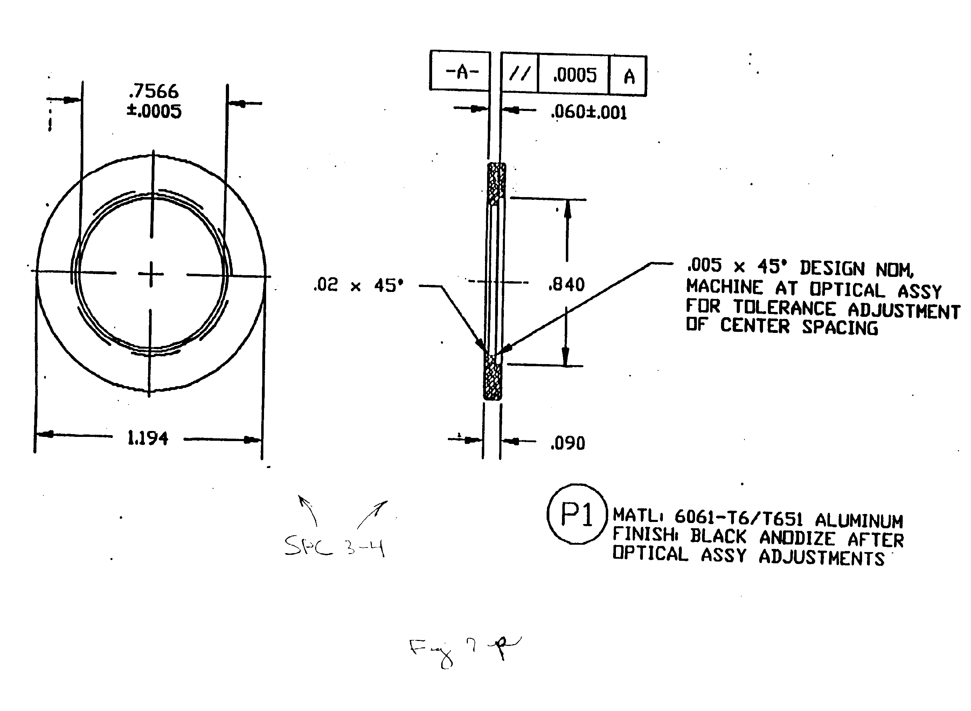

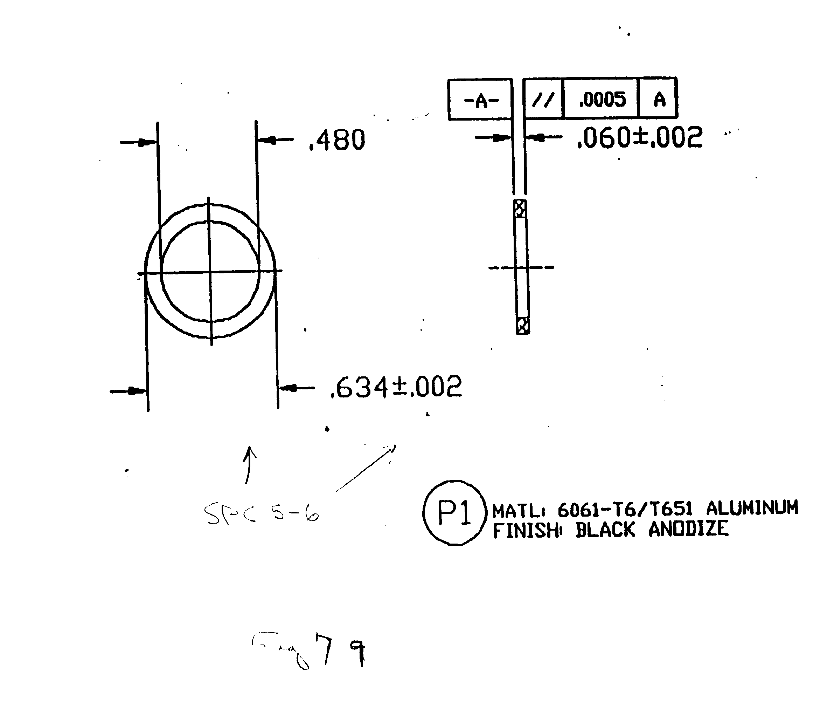

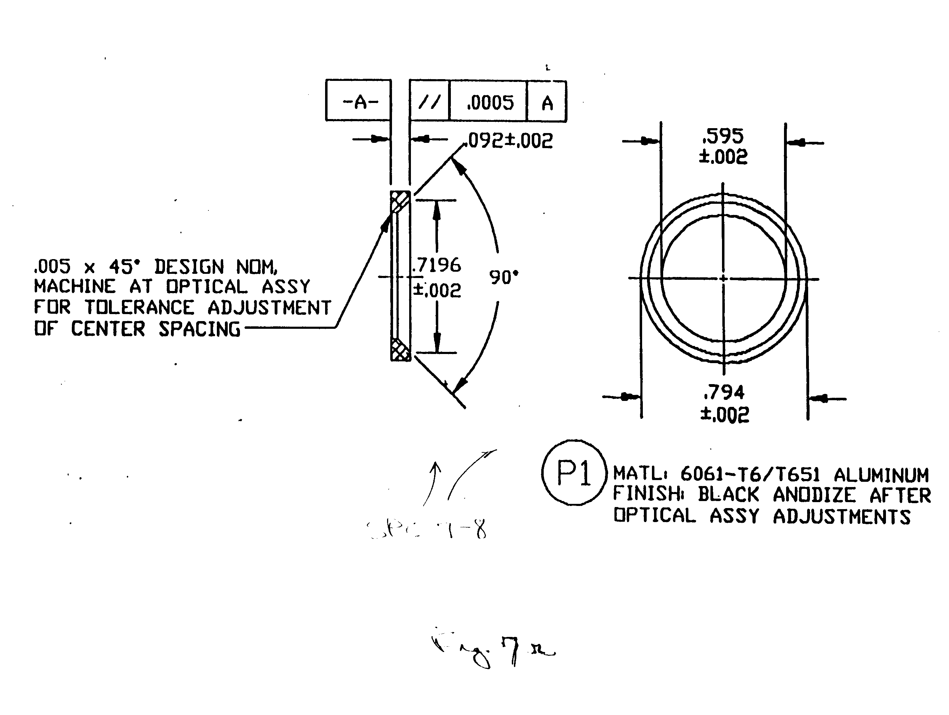

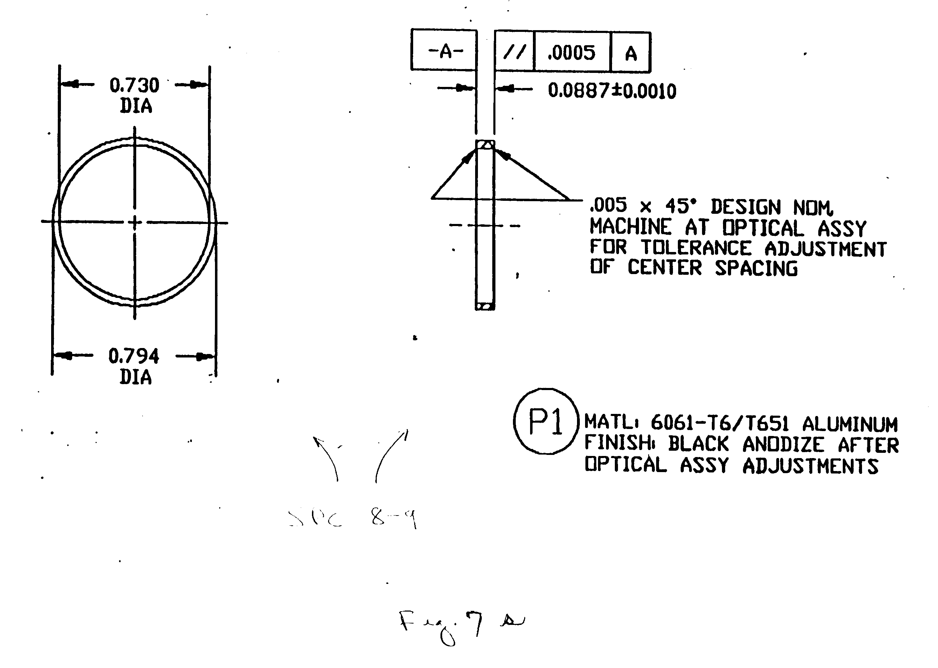

Lens 21 is shown in assembled cross section in Fig. 7. Lens 21 is comprised of nine optical elements designated EL1 through EL9. Elements EL4 and EL5 are cemented together, as are elements EL6 and EL7. The other optical elements are discrete. All the optical elements are retained within metal cell 40 by retaining nuts 41 and 42 respectively positioned at opposite ends of the cell 40. The spacers between the optical elements are respectively designated SPC 1-2, SPC 2-3, SPC 3-4, SPC 5-6, SPC 7-8, and SPC 8-9.

Figs. 7a through 7s respectively show cross-sectioned (and end-on where appropriate) views of the optical elements, retaining nuts and spacers, including where pertinent the relevant optical characteristics and other parameters of the optical elements, nuts and spacers. Indicated dimensions are in inches. Figs. 7a through 7k show the optical elements, Fig. 7d also showing the cemented assembly of optical elements EL 4 and EL 5, and Fig. 7g also showing the cemented assembly of optical elements EL 6 and EL 7. Figs. 7l and 7m respectively show the retaining nuts 41 and 42. Figs. 7n through 7s respectively show the above designated spacers SPC 1-2, etc.

Lens 21 as a unit has an extremely wide field of view (65 degrees) and a very short focal length (effective focal length of .6760 inches), both of which render the lens particularly advantageous for the head tracker of the present invention. The wide field view allows the maximum excursions of the pilots head (helmet 11 with LED configurations 20) about the cockpit to be kept within view. Further, at distances of two to three feet objects viewed by the position sensing diode 22 through the lens 21 are extremely crisp and are focused to an extremely small spot size. The LED configurations 20 on helmet 11 are positioned within two - three feet of position sensing diode 22 (see Figs. 5,6) and the lens 21 (which is mounted adjacent, on the order of millimeters, the face of the position sensing diode 22). Distances greater or shorter will affect the spot size on the position sensing diode 22 and thus decrease its accuracy, applicants having discovered that in practical applications smaller spot sizes provide greater accuracy in the position readings determined by the system of the present invention. The system is capable of sensing changes on the face of the position sensing diode 22 of less than one-tenth of a micron.

It also is necessary that lens 21 have both a wide field of view and a wide aperture (1.4), these two aspects normally being inconsistent in lens design. The wide aperture optimizes light input and provides a desirable light signal to noise ratio. Here, the nine optical elements with their particular configurations and parameters, including the curves, separations and types of the optical elements, combine to provide both the very wide field of view and the wide aperture.

For applications involving spacings of less than two-three feet, a wider lens field of view is needed and the system becomes less accurate while covering the same area. The greater the spacings, the greater the system accuracy, but the confines of the aircraft cockpit obviously limit the available spacing for the head tracker.

The Position Sensing Diode (22)

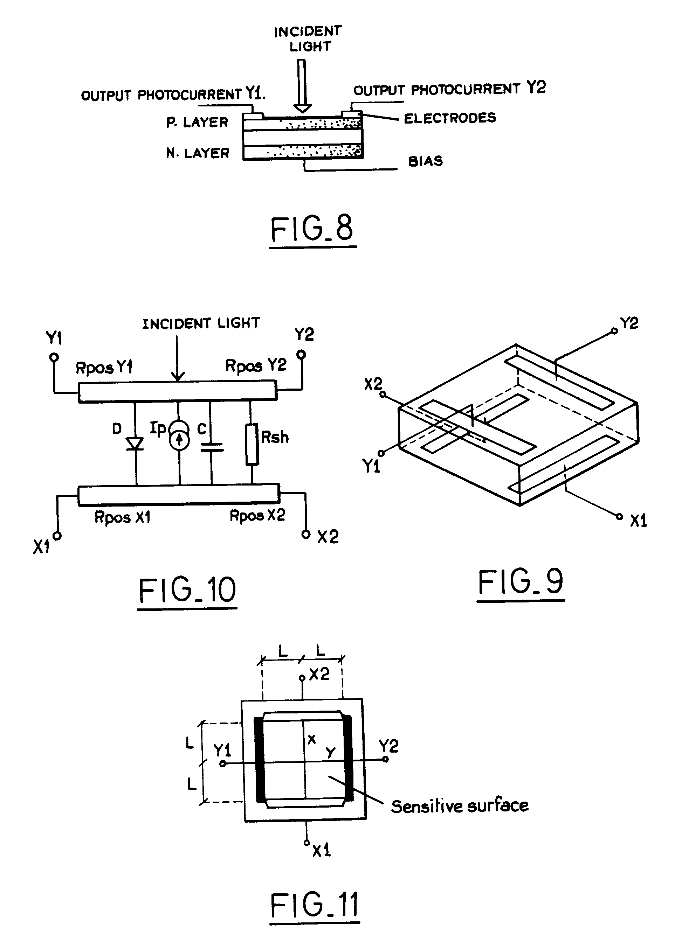

Position sensing diode 22 is a novel semiconductor device which generates signal currents in response to light incident on the single surface of the device. The photoelectric device converts the incident light spot from lens 21 into continuous position data. A generalized showing of a position sensing diode is illustrated in Fig. 8.

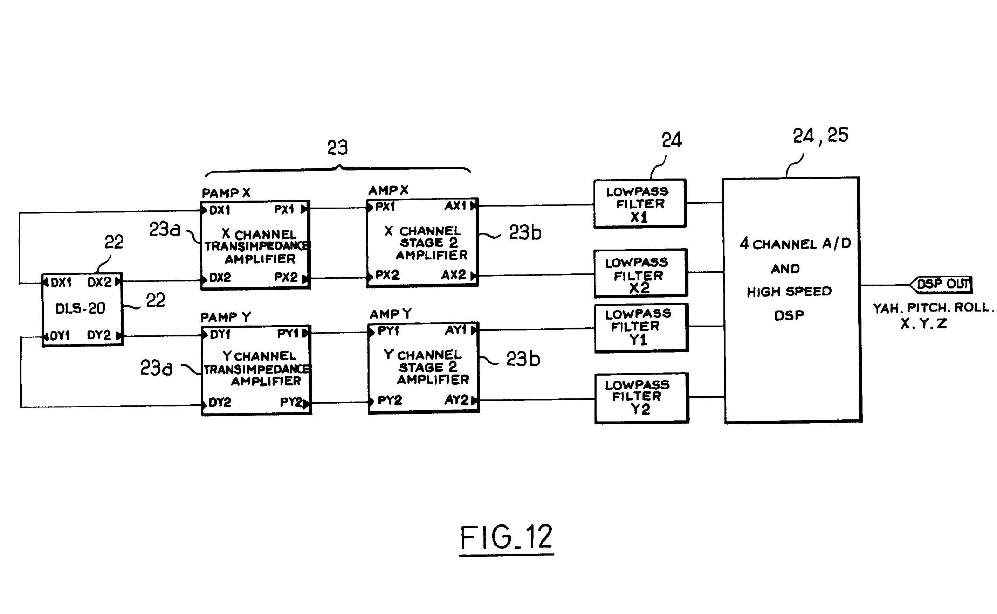

In the head tracker of the present invention, a duo lateral two-dimensional position sensing diode is used, which has four terminals with two anode leads and two cathode leads. Fig. 9 shows this structure for such a device, and Fig. 10 shows the equivalent circuit thereof. In the equivalent circuit, Ip is the photoelectric current generated by the incident light, D is ideal diode, C is the junction capacitance, Rsh is the shunt resistance, and RposX, RposY are the position resistance X - axis, y - axis. The photoelectric current generated by the incident light flows through the device 22 and can be seen as two input currents and two output currents. The distribution of the output currents shows the light position of one (y) dimension, and the distribution of the input currents shows the light position of the second (x) dimension. Referring to Fig. 11, one determines the position of the light spot on the detector's sensitive surface by the following formula, taking the detector to be a square with sides 2L:

$$\frac{X2 - X1}{X1 + X2} = \frac{x}{L}$$

$$\frac{Y2 - Y1}{Y2 + Y1} = \frac{y}{L}$$

The duo lateral position sensing diode 22 used in the head tracker of the present invention provides excellent resolution, fast response and excellent linearity, all of which characteristics are essential to the head tracker of the present invention. The particular device utilized is a DLS-20 by UDT, with an IR coating added and a filter added on the cover glass to filter out ambient light.

Other position sensoring diodes were considered, including an SC-10 device by UDT which is a tetra lateral two-dimensional device with five terminals (four anodes on one side, a cathode on the other side). The latter device was unsatisfactory in the high accuracy head tracker of the present invention. Its linearity was limited to a small region near the center of the structure, and was about 90% overall. The DLS-20 duo lateral device on the other hand has inherently much greater linearity, in excess of 99.9% across the active surface of the device. In addition, in the duo lateral structure the intelligence of the signal is shared between the anode and the cathode, so that the signal levels are twice as high as a tetra lateral structure (i.e., the SC-10 device).

The Transimpedance Amplifiers (23)

The duo lateral two-dimensional position sensing diode 22, as noted above, produces signal currents proportional to the magnitude and position of the infra-red spot on the diode's surface. The currents from the position sensing diode are in two pairs (one pair for information as to the X position of the spot, one pair for information as to the Y position of the spot), and are in the microamp range (less than 40 microamps). These photo currents therefore must be amplified by transimpedance amplifiers 23 and converted to a voltage to be read by analog to digital converter 24. The amplification should be sufficient while introducing as little noise as possible into the signal to avoid introducing any error to the 16 bit conversion process of the present invention. Another amplifier requirement is that they have sufficient transient response to meet the system throughput requirements. The amplifiers 23 also must keep the position sensing diode properly reversed biased, while presenting as little load as possible on the diode so as not to alter the signals they are to amplify.

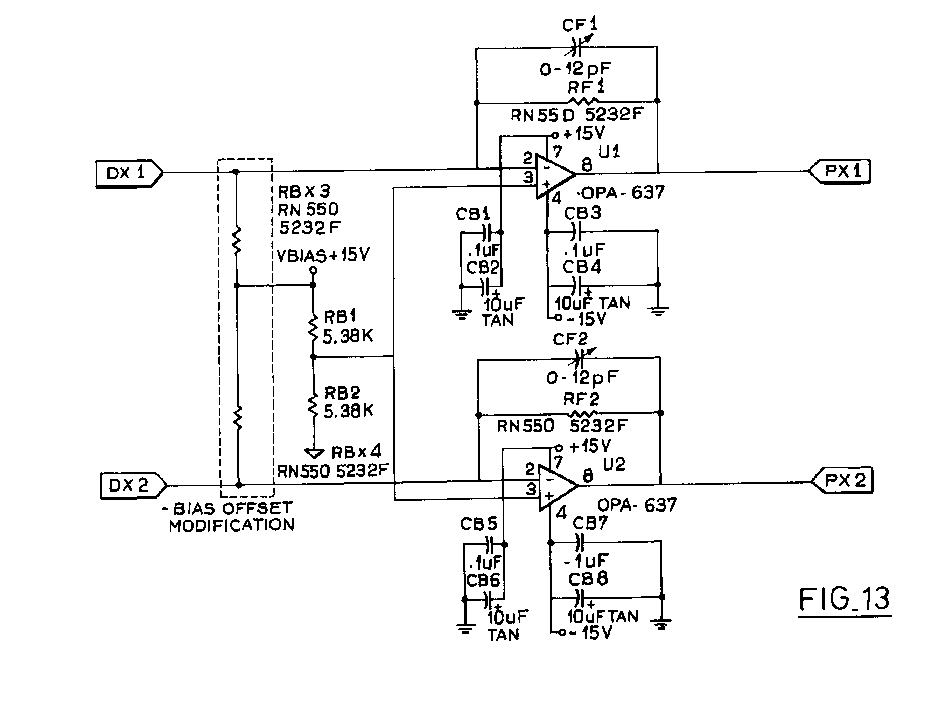

Referring to Fig. 12, the transimpedance amplifiers 23 are shown in two stages, 23a and 23b. Preamplifier stage 23a, shown in Fig. 13 (for the X channel), is implemented with four (the two for the X channel being shown) operational amplifiers (Burr Brown OPA - 627) each in a transimpedance configuration. The output of a given transimpedance amplifier is a voltage equal to the product of the input current and the impedance of the feedback loop. For DC currents the impedance of the feedback loop is equal to the feedback resistor value (RF1-RF4). Bias for the position sensing diode 22 is provided by the resistive divider network connected to the non-inverting terminal of the op-amps (RB1,RB2). This bias is removed from the output of the preamplifier by a second resistive divider network connected to the inverting terminals of each op-amp (RBX3,RBX4).

The operational amplifiers used in stage 23a best optimize the characteristics of ultra low input voltage noise, high impedance FET inputs, and excellent transient response. The feedback network optimizes noise and transient response considerations. As noted above, the DLS-20 position sensing diode 22 requires a reverse bias across its junction to perform properly in the system. The reverse bias decreases the diode 22 response time, prevents input saturation and increases leakage current. Since the noise current generated by diode 22 is directly proportioned to the leakage current, it is desirable to be kept low, and the biasing accordingly is designed to best satisfy these performance trade-offs.

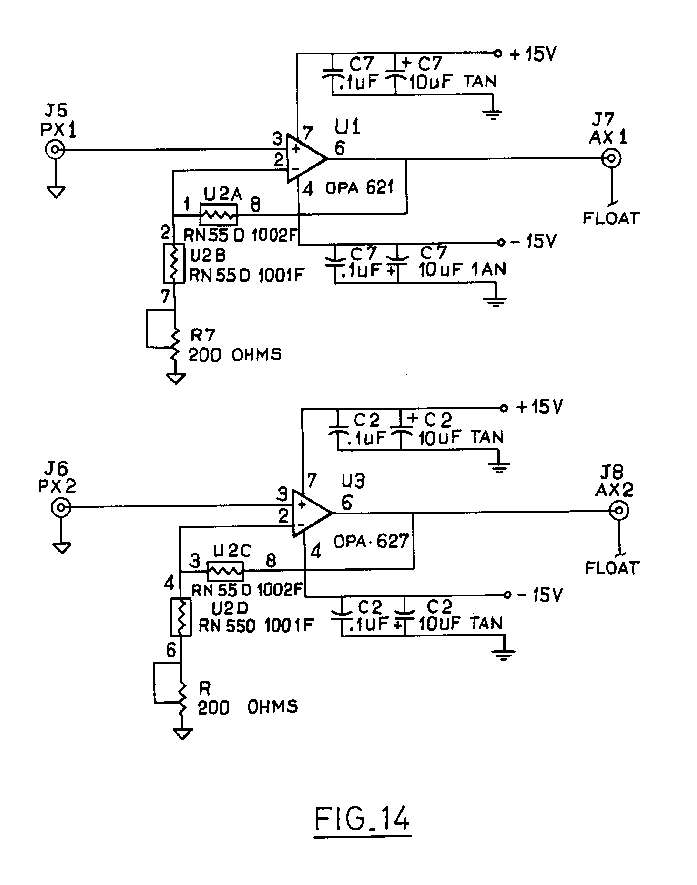

The second stage amplifier 23b is shown in Fig. 14 (for the X channel), and is comprised of four operational amplifiers (the two for the X channel being shown). Each op-amp amplifies one of the four position sensing diode signals. The two op-amps for the two X channel signals are configured for non-inverting gain. The other two op-amps are configured as inverting amplifiers for the two Y channel signals. The output of the second stage amplifier 23b, from the position sensing diode 22, is adjustable from zero to full scale so that the full input voltage range of the analog to digital converter 24 may be used.

To further reduce noise in the system, the power supply lines may be passively filtered, the amplifiers 23 and position sensing diode 22 may be placed in enclosures to block electromagnetic interference, etc.

The Filters and Analog to Digital Converter 24

As shown in Fig. 12, following the second stage amplifiers 23b are four one pole low pass filters (x1,x2,y1,y2), each in the form of an RC network and one filter for each of the four signal outputs. Each filter provides a cutoff of 3.35 kHz. The output of each filter is connected to the analog to digital converter 24.

The analog to digital converter 24 takes the analog information from the position sensing diode 22 (as thereafter converted to voltage and amplified by the transimpedance amplifiers 23) and converts it to digital form for subsequent computation by digital signal processor 25. The converter 24 must have accuracy, speed, stability, repeatability and communication. High resolution is most important, and 16 bits is the resolution used while maintaining an adequate conversion rate. If one averages 4 to 8 readings, then the accuracy of the converted signals is equal or very close to the digitization ambiguity of the analog to digital converter 24 used. This would correspond to an angle of 4 seconds in a field of view of 65 , degrees. This resolution must remain stable and repeatable, because of the low frequency signals to be sampled and the environment where it is to be used. A pilot will probably not move his head faster than 3600 degrees per second, which can produce up to a 10 Hz signal to be sampled. 10 Hz down to DC signals are very slow and therefore sometimes difficult to sample accurately and repeatably. To digitally reproduce a signal ranging up to 10 Hz, it must be sampled at least at a rate of 20 Hz. The 16 bit analog to digital converter 24 here used easily surpasses this conversion rate. To stay within the real-time requirements of the system, however, the conversion rate must be significantly faster. Following the high speed conversion, the data must be passed at the same speed to the digital signal processor 25. The analog to digital converter 24 here used is the CS5101 16 bit converter from Crystal Semiconductor Corporation.

The CS5101 is a 16 bit converter with high stability and repeatablity. It contains a unique self-calibration scheme that checks the converter after every conversion. It enhances power supply rejection and enables more accurate conversion of low frequency signals. A single chip works as dual converter sampling both signals at a rate of 50 kHz, satisfying any real time constraints. The converted data is then fed serially out of the chip to the digital signal processor 25 at that conversion rate.

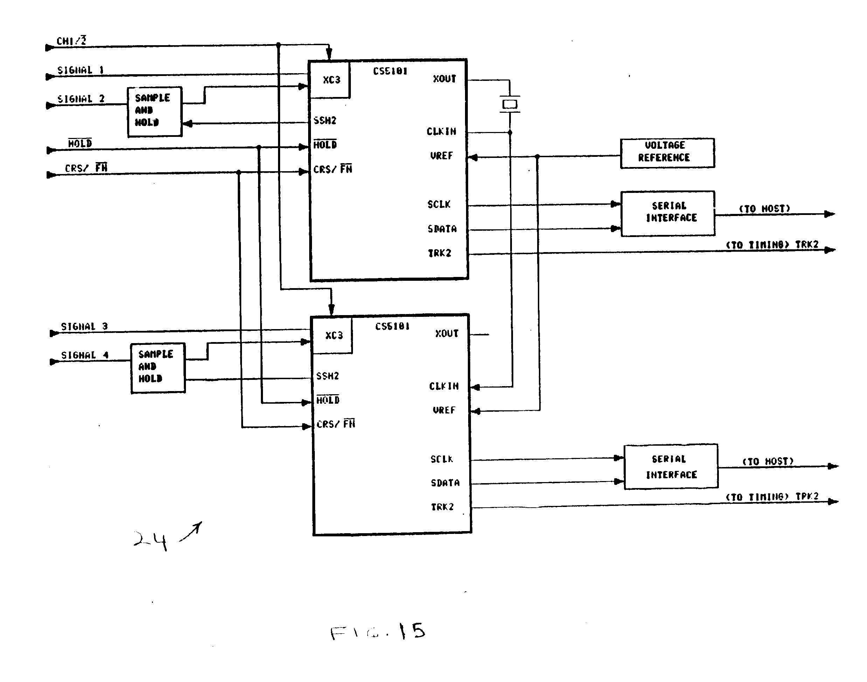

The analog to digital converter 24 of the system is designed to use two CS5101 converter chips allowing four signal lines to be converted, as shown in Fig. 15. The CS5101 samples its two analog inputs 180 degrees out of phase, using a 100 kHz sample clock. It samples the two signals serially at 100 kHz, yielding a 50 kHz sample for each signal instead of in parallel at 50 kHz. To sample the two signals simultaneously and give the effect of being converted in parallel, a sample and hold chip is used to sample the second signal when the first is sampled and hold that second signal level to be converted after the first signal is converted. This will provide more accurate results during digital computations.

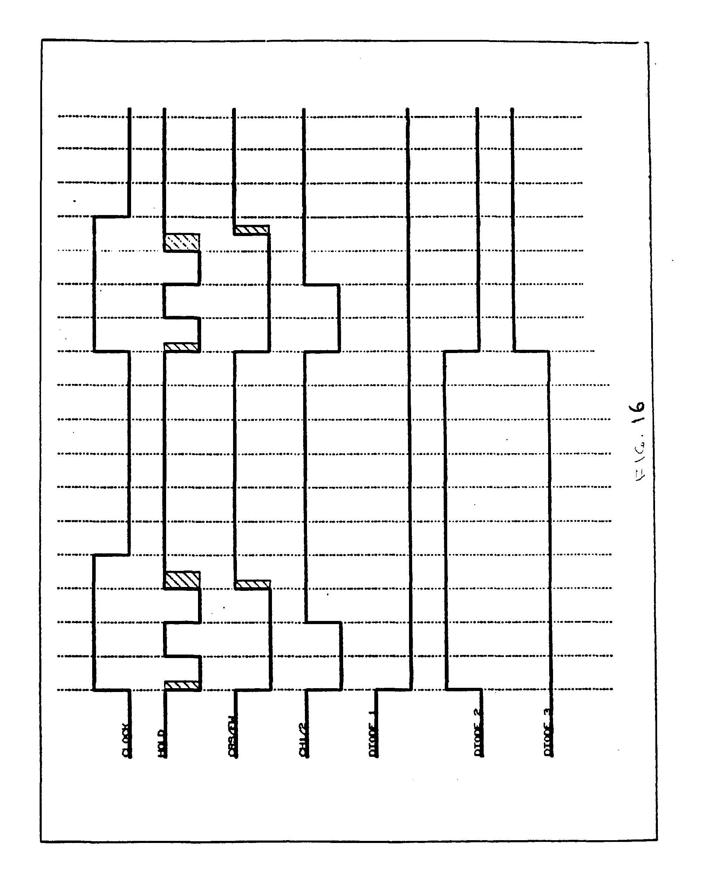

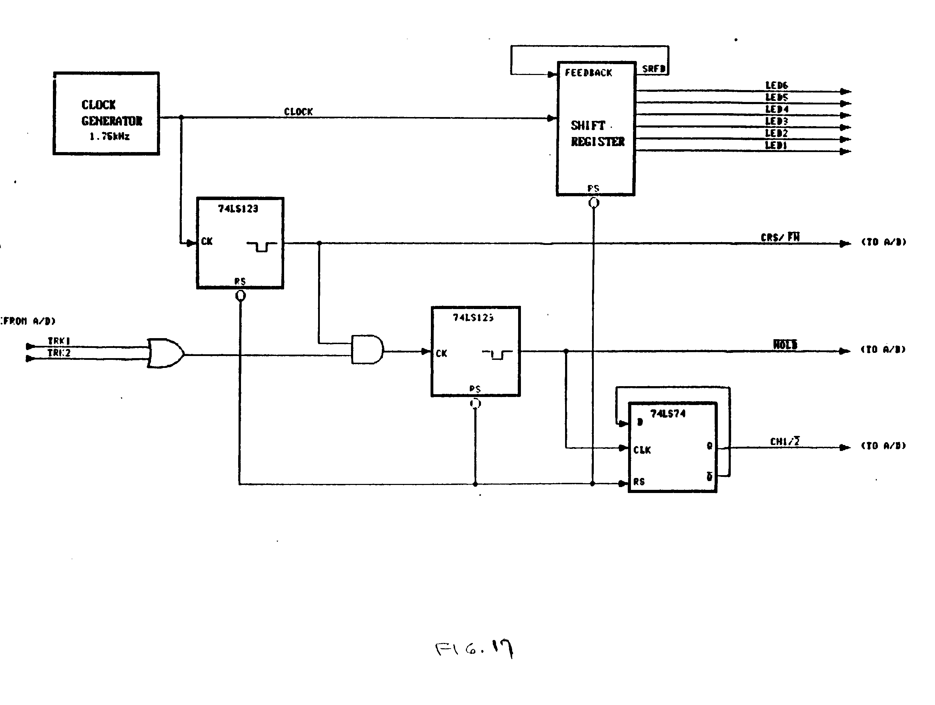

The sample timing shown in Fig. 16 for the converters is generated in the timing section of the system shown in Fig. 17. The timing section is the central control area overseeing diode multiplexing, analog to digital conversion, and system reset lines. There is precise timing needed to convert as much data as possible and also allow ample slew time for the system to react to each diode. The timing is controlled by a 1750 Hz clock and three 74CS123 monostable multivibrator chips. This allows the timing to be adjusted and fine tuned to achieve optimum over sampling and slew time.

## The Digital Signal Processor 25 and Control Computer 26

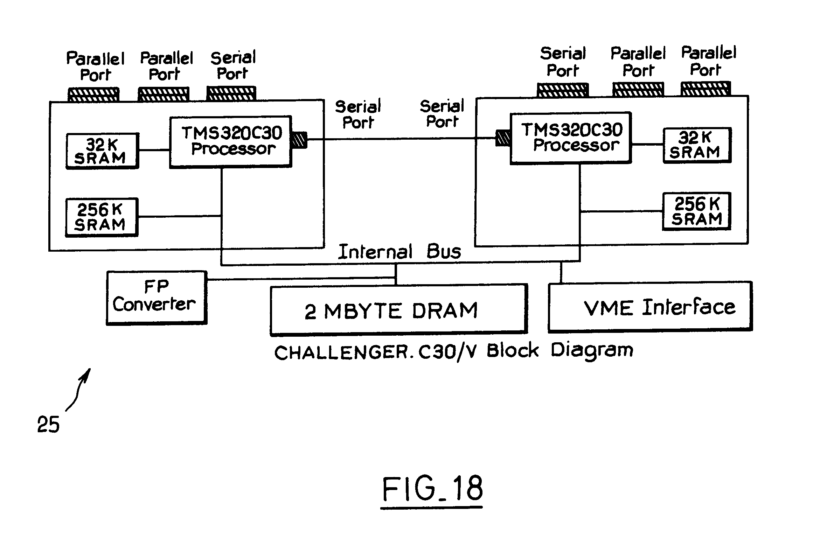

Fig. 18 shows a block diagram of the digital signal processor 25 here used, being a Sky Challenger - C30/V digital signal processor for VME based systems. Digital data from the analog to digital converter 24 is fed to the host processor 25. The processor and the 1553B/Ethernet, etc. interfaces are shown in block diagram in Fig. 2. An embedded controller is incorporated into a 4-slot VME which can accommodate all cards necessary for the system. The Motorola based CPU function (68030 at 33 MHz) is to control all the necessary signals on the backplane. The functioning parameters of the processor are 64 MIPS and 250 Hz update rates. Its 6 U VME design allows it to be incorporated into a small VME box, other slots in the VME cage being reserved for communication cards (1553 B, Ethernet cards, FDDI, etc.)

The digital data from the analog to digital converter 24 is sent serially to two ports on the digital signal processor 25, which receives the data, processes it and then uses it in an algorithm that computes yaw, pitch, roll, X, Y, and Z orientation, etc. The processor is geared for very fast, parallel processing of data, using two of the fastest digital signal processing chips available with shared and local memory.

## The LED Diode Drivers 27

The purpose of the diode drivers 27 is to provide noise-free, flat-top pulses of drive current to the infrared LEDs. The output power of the diodes 20 is proportional to the current driving them. The pulses of current from the diode drivers 27 produce pulses of IR light from the diodes 20. The diode drivers 27 accept a multi-line pulse trigger (one line for each diode) from the system clock which defines the specific diode to be pulsed, and the duration of that pulse.

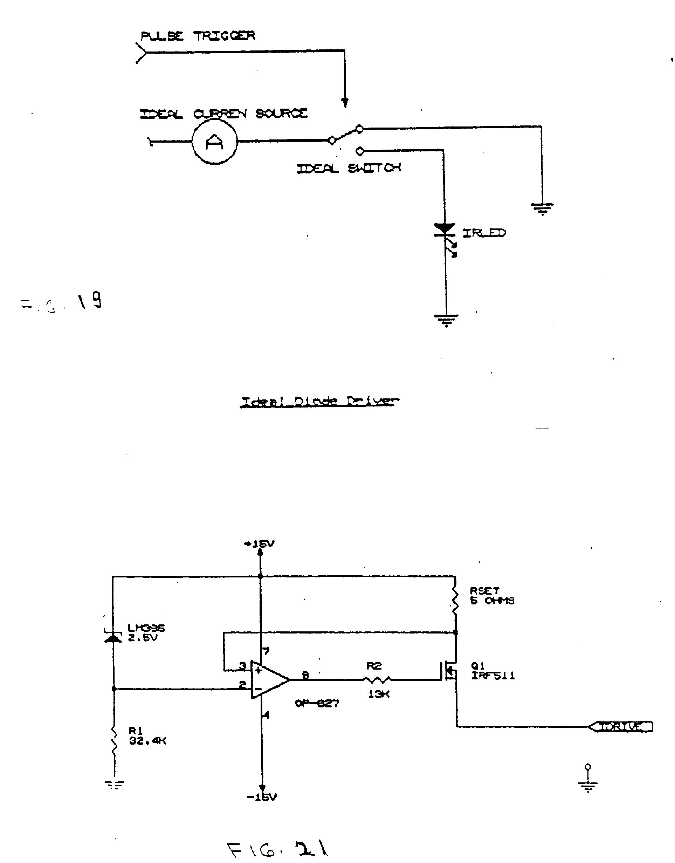

The perfect diode driver would have an ideal current source and an ideal switch. The ideal current source would provide constant, noiseless current regardless of changes in load or temperature. The ideal switch would, when the diode is off, multiplex all of the current away from the diode. In addition, when the diode is pulsed, the ideal switch would couple the diode to the ideal current source, forcing all of that current to flow through the diode for the duration of the pulse. In sum, the ideal switch would either be completely open or completely closed and the ideal source would be level and noiseless. The goal is to approximate the components of the ideal diode driver as closely as possible, an ideal diode driver being shown in Fig. 19.

The closest approximation of the ideal switch is a mechanical relay. Unfortunately, mechanical relays cannot operate fast enough for this application. To build a switch that can operate at speeds required by the diode drivers 27 we must use an N channel MOSFET transistor. The NMOS, as it is referred to, is a three terminal device. When the NMOS is on, current can flow from the drain terminal to the source terminal with a very low resistance (less than 100 ohms). Alternately, when the NMOS is off there is no conduction path between the drain and source, preventing current from flowing through the device. To control the on/off state of the device, one uses the gate terminal. If the gate to source potential is sufficiently high, the device is turned on but should the gate to source be at equal potential, the device is turned off.

There is some relevant non-ideal behavior of the NMOS that must be considered. The device takes several nanoseconds to turn on and off. This speed, however, is fast enough for this application. In addition, the device does not provide a perfect conducting path for the drive currents. When the device is in the "on" state there is a resistance of approximately 100 ohms between the drain and source. This "on" resistance varies between the drain and-source. It also varies with the gate to source potential, the current flowing through the device, and the temperature of the device. If we were able to implement an ideal current source to drive through the NMOS, the "on" resistance would be of little concern. Since this is not the case, we must take this resistance into account.

Referring to Fig. 20, a buffer circuit is implemented which accepts TTL pulses from a master clock and makes them capable of driving the NMOS switches. First, the TTL signal is "cleaned up" by sending it through a comparator which filters the noisy TTL signal into a clean square pulse signal. Next, the output current and voltage of the comparator is amplified by a high speed operational amplifier. The output of this operational amplifier is then used to drive the gate of the NMOS either high (on), or low (off).

Since it is not possible to build an ideal current source, we must attempt to simulate one. Not only must the current source for the diode drivers 27 be able to handle the changing loads of the diodes being switched on and off, it will also have to be "quiet" since any noise present in the current, will be present in the diodes.

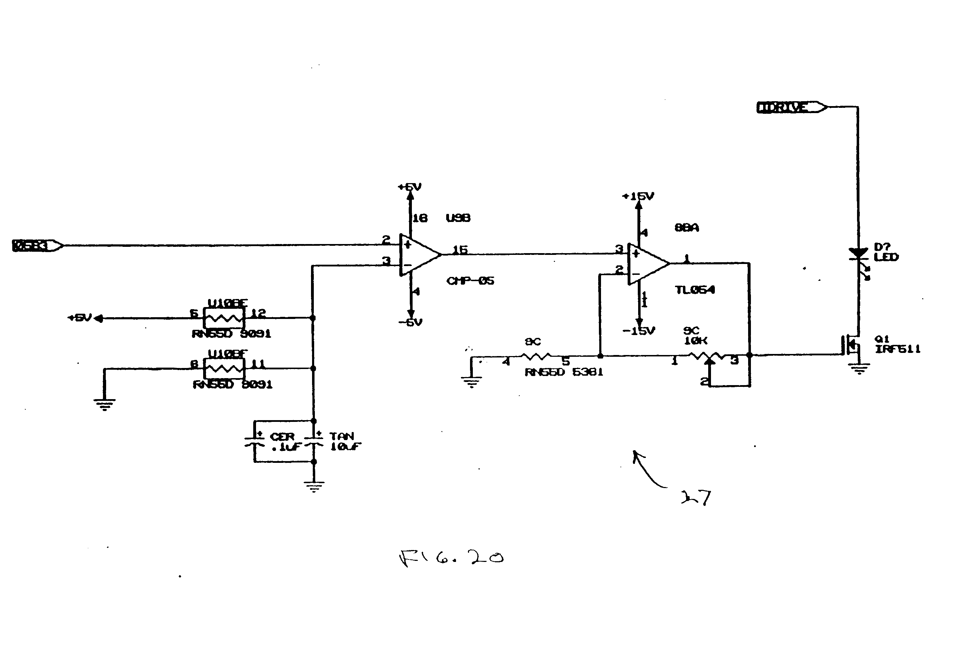

Referring to Fig. 21, the current source built uses a precision voltage reference as well as the "virtual short" characteristics of an operational amplifier to produce a constant current through a resistor. The current through this resistor is mirrored by a MOSFET transistor which in turn sources current to the IR LEDs. The noise of the circuit will be the RMS sum of the noise of the various components of the current source circuit. For this reason all the components have been chosen for their low noise characteristics.

## Digital Signal Processor (DSP) Computation - An Overview

### Introduction

The position and orientation measurement system as previously noted provides a continuous measure of the relative position and orientation of a remote body (i.e., the helmet) by precisely measuring and processing images of some known points (the LED's) observed on the remote body. That is, fixed on the remote body are several points whose position are precisely defined in the body coordinate frame.

At any position and orientation of the remote body (within the specified domain of operation) some set of four of these points must be observed by the position sensing diode sensor. As shown in Fig. 22, the input to the system is the instantaneous actual position and orientation of the remote body or, more specifically, the observed point set which is fixed on the remote body. The observed point set is precisely measured by the position sensing diode sensor. These measurements are processed, using the relative geometry of the observed point set which was known àpriori. The output of the system is the computed measure of the six degrees-of-freedom: the relative position and orientation of the remote body.

### Coordinate Frames

In this application there are two important independent coordinate frames, namely, the reference frame (occasionally referred to as the sensor frame) and the remote body frame. These frames provide the framework for the following discussion of the measurement system.

The reference coordinate frame is fixed with respect to the sensor and for this reason sometimes is called the sensor frame. The x-axis of the reference frame is normal to the sensor plane. The origin of the reference frame is centered in the sensor lens, for reasons which will be come clear hereafter.

The body frame is fixed, centered, and meaningfully oriented in the remote body. For example, in this application the remote body is the helmet. The body frame origin is centered in the helmet and the body frame x-axis is defined as the line-of-sight of the person wearing the helmet. The y-axis is directed out the left ear with the z-axis directed down to make a "right-handed" coordinate frame.

### Position of the Remote Body

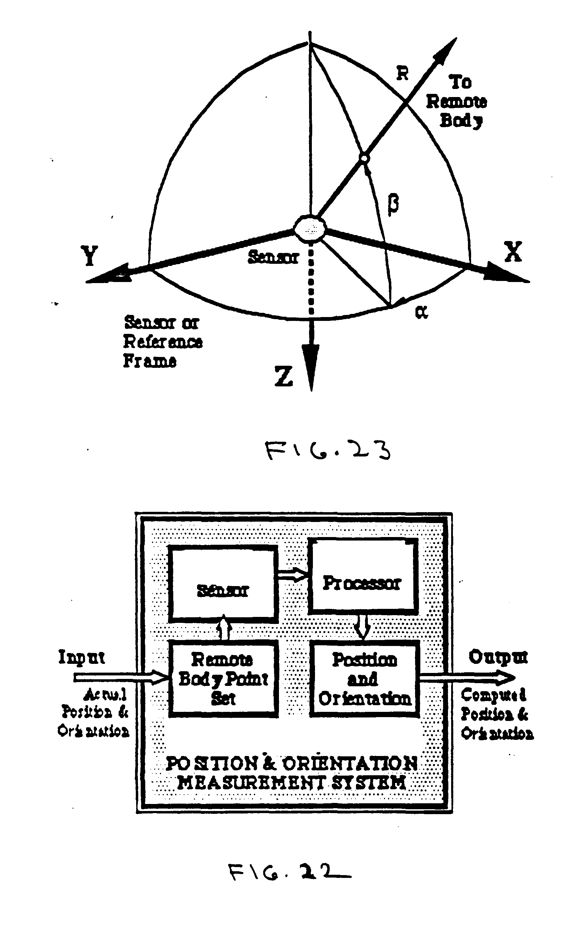

The position of the remote body is defined using the polar coordinate triple, $(R,\alpha,\beta)$, relative to the reference frame as illustrated in Fig. 23, where R is the distance from the "sensor" to the remote body and angles $\alpha$ and $\beta$ are the tracking angles which define the direction to the remote body. The rotation operator expressed as a matrix operator, B, for this sequence of rotations is

$$B = \begin{bmatrix} b_{11} & b_{12} & b_{13} \\ b_{21} & b_{22} & b_{23} \\ b_{31} & b_{32} & b_{33} \end{bmatrix} \begin{bmatrix} \cos\alpha\cos\beta & \sin\alpha\cos\beta & -\sin\beta \\ -\sin\alpha & \cos\alpha & 0 \\ \cos\alpha\cos\beta & \sin\alpha\sin\beta & \cos\beta \end{bmatrix} \quad (1)$$

### Orientation of the Remote Body

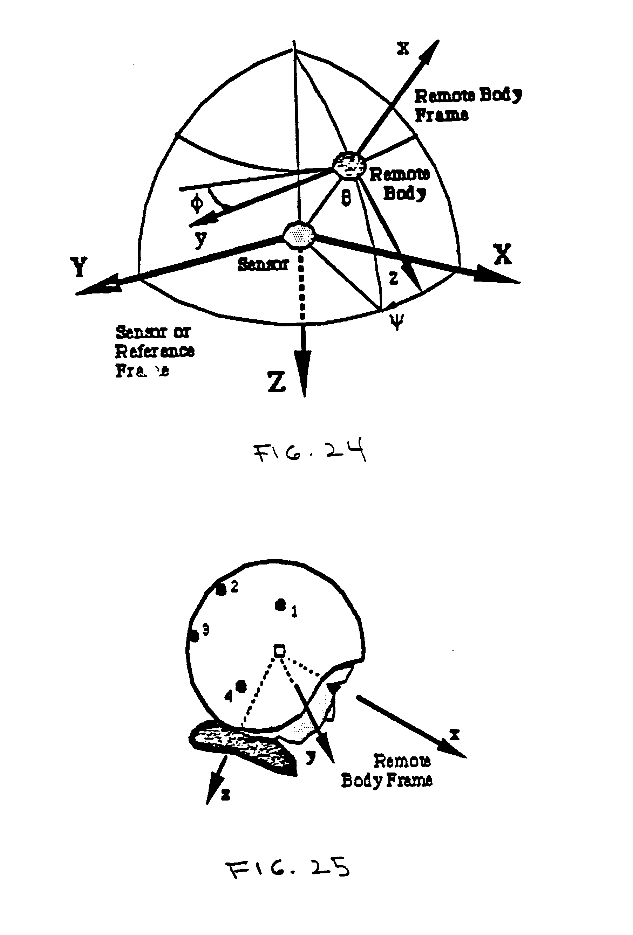

The orientation of the remote body or the remote body frame, xyz, is defined relative to the reference or sensor frame, XYZ, as illustrated in Fig. 24. The three orientation angles, $(\psi,\Theta,\phi)$, represent the relative heading angle, the relative elevation angle, and the relative roll angle, respectively.

The rotation operator, A, represents the Euler angle sequence (out of the 12 sequences possible) which is commonly used in aerospace descriptions. In Fig. 24, the displacement of the origin of the remote body frame from the origin of the reference of sensor frame is shown merely to make the sequence of relative rotations clear and to avoid congestion in the diagram; orientation has nothing to do with linear translation. Actually, to see how the orientation of the body frame is related to the reference frame -- rotate first about the reference Z-axis through a heading angle, $\psi$, the rotate about the newly orientated y-axis through an elevation angle, $\Theta$, and finally rotate about the body frame x-axis through a roll or bank angle, $\phi$.

Note, all three of the Euler orientation angle rotations shown in Fig. 24 are positive rotations. It also should be emphasized at this point, the values of the three orientation angles, $\psi$, $\Theta$, and $\phi$, are independent of the values given the position triple, $(R,\alpha,\beta)$.

The rotation matrix operator for orientation is designated,

$$A = \begin{bmatrix} a_{11} & a_{12} & a_{13} \\ a_{21} & a_{22} & a_{23} \\ a_{31} & a_{32} & a_{33} \end{bmatrix} \qquad (2)$$

where:

$$
\begin{aligned}
a_{11} &= \cos\psi \, \cos\theta \\
a_{12} &= \sin\psi \, \cos\theta \\
a_{13} &= -\sin\theta \\
a_{21} &= \cos\psi \, \sin\theta \, \sin\phi - \sin\psi \, \cos\phi \\
a_{22} &= \sin\psi \, \sin\theta \, \sin\phi + \cos\psi \, \cos\phi \\
a_{23} &= \cos\theta \, \sin\phi \\
a_{31} &= \cos\psi \, \sin\theta \, \cos\phi + \sin\psi \, \sin\phi \\
a_{32} &= \sin\psi \, \sin\theta \, \cos\phi - \cos\psi \, \sin\phi \\
a_{33} &= \cos\theta \, \cos\phi
\end{aligned}
\qquad (3)
$$

Observable Points on the Remote Body

As stated above, the helmet has fixed to it several observable points. These points are precisely defined in the remote body frame. At every position and orientation within the operational domain of the system, four of these several points must be observed by the sensor.

Since these points are fixed on the body (or helmet) and do not move with respect to the body frame this matrix is a constant matrix; this constant matrix, along with all of the other matrices which represent possible sets of four observable points for this helmet, are included in the system software (for this particular helmet) before system installation and operation.

A set of four such points, shown in Fig. 25, are being observed by the sensor. This particular set of four points or vectors are represented by the columns in matrix,

$$P = \begin{bmatrix} p_{11} & p_{12} & p_{13} & p_{14} \\ p_{21} & p_{22} & p_{23} & p_{24} \\ p_{31} & p_{32} & p_{33} & p_{34} \end{bmatrix} \qquad (4)$$

In what follows, it is assumed the position and orientation changes of the remote body are small and that this particular constant matrix still represents the points being observed. If the motion of the helmet is such that one or more of the points move out of view then other points will move into view and the appropriate corresponding matrix of constant vectors will be called up from all those stored in the system.

Another necessary property of $P$ is that its column vectors must span $R^3$. That is, the four observed points must not be coplanar. We now use these four observed points to locate the origin of the remote body frame. This computation, described below, also is done àpriori.

Origin of the Remote Body Frame

We construct an auxiliary frame, $\{u_{ij} \, i,j=1 \text{ to } 3\}$, using $P$ as follows,

$$u_{ij} = p_{ij} - p_{i4} \text{ for } i,j = 1 \text{ to } 3 \qquad (5)$$

These new basis vectors are represented by the columns in the non-singular matrix,

$$P_u = \begin{bmatrix} u_{11} & u_{12} & u_{13} \\ u_{21} & u_{22} & u_{23} \\ u_{31} & u_{32} & u_{33} \end{bmatrix} \qquad (6)$$

To find the point (or vector) which is the origin of the remote body we must solve the vector equation

$$P_u c = -p_4 \text{ for the constant vector, } c = -P_u^{-1} p_4 \qquad (7)$$

where the vector $p_4$ is column 4 in P. Note, the constant vector c locates the origin as a linear combination of the basis vectors defined by the columns of $P_u$. There is a vector c associated with every $P_u$ which is associated with every set of four observed points represented by the matrix P.

Operational Process

During operations the processing strategy roughly follows this sequence of events:

The image of four points are observed and measured by the sensor. These measurements are ordered pairs since the images of the points at whatever position and orientation appear as projections into the sensor plane.

The system objective is to determine a measure of the six degrees-of-freedom for, namely, the position, $(R,\alpha,\beta)$, and the orientation, $(\psi,\Theta,\phi)$. These are the six numbers which determine how the remote body is situated (that is, both its position and its orientation) with respect to the reference frame. Implicit in the point-set image displayed in the sensor plane is the information.

The processor "makes a guess" at the values for each of these six numbers. At start-up the best guess for R would be nominal value, say, 18 inches, and choose zero for each of the five angles. However, during normal operations "good guesses" would be the last values computed for each degree-of-freedom. These guesses are used to determine the computed projected images for each of the four known points observed by the sensor.

The differences between the numbers which represent the actual images and their corresponding numbers which represent the computed images provide six error measures; one for each degree-of-freedom. These error measures are used to improve the next guess for each of the six degrees-of-freedom. This process is continued, indefinitely, or until the errors are judged by the system to be sufficiently small.

In summary to this point, the actual image of the points on the sensor represent the actual situation. The processor makes a guess at the value for each degree-of-freedom. Using these six guessed values the processor determines a computed image. The differences between the actual images and the computed images of the points provide useful error measures. These errors are used to make a better guess and the process is repeated.

We now discuss in greater detail the computations required in this iterative process which yield the computed image.

Homogeneous Coordinates

In order to simulate the remote body situation and in order to arrive at a computed measure of the images on the sensor, the point sets, the vector sets, and the rotation matrices and translation are expressed using homogeneous coordinates. The resulting composite projective transformation matrix then includes not only all five rotations but also the translation of the remote body with respect to the reference frame.

Using homogeneous coordinates the tracking rotation matrix is

$$B = \begin{bmatrix} b_{11} & b_{12} & b_{13} & 0 \\ b_{21} & b_{22} & b_{23} & 0 \\ b_{31} & b_{32} & b_{33} & 0 \\ 0 & 0 & 0 & 1 \end{bmatrix} = \begin{bmatrix} B' & 0 \\ 0 & 1 \end{bmatrix} \qquad (8)$$

and the orientation rotation matrix is

$$A = \begin{bmatrix} a_{11} & a_{12} & a_{13} & 0 \\ a_{21} & a_{22} & a_{23} & 0 \\ a_{31} & a_{32} & a_{33} & 0 \\ 0 & 0 & 0 & 1 \end{bmatrix} = \begin{bmatrix} A' & 0 \\ 0 & 1 \end{bmatrix} \quad (9)$$

where B' and A' are the more conventional 3x3 matrix representation for these rotation operators as defined in equations (1), (2), and (3), respectively.

The translation matrix in homogeneous coordinates is

$$T = \begin{bmatrix} 1 & 0 & 0 & R \\ 0 & 1 & 0 & 0 \\ 0 & 0 & 1 & 0 \\ 0 & 0 & 0 & 1 \end{bmatrix} \quad (10)$$

An important advantage in using the homogeneous coordinate representation for these operators is that translation may be included multiplicatively along with the rotation operators. For example, the composite transformation which takes into account both the rotations and translation is

$$M = B^t TBA^t \quad (11)$$

where the superscript 't' merely means the matrix is transposed.

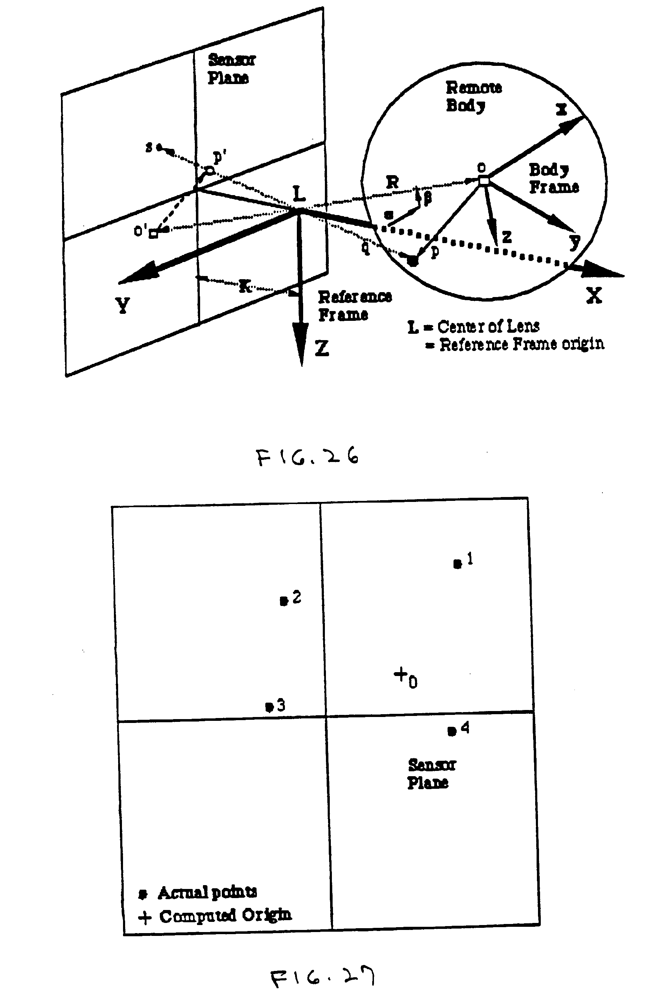

In Fig. 26 note that the body frame is not only rotated but also translated with respect to the reference frame. If at the outset we assume all five angles and R to be zero, then the body frame would be coincident with the reference frame. The transformation M will take any set of points, say, the reference set P in equation (4), into the set, Q, which is rotated and translated with respect to the reference set, P, using,

$$Q = MP \quad (12)$$

Equation (12) is a mathematical representation of the set of points on, say, the helmet, which is rotated and translated with respect to the reference frame. What needs to be done now is to determine what the sensor sees, that is, we must project these points onto the sensor plane.

Projective Transformation

Note in Fig. 26, a single point p is shown on the remote body in the body frame. This same point viewed from the reference frame is q = Mp. The distance from center of the sensor lens L (which is at the origin of the reference frame) to the sensor plane of the lens is designated K.

We must find some scalar multiple of each vector

$$q = iq_1 + jq_2 + kq_3 \quad (13)$$

such that the image in the sensor plane of q is the point s=Fq. The value of the scalar, F, which will do this for each vector q is,

$$F = \frac{K}{q_1} \quad (14)$$

That is, multiplying (13) by (14) gives,

$$s = Fq = Ki + \frac{Kq_2}{q_1}j + \frac{Kq_3}{q_1}k$$

$$= s_1 i + s_2 j + s_3 k \quad (15)$$

for any vector q.

Therefore, for any point or vector, $q = iq_1 + jq_2 + kq_3$, its image in the sensor plane is represented by the ordered pair,

$$(s_2, s_3) = (\frac{Kq_2}{q_1}, \frac{Kq_3}{q_1}) \quad (16)$$

With these preliminaries, we now can compute the points, $(s_{j2}, s_{j3})$, in the sensor plane for each point defined by the j columns of the matrix Q in Equation (12). From the foregoing we can readily compute the ordered pair for each of the j points as,

$$(s_{2j}, s_{3j}) = (\frac{Kq_{2j}}{q_{1j}}, \frac{Kq_{3j}}{q_{1j}}) \text{ for } j = 1 \text{ to } 4 \quad (17)$$

Remember, these computed points are based upon "guesses" for the numbers which represent both the remote body position and orientation. So, now we have two sets of ordered pairs:

The actual set $(t_{2j}, t_{3j})$ indicated on the sensor plane, and the guessed set $(s_{2j}, s_{3j})$ both for j = 1 to 4

We compute the two points in the sensor plane which represent the location of the origin of the remote body for the actual situation and for the guessed situation, respectively, using the scheme defined in equations (5), (6), and (7). The image of the origin of the actual set is

$$(t_{20}, t_{30}) = (t_{24}, t_{34}) + \sum_{k-1}^{3} c_k [(t_{2k}, t_{3k}) - (t_{24}, t_{34})] \quad (18)$$

and the image of the origin of the guessed set is

$$(s_{20}, s_{30}) = (s_{24}, s_{34}) + \sum_{k-1}^{3} c_k [(s_{2k}, s_{3k}) - (s_{24}, s_{34})] \quad (19)$$

From the differences or disparities in the relative locations of these two point-sets, and their computed origins, we are able to compute improved guesses for the position and/or orientation numbers. With these new improved guesses the process is repeated. The relative differences between point-set locations for the actual and the guessed sets provide six error measures which are used in the algorithms for improving the next guesses.

Guess-Error Reduction Algorithms

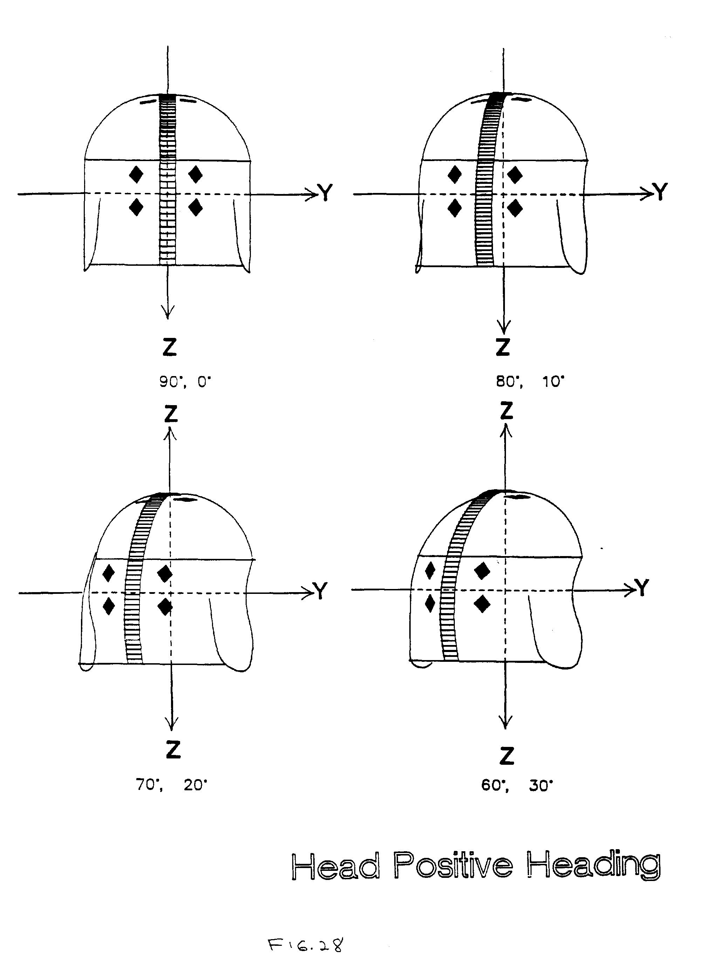

Let the points shown in Fig. 27 represent the actual image of the points observed by the sensor. The small cross represents the location of the computed origin based upon the location of these indicated points. There also is a computed set of "guessed" points (not shown) based upon guess for each position and orientation parameter. If the numbers which represent the position and orientation in the guessed situation are very close to the corresponding numbers representing the actual situation then the disposition of the guess-points along with its origin will be very close to the actual images shown in Fig. 27. The corresponding differences between the actual and the guessed are used in the following algorithms to improve the next guess.

The situation displayed by the actual images are:

$$r_0 = t_{21} - t_{22} + t_{34} - t_{31} \qquad \text{Range}$$

$$r_1 = t_{20} \qquad \text{Alpha}$$

$$r_2 = t_{30} \qquad \text{Beta}$$

$$r_3 = 4t_{20} - t_{21} - t_{22} - t_{23} - t_{24} \qquad \text{Heading}$$

$$r_4 = t_{31} + t_{32} + t_{33} + t_{34} - 4t_{30} \qquad \text{Elevation}$$

$$r_5 = t_{31} - t_{32} + t_{21} - t_{24} \qquad \text{Roll}$$

The situation represented by the guesses correspond to the following:

$$g_0 = s_{21} - s_{22} + s_{34} - s_{31} \qquad \text{Range}$$

$$g_1 = s_{20} \qquad \text{Track Heading}$$

$$g_2 = s_{30} \qquad \text{Track Elevation}$$

$$g_3 = 4s_{20} - s_{21} - s_{22} - s_{23} - s_{24} \qquad \text{Body Heading}$$

$$g_4 = s_{31} + s_{32} + s_{33} + s_{34} - 4t_{30} \qquad \text{Body Elevation}$$

$$g_5 = s_{31} - s_{32} + s_{21} - s_{24} \qquad \text{Body Roll}$$

The errors in the guess for each of these named parameters:
Range, Track Elevation, etc., we designate as, $e_k = r_k - g_k$ for k = 0 to 5; it is this error that is used to make a better "guess" -- then the process is repeated.

Designate the six parameters, Range, Track Heading, Track Elevation, etc., as,

$$a_k \text{ for } k = 0 \text{ to } 5$$

Then we can express the improved estimate for each parameter, the $a_k$'s as,

$$(a_k)_{new} = (a_k)_{old} - G_k e_k \text{ for } k = 0 \text{ to } 5 \quad (20)$$

where the $G_k$'s are gains to be selected to minimize the time to converge.

In dynamic measurement situations this iterative process would be continued indefinitely. In applications where only occasional measurements are required, the iterative process would continue until the error in the guess is judged to be sufficiently small.

## Digital Signal Processor (DSP) Computation - Detailed Preferred Embodiment

The preferred DSP computation embodiment is non-deterministic. An initial "guess" at the position and orientation of the helmet is made, and with recursive iterations the guess is modified to bring it closer and closer to the actual position and orientation of the helmet. This is similar to Newton's recursive method for solving polynomial equations (as described in An Introduction to Numerical Computations by Sidney Yakowitz and Ferenc Szidarovszky). The preferred embodiment is believed to provide an accuracy generally of around 30 arc seconds, and ideally of 3 arc seconds.

## Background

A number of points (LED's) are placed on the pilot's helmet, which can be sensed by the position sensing diode which is mounted in the cockpit. For the algorithm to be effective with the system, at least four non-coplanar points must be detectable by the sensor under any position and orientation of the pilot's head. With the matrix of the coordinates of the four points as they appear on the sensor (the data for which is received from the hardware), and a matrix of the position of the four visible points at a known position and orientation, intelligent guesses can be made in an iterative fashion as to the position and orientation of the helmet.

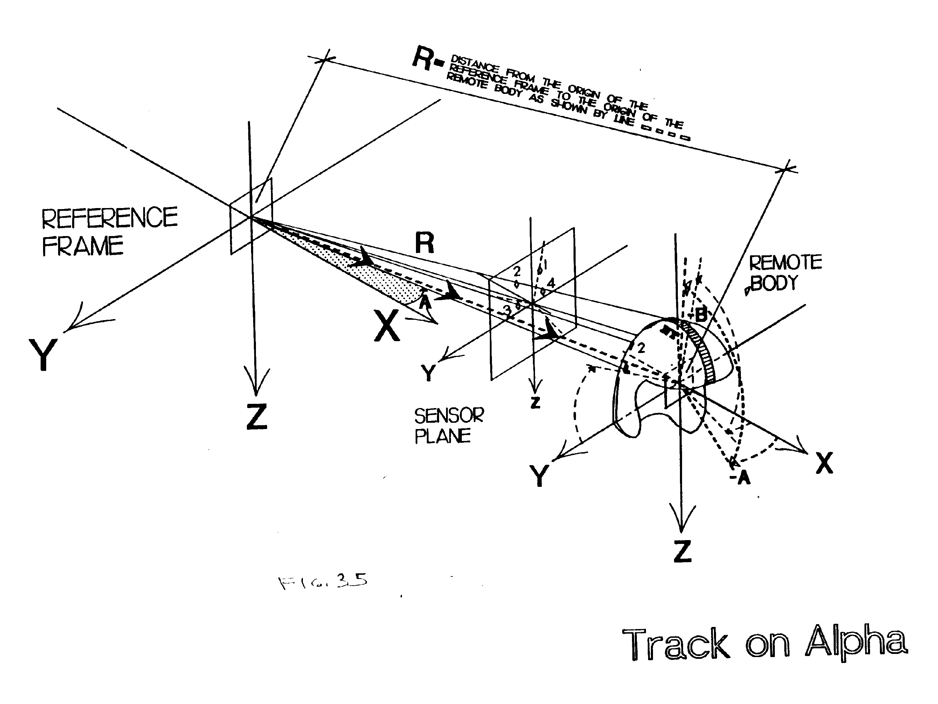

Two distinct (x,y,z) coordinate frames are used by the algorithm. The "remote body coordinate frame" can be thought of as being attached to the helmet. When the helmet moves and rotates, the remote body frame moves and rotates as well. The "reference frame" (also called the "sensor frame"), on the other hand, is a frame with a fixed position and orientation, with the origin of the reference frame on the sensor. These two coordinate frames are illustrated in Fig. 34.

Six variables uniquely define the position and orientation of the helmet (i.e., the remote body frame):

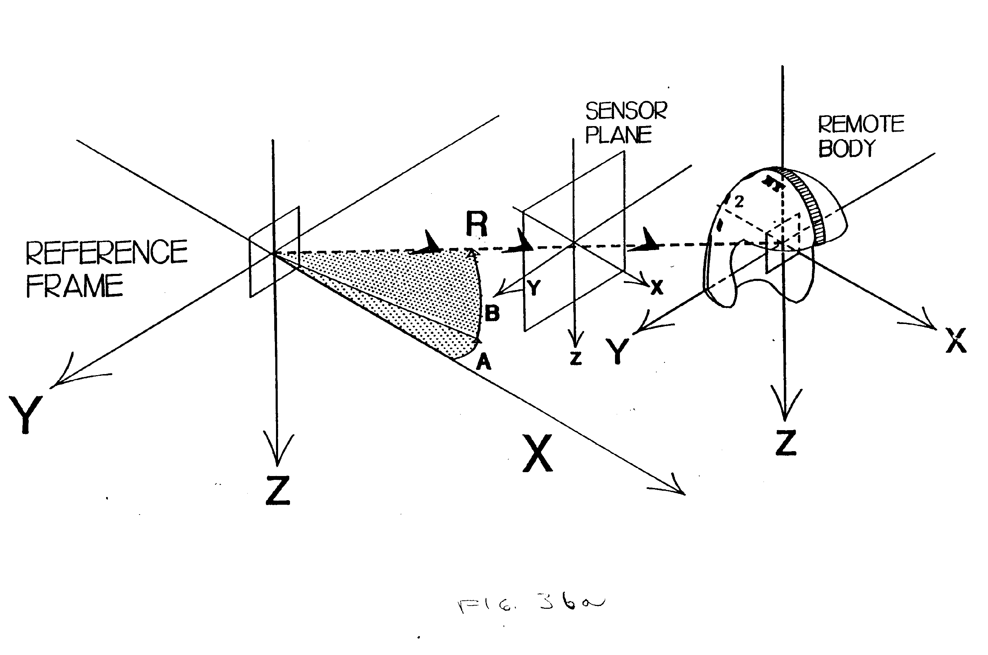

R: The distance from the origin of the reference frame to the origin of the remote body frame. This distance is shown in Fig. 36.

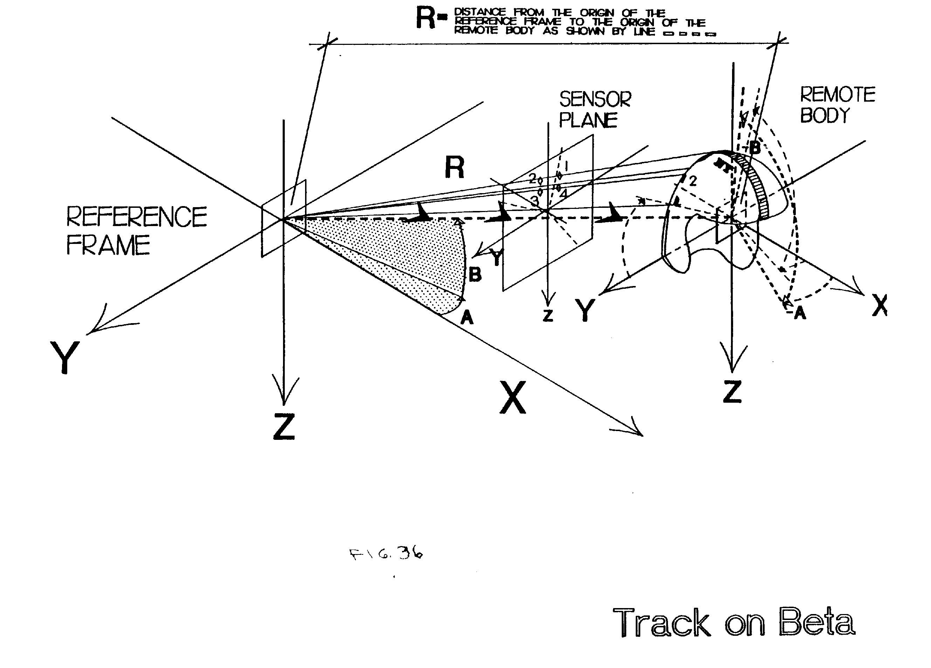

$\alpha$: The track of the object about the z axis of the reference frame. This is illustrated in Fig. 35.

$\beta$: The track of the object about the y axis of the reference frame. This is illustrated in Fig. 36.

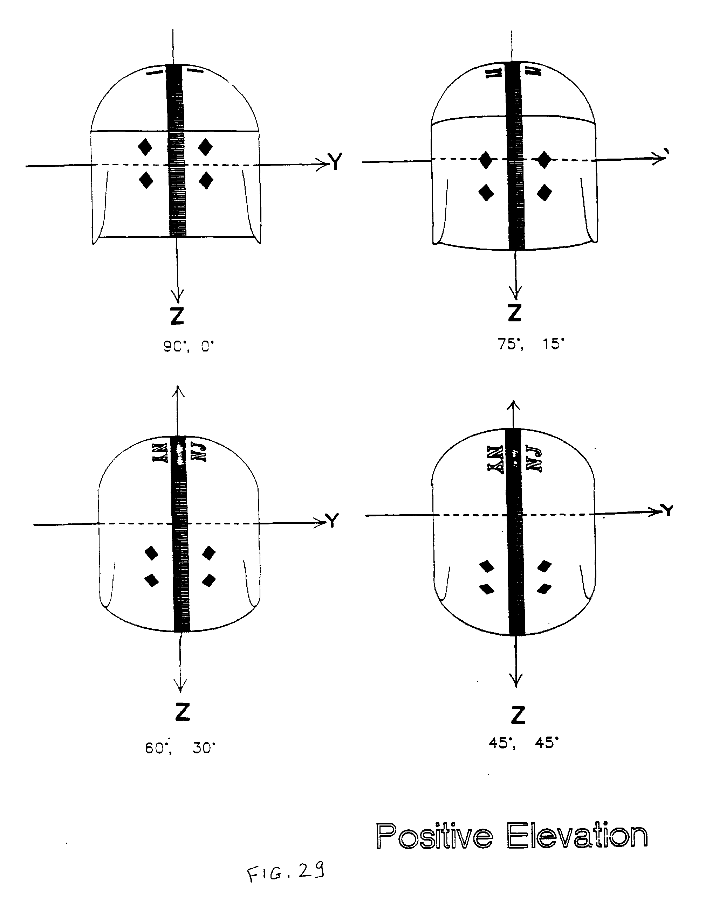

$\psi$: The rotation of the remote body about the z axis of the reference frame. This rotation is also called the "heading" of the head, and is illustrated in Fig. 28.

$\Theta$: The rotation of the remote body frame about the y axis of the remote body frame. This rotation is also called the "elevation" of the head, and is illustrated in Fig. 29.

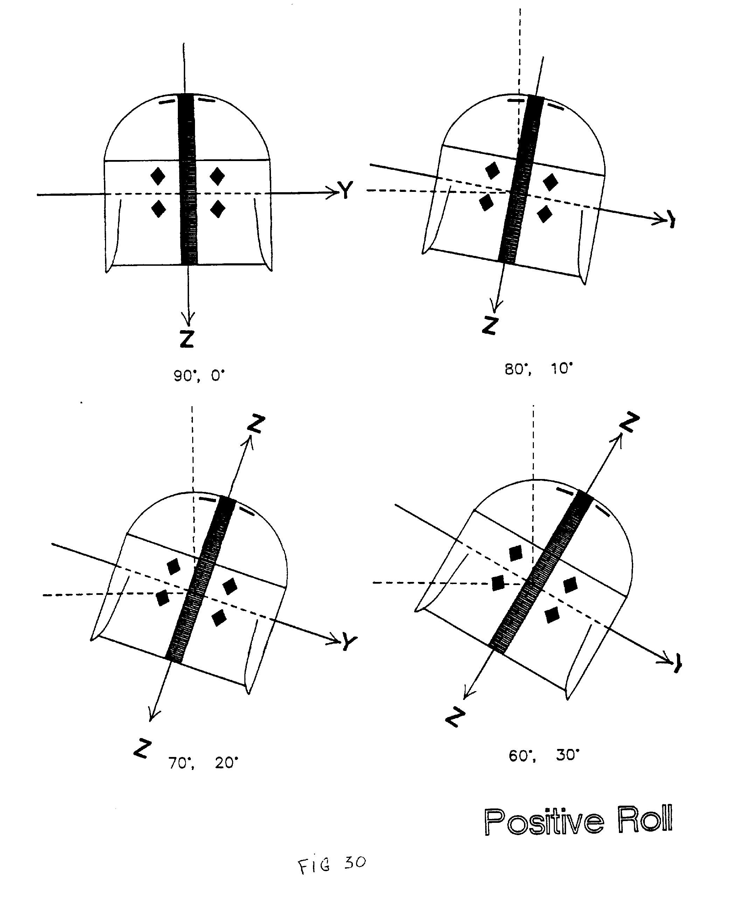

$\phi$: The rotation of the remote body frame about the x axis of the remote body frame. This rotation is also called the "roll" of the head, and is illustrated in Fig. 30.

These variables, known as the "six degrees of freedom" of the remote object, will be explained in more detail in the steps that follow.

The matrix of the coordinates of the four points as they appear on the sensor will be called the "sensor matrix." The algorithm also builds a "guess matrix" from the guessed values for the six variables defined above, for comparison to the sensor matrix. This guess matrix represents the readings of the coordinates of the four points which the sensor would generate if the remote body were at the guessed position and orientation. If the guess matrix and the sensor matrix are close enough, the guesses for the six degrees of freedom are used as the values which represent the actual position and orientation of the pilot's helmet. Otherwise, a new guess for the six values is generated, and the process is repeated.

Step 1:

The four points are represented at an ápriori position and orientation by their x, y, and z coordinates in the remote body coordinate frame, as columns in the matrix:

$$ P \quad = \quad \begin{bmatrix} p_{11} & p_{12} & p_{13} & p_{14} \\ p_{21} & p_{22} & p_{23} & p_{24} \\ p_{31} & p_{32} & p_{33} & p_{34} \end{bmatrix} $$

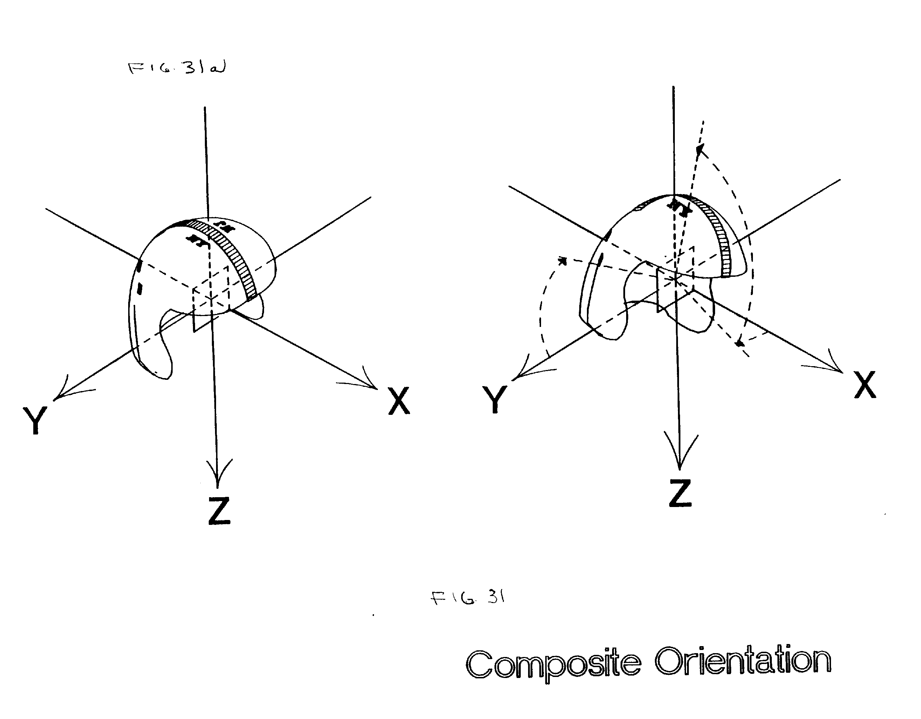

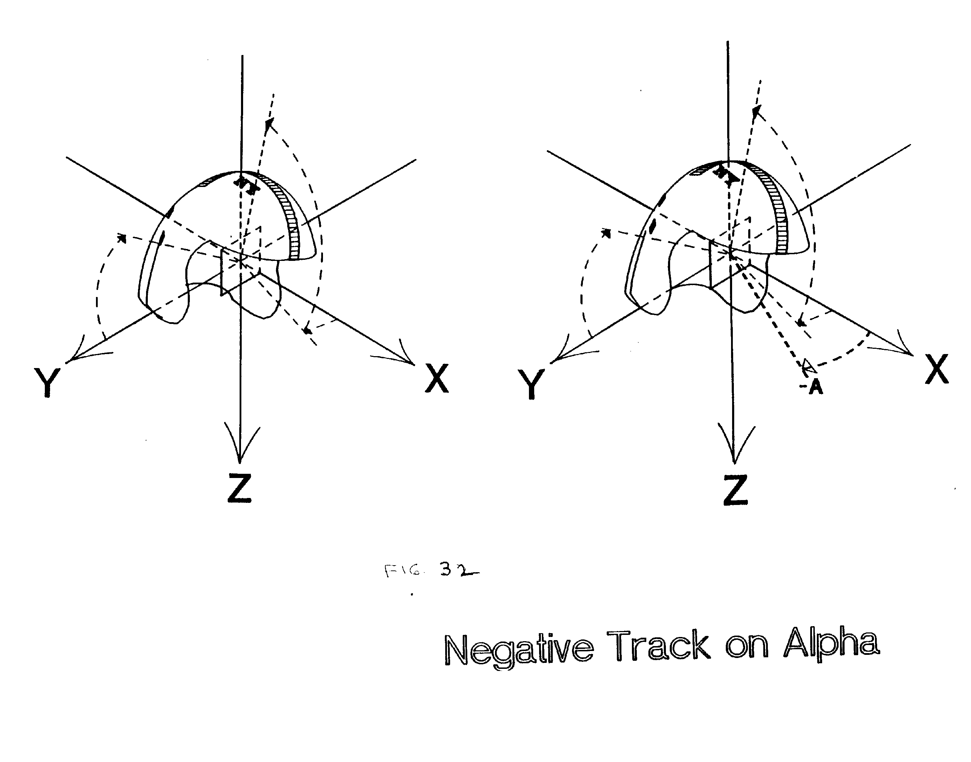

Where, for each $p_{ij}$, i represents the axis (1=x, 2=y, 3=z), and j represents which of the four points is being described. The coordinates of the points used ápriori are their coordinates when the reference frame and the remote body frame are perfectly aligned, as illustrated in Fig. 31a. Thus, the matrix P represents the ápriori coordinates of the four points in both the reference frame and the remote body frame. The matrix is set up by actually measuring the position of each point with the two coordinate frames aligned, and representing that measurement using (x,y,z) notation. The four points we are interested in are the four points observable at the new position and orientation of the pilot's head. Thus, calculations will be done and stored ahead of time on all permutations of four points, and the values used will be the values which correspond to the four scanned points.

Each of the four columns are called "column vectors," since they can be seen to represent a vector from the zero point of the remote body coordinate frame to the identified point.

The matrix P defines the following four vectors:

Step 2:

From the matrix P, compute matrix $R_u$ by subtracting the fourth point from each of the first three (for example, $p_{11} - p_{14} = u_{11}$, $p_{22} - p_{24} = u_{22}$, $p_{33} - p_{34} = u_{33}$ etc.) such that:

$$ u_{ij} = p_{ij} - p_{i4} \qquad 1 \leq i \leq 3 $$

$$ 1 \leq j \leq 3 $$

And represent this matrix as:

$$R_u = \begin{bmatrix} u_{11} & u_{12} & u_{13} \\ u_{21} & u_{22} & u_{23} \\ u_{31} & u_{32} & u_{33} \end{bmatrix}$$

The three vectors defined by $R_u$ are vectors that terminate at points 1, 2, and 3, but originate at point 4 rather than at the zero point of the remote body coordinate frame. Thus, $R_u$ represents the following three vectors:

The coordinates of the three points as expressed in $R_u$ are the coordinates in reference to $p_4$, that is, the coordinates in a coordinate frame in which $p_4$ is the origin. We will call this coordinate frame the "temporary coordinate frame."

Step 3:

Form the negative of vector $\vec{P}_4$ (hereinafter "$-\vec{P}_4$").

For the purposes of this disclosure, the negative of $\vec{P}_4$ will mean a vector with the same endpoints as $\vec{P}_4$, but with the opposite direction. As is illustrated in the following diagram, this vector is formed by taking the negative of the coordinates of $\vec{P}_4$, and forming a vector to these coordinates from the origin of the temporary coordinate frame:

The coordinates of point $-p_4$ are $(-p_{14}, -p_{24}, -p_{34})$. It is clear that the vector formed terminates at the origin of the remote body frame, as well as at the origin of the reference frame when the remote body frame is at its

ápriori position and orientation. The ápriori position and orientation of the remote body frame is its position and orientation when it is perfectly aligned with the reference frame.

Step 4:

Calculate the coefficients for the linear combination of $\vec{u}_k$, where $1 \leq k \leq 3$, to form $-\vec{p}_4$.

$-\vec{p}_4$ can be expressed in terms of $\vec{u}_1$, $\vec{u}_2$, and $\vec{u}_3$. Represented as a linear equation:

$$-\vec{p}_4 = c_1 u_{11} + c_1 u_{21} + c_1 u_{31} , c_2 u_{12} + c_2 u_{22} + c_2 u_{32} , c_3 u_{13} + c_3 u_{23} + c_3 u_{33}.$$

The components of $-\vec{p}_4$ can be expressed in terms of the corresponding components of $\vec{u}_1$, $\vec{u}_2$, and $\vec{u}_3$:

$$-p_{14} = c_1 u_{11} + c_2 u_{12} + c_3 u_{13}$$
$$-p_{24} = c_1 u_{21} + c_2 u_{22} + c_3 u_{23}$$
$$-p_{34} = c_1 u_{31} + c_2 u_{32} + c_3 u_{33}$$

The p values are known from the sensor matrix, the u values are known from the $R_u$ matrix calculated in Step 2, and with three equations, we can solve for $c_1$, $c_2$ and $c_3$.

Step 5:

Find the location of the origin of the remote body frame in the sensor frame.

The coefficients calculated in Step 4 will always produce a vector from $p_4$ to the origin of the remote body frame, regardless of the position and orientation of the remote body frame. In order to calculate these coefficients, we used the relative positions of $p_4$ and the origin (as well as the difference between $p_4$ and each of the other points at their ápriori position and orientation), where the coordinates of both these points were known (the origin of the remote body frame was known to be at (0,0,0) in the reference frame). Now that the coefficients have been calculated, they can be used with the coordinates of $s_4$ (point 4 as measured by the sensor) to determine the new coordinates for the origin of the remote body frame as measured by the sensor. The method for accomplishing this is described below.

The coordinates of $-\vec{p}_4$ when the remote body frame and the reference frame were aligned was not (0,0,0), since the coordinate frame was changed for matrix $R_u$ to use $p_4$ as the origin (the temporary coordinate frame). The following diagram depicts $-\vec{p}_4$ in the temporary coordinate frame:

If these coordinates were used in the remote body frame, the vector $-\vec{p}_4$ would look as follows in the remote body frame:

Of course, the coordinates of the origin of the remote body frame in the reference frame at the new position and orientation of the remote body frame are not known. This is what we wish to calculate. However, $c_1$, $c_2$, and $c_3$ will be used to form $-\vec{p}_4$ in the remote body frame, as shown above. If we add the values for $p_{14}$, $p_{24}$ and $p_{34}$ back to the coordinates of point $-p_4$, we have the coordinates of the origin of the remote body frame. It is clear this calculation will always produce the origin of the remote body frame, even when it moves away from the reference frame (as in Fig. 36), since $c_1$, $c_2$, and $c_3$, will always generate a vector with respect to the origin of the remote body frame.

Thus, if the points in the sensor frame are represented as:

$$S = \begin{bmatrix} s_{11} & s_{12} & s_{13} & s_{14} \\ s_{21} & s_{22} & s_{23} & s_{24} \\ s_{31} & s_{32} & s_{33} & s_{34} \end{bmatrix}$$

we will perform the following computations to determine the origin of the sensor frame:

Step 5.1

From the sensor matrix, compute matrix $R_q$ by subtracting the fourth point from each of the first three.

The procedure for performing the operation is described in Step 2 (only the sensor matrix will be used instead of the matrix P.) The matrix $R_q$ is represented as:

$$R_q = \begin{bmatrix} q_{11} & q_{12} & q_{13} \\ q_{21} & q_{22} & q_{23} \\ q_{31} & q_{32} & q_{33} \end{bmatrix}$$

Step 5.2

Use matrix $R_q$ to calculate the coordinates for the origin of the sensor matrix (i.e. the origin of the remote body at its actual position and orientation).

The explanation in Step 5 demonstrates the following calculations will generate these coordinates:

$SO_x$ = x coordinate of the remote body frame origin on the sensor
$= c_1 *q_{11} + c_2 *q_{12} + c_3 *q_{13} + s_{14}$
$SO_y$ = y coordinate of the remote body frame origin on the sensor
$= c_1 *q_{21} + c_2 *q_{22} + c_3 *q_{23} + s_{24}$

$SO_z$ = z coordinate of the remote body frame origin on the sensor
= $c_1 * q_{31} + c_2 * q_{32} + c_3 * q_{33} + s_{34}$

Step 6:

Calculate values for the sensor matrix which will later be used to determine if the guess values for the six degrees of freedom are close enough to the actual values to stop guessing.

**R:**

R is the distance along a straight line from the origin of the reference frame to the origin of the remote body frame. The value to be used for comparison (Sd) will be the sum of the differences between the coordinates for one of the four points and the corresponding coordinates of the origin. The algorithm uses point 1 to calculate these differences. Thus:

$$Sd = (s_{21} = SO_y) + (s_{31} - SO_z)$$

$\alpha$:

The value to be used for comparison (Sa) will be the y coordinate of the origin of the sensor frame. Thus,

$$Sa = SO_y$$

$\beta$:

The value to be used for comparison (Sb) will be the z coordinate of the origin of the sensor frame. Thus:

$$Sb = SO_z$$

**Heading:**

The value to be used for comparison (Sh) will be the algebraic sum of the y component of each of the four points on the sensor with respect to the y component of the origin on the sensor. As is illustrated in Fig. 28, the y coordinate of the origin gets larger with respect to the y coordinates of the four points when the heading is positive. Thus, to be consistent, the value for comparison should be the algebraic sum of the y component of the origin on the sensor with respect to the y components of each of the four points on the sensor, or $[(4 * SO_y) - s_{21} + s_{22} + s_{23} + s_{24}]$. It is not done this way here, however. This inconsistency is accounted for in Step 17 when the new guess is generated, by adding the value of Dh to the old guess rather then subtracting it. Thus:

$$Sh = s_{21} + s_{22} + s_{23} + s_{24} - (4 * SO_y)$$

**Elevation:**

The value to be used for comparison (Se) will be the algebraic sum of the z component of each of the four points on the sensor with respect to the z component of the origin on the sensor. As is illustrated in Fig. 29, the z coordinate of the origin gets smaller with respect to the z coordinates of the four points when the elevation is positive. Thus:

$$Se = s_{31} + s_{32} + s_{33} + s_{34} - (4 * SO_z)$$

**Roll:**

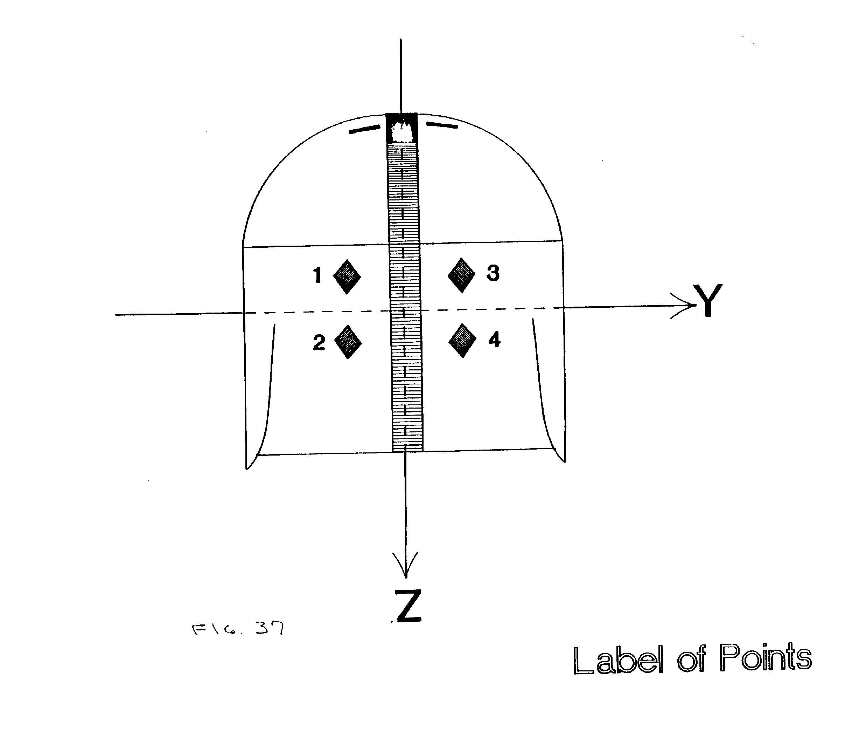

The layout (numbering) of the four points is illustrated in Fig. 37. As is illustrated in Fig. 30, positive roll is a tilt of the pilot's head to the right.

When the pilot tilts the head to the right, point 3 will have a greater y coordinate than point 4, and point 1 will have a greater z coordinate than point 3 (when the head is upright point 3 and point 4 have the same y coordinate, and point 1 and point 3 have the same z coordinate).

Thus, the value to be used for comparison (Sr) will be the y coordinate of point 3 minus the y coordinate of point 4 plus the z coordinate of point 1 minus the z coordinate of point 3:

$$Sr = s_{23} - s_{24} + s_{31} - s_{33}$$

Step 7:

Make an initial "guess" for the values of the six degrees of freedom at the actual position of the remote body frame.

A convenient initial guess is zero for all degrees of freedom, meaning that the remote body frame is perfectly aligned with the reference frame. Of course, given that the origin of the reference frame lies in the sensor, it is impossible for this first guess to be correct. Here, however, 18 inches is used as the initial guess for R (the initial guess for the other five degrees of freedom is zero). This is because the lens used here is fixed focused at approximately 18 inches.

Step 8:

Construct a "rotation matrix" using the guessed angles $\phi$, $\Theta$ and $\psi$.

As discussed above, the algorithm begins with the supposition that the remote body frame and the reference frame are aligned. The matrix P, then, represents the coordinates of the four points as measured in either of the two frames. Step 8 is the first step toward determining what the sensor readings for the guessed position would be, by constructing a matrix to orient the matrix P by the guessed angles.

The rotation of the helmet in three dimensions is known to be defined by the following 3 x 3 matrix:

$$
A = \begin{bmatrix} 1 & 0 & 0 \\ 0 & \cos\phi & \sin\phi \\ 0 & -\sin\phi & \cos\phi \end{bmatrix} \begin{bmatrix} \cos\Theta & 0 & -\sin\Theta \\ 0 & 1 & 0 \\ \sin\Theta & 0 & \cos\Theta \end{bmatrix}
$$

$$
\begin{bmatrix} \cos\psi & \sin\psi & 0 \\ -\sin\psi & \cos\psi & 0 \\ 0 & 0 & 1 \end{bmatrix} ,
$$

$$
= \begin{bmatrix} a_{11} & a_{12} & a_{13} \\ a_{21} & a_{22} & a_{23} \\ a_{31} & a_{32} & a_{33} \end{bmatrix}
$$

where:

$a_{11} = \cos\psi \cos\Theta$

$a_{12} = \sin\psi \cos\Theta$

$a_{13} = -\sin\Theta$

$a_{21} = \cos\psi \sin\Theta \sin\phi - \sin\psi \cos\phi$

$a_{22} = \sin\psi \sin\Theta \sin\phi + \cos\psi \cos\phi$

$a_{23} = \cos\Theta \sin\phi$

$a_{31} = \cos\psi \sin\Theta \cos\phi + \sin\psi \sin\phi$

$a_{32} = \sin\psi \sin\Theta \cos\phi - \cos\psi \sin\phi$

$a_{33} = \cos\Theta \cos\phi$

The multiplication of two 3x3 matrices forms a 3x3 matrix, calculated as follows:

$$
\begin{bmatrix} a & b & c \\ d & e & f \\ g & h & i \end{bmatrix} \times \begin{bmatrix} j & k & l \\ m & n & o \\ p & q & r \end{bmatrix} =
$$

$$
\begin{bmatrix} aj + bm + cp & ak + bn + cq & al + bo + cr \\ dj + em + fp & dk + en + fq & dl + eo + fr \\ gj + hm + ip & gk + hn + iq & gl + ho + ir \end{bmatrix}
$$

Matrix multiplication is associative, and the 3x3 matrix A represents the multiplication of the three matrices.

This rotation matrix is used to relate the remote body frame to the reference frame. The transpose of matrix A, denoted $A^t$, is used to rotate the points, where:

$$
A^t = \begin{bmatrix} a_{11} & a_{21} & a_{31} \\ a_{12} & a_{22} & a_{32} \\ a_{13} & a_{23} & a_{33} \end{bmatrix}
$$

In order to allow the translation in Step 10 to be incorporated into the MM matrix in Step 11 (so the entire position and orientation change in matrix P can be accomplished with a single multiplication), matrix $A^t$ is expressed using homogeneous coordinates. Matrix $A^t$, then, has the following elements:

$$
A^t = \begin{bmatrix} a_{11} & a_{21} & a_{31} & 0 \\ a_{12} & a_{22} & a_{32} & 0 \\ a_{13} & a_{23} & a_{33} & 0 \\ 0 & 0 & 0 & 1 \end{bmatrix}
$$

Step 9:

Construct a "tracking" matrix, and the transpose of the tracking matrix, using the guessed values for $\alpha$ and $\beta$.

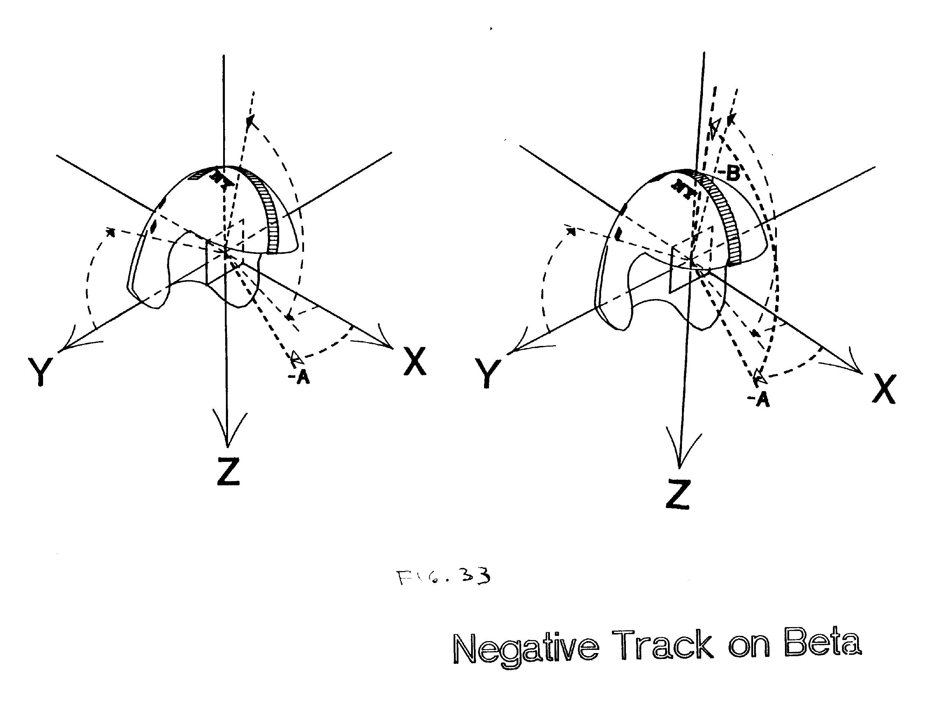

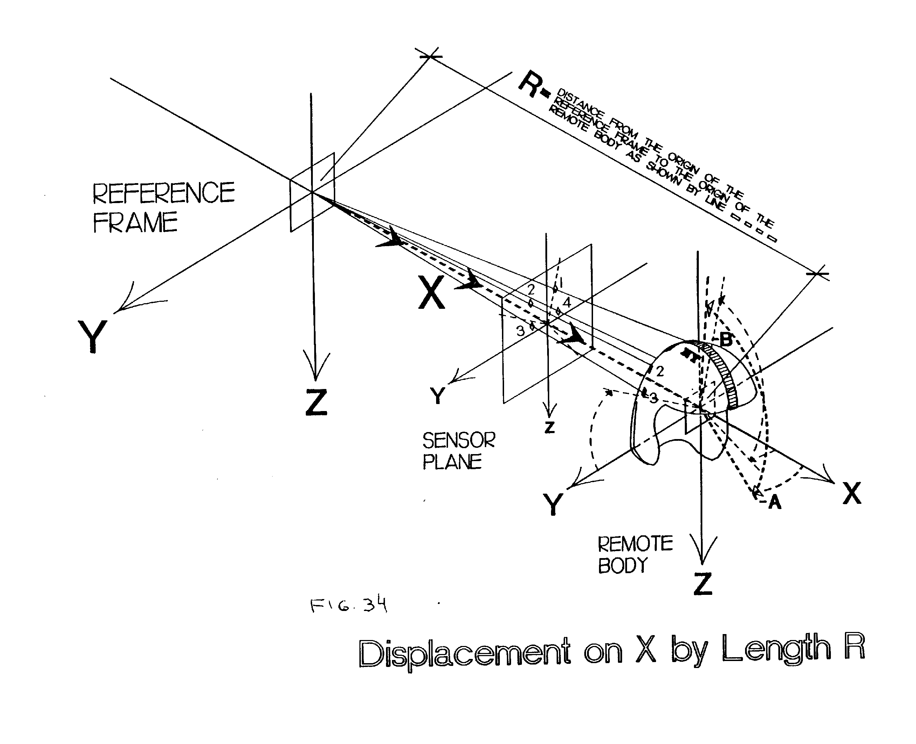

As is illustrated in Figs. 31-36, tracking is the orientation change an object undergoes as it is being translated to its new polar position. Since this change in orientation is unwanted, the transpose of this tracking matrix is also constructed. The tracking matrix, PP, is used to change the orientation of the object at the origin, such that when it is projected to its new position, the original orientation of the object is maintained. This change is shown in Figs. 32, 33. The transpose of the tracking matrix, $PP^t$, is used to effect the rotation on $\alpha$ and $\beta$, as shown in Figs. 35, 36. The tracking matrix is:

$$
PP = \begin{bmatrix} b_1 & b_2 & b_3 \\ b_4 & b_5 & b_6 \\ b_7 & b_8 & b_9 \end{bmatrix}
$$

where:

$b_1 = \cos(\alpha) * \cos(\beta)$
$b_2 = \sin(\alpha) * \cos(\beta)$
$b_3 = -\sin(\beta)$
$b_4 = -\sin(\alpha)$

$b_5 = \cos(\alpha)$
$b_6 = 0$
$b_7 = \cos(\alpha) * \sin(\beta)$
$b_8 = \sin(\alpha) * \sin(\beta)$
$b_9 = \cos(\beta)$

$PP^t$, then, is

$$PP^t = \begin{bmatrix} b_1 & b_4 & b_7 \\ b_2 & b_5 & b_8 \\ b_3 & b_6 & b_9 \end{bmatrix}$$

We express PP and $PP^t$ in homogeneous form as well:

$$PP = \begin{bmatrix} b_1 & b_2 & b_3 & 0 \\ b_4 & b_5 & b_6 & 0 \\ b_7 & b_8 & b_9 & 0 \\ 0 & 0 & 0 & 1 \end{bmatrix}$$

$$PP^t = \begin{bmatrix} b_1 & b_4 & b_7 & 0 \\ b_2 & b_5 & b_8 & 0 \\ b_3 & b_6 & b_9 & 0 \\ 0 & 0 & 0 & 1 \end{bmatrix}$$

Step 10:

Construct a translation matrix, TR, for positioning the origin of the remote body the distance R from the origin of the reference frame. This matrix has the elements as follows:

$$TR = \begin{bmatrix} 1 & 0 & 0 & R \\ 0 & 1 & 0 & 0 \\ 0 & 0 & 1 & 0 \\ 0 & 0 & 0 & 1 \end{bmatrix}$$

Step 11:

Construct the matrix MM, which when multiplied with the matrix P will generate a matrix of the points at the guessed position and orientation.

$$MM = (PP^t)(TR)(PP)(A^t)$$

Step 12:

Multiply the MM matrix with the P matrix. In order to perform this step, matrix P will have to be expressed in homogeneous form prior to the multiplication. Thus:

$$P = \begin{bmatrix} p_{11} & p_{12} & p_{13} & p_{14} \\ p_{21} & p_{22} & p_{23} & p_{24} \\ p_{31} & p_{32} & p_{33} & p_{34} \\ 1 & 1 & 1 & 1 \end{bmatrix}$$

Put the result in the guess matrix. This matrix is a matrix of the coordinates of the four points in the reference frame at the guessed position and orientation.

Step 13:

Now that the coordinates of the four points at the guessed position and orientation of the remote body are known, determine the readings the four points would have on the sensor at this guessed position and orientation.

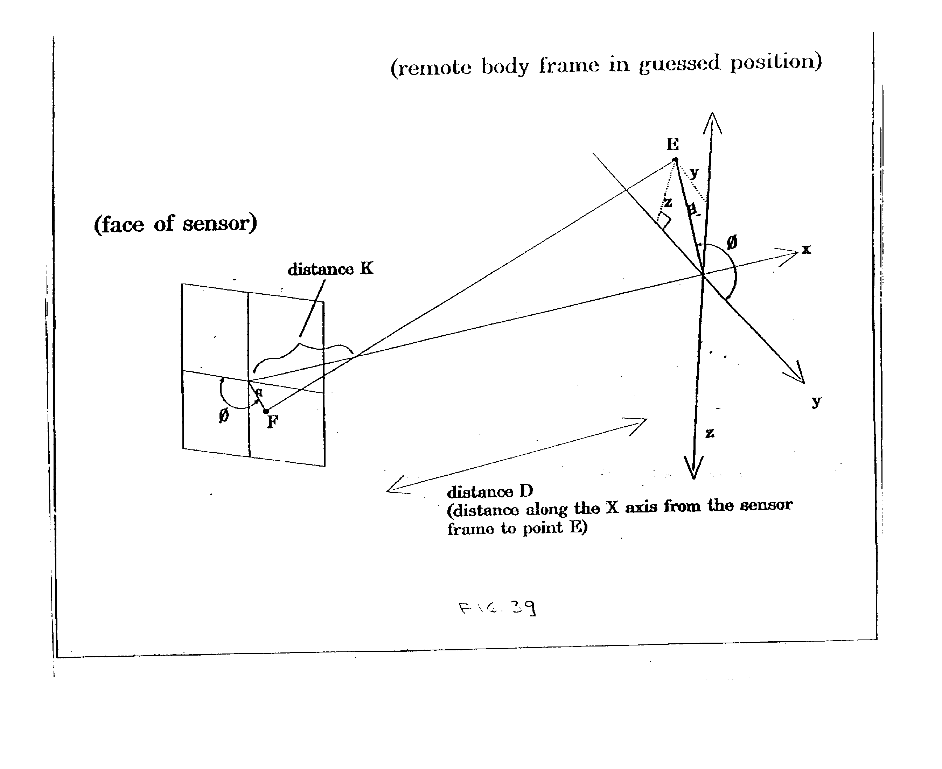

Fig. 39 illustrates a point on the remote body frame in its guessed position (point E) and the corresponding point as it appears on the sensor (point F). The following are the variables needed to calculated what the sensor readings for point E (i.e. the coordinates of point F) would be:

D: the distance from the focal point of the sensor lens to the x position of point E.
K: the distance from the sensor to the focal point of the sensor lens.
m': the length of the vector from the origin of the remote body frame to point E.
z: the z coordinate of point E on the remote body frame.
y: the y coordinate of point E on the remote body frame.
$\phi$: the angle from the positive x axis to m'.
q: the length of the vector from the origin of the reference frame to point F (the representation of point E on the sensor).
y': the y coordinate of point F on the reference frame.
z': the z coordinate of point F on the reference frame.

Distance D is the x position of point E, and is found from the x position of point E in the guess matrix.

y' and z' represent the y and z sensed coordinates of point E, and can be calculated with the following trigonometric equations:

$$m' = \sqrt{z^2 + y^2}$$

$$\phi = \operatorname{atan}\left(\frac{z}{y}\right)$$

$$q = \frac{k}{D}(m')$$

$$y' = q * \cos\phi$$

$$z' = q * \sin\phi$$

y and z, of course, are known from the guess matrix as modified in Step 12. k is the known distance from the sensor face to the focal point of the sensor lens. Using these knowns, the given steps derive values for y' and z', which are the sensed readings for the point E.

This procedure should be followed for each of the four points in the guess matrix, and for each point the values for y' and z' are substituted for the existing values of their y and z coordinates. The guess matrix now contains the values for the y and z coordinates of each of the points as they would be read by the sensor if the remote body frame were actually at its guessed position.

The sensor matrix information as received from the hardware will not contain x coordinates for the four points. The sensor sits in the plane of the y-z axes with the x axis normal to the center point of the face of the sensor, as shown:

As a result, the change in position of the zero point of the remote body frame (The change in position of the zero point of the remote body frame represents the change in position of the four observable points. This is distinguished from the change in orientation of the points, which is rotation about the zero point of the remote body frame.) in the x direction cannot be directly measured by the sensor.

At this point, the values in the guess matrix will be represented as

$$
\begin{bmatrix}
g_{11} & g_{12} & g_{13} & g_{14} \\
g_{21} & g_{22} & g_{23} & g_{24} \\
g_{31} & g_{32} & g_{33} & g_{34}
\end{bmatrix}
$$

Step 13a:

As an alternative step to Step 13, now that coordinates of the four points at the guessed position and orientation of the remote body are computed, determine the reading the four points would have on the sensor at this guessed position and orientation.

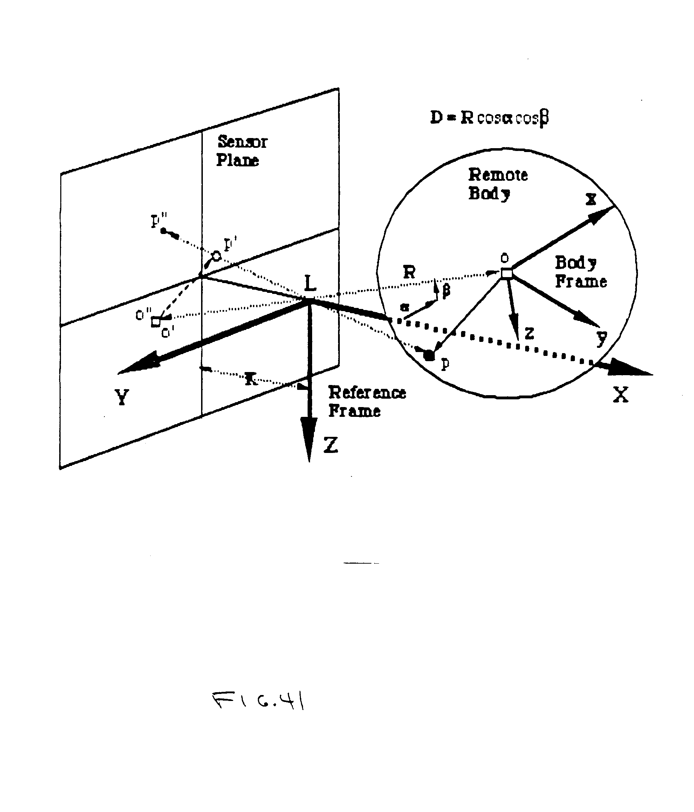

Fig. 41 illustrates one such point, p (whether guessed or actual), on the remote body frame and its corresponding projection, $p''$, in the sensor plane. We present an algorithm for each sensor reading, $p''$, as an ordered yz pair in the sensor plane. Following are the variables and other parameters needed to make the calculation:

D: the distance (in the reference frame x-direction) from the center of the sensor lens L, to the origin, o, of the remote body.

K: the distance from the center of the sensor lens to the sensor plane.

$x_j$: the x-component of the point $p_j$ (1st element in the $j^{th}$ column of guessed matrix)

$y_j$: the y-component of the point $p_j$ (2nd element in the $j^{th}$ column of guessed matrix)

$z_j$: the z-component of the point $p_j$ (3rd element in the $j^{th}$ column of guessed matrix)

$y'_j$: the y-component of the image, $p''_j$, in the sensor plane of point $p_j$

$z'_j$: the z-component of the image, $p''_j$, in the sensor plane of point $p_j$

The sensor plane ordered pairs, $(y'_j, z'_j)$, for each point (j = 1 to 4) on the remote body are:

$$y'_j = [K/x_j]y_j \text{ and } z'_j = [K/x_j]z_j \quad j = 1,2,3,4$$

Each of the $x_j$, $y_j$ and $z_j$'s, of course, are known from the columns of the guess matrix as discussed in Step 12.

This procedure should be followed for each of the four points in the guess matrix, and for each point the values for y' and z' are substituted for the existing values of their y and z coordinates. The guess matrix now contains the values for the y and z coordinates of each of the points as they would be read by the sensor if the remote body frame were actually at its guessed position.

The sensor matrix information as received from the hardware will not contain x coordinates for the four points. The sensor plane is parallel to the reference frame yz plane with the x-axis normal to the face of the sensor at its center, as shown in Fig. 41.

As a result, the change in position of the zero point of the remote body frame (The change in position of the zero point of the remote body frame represents the change in position of the four observable points. This is distinguished from the change in orientation of the points, which is rotation about the zero point of the remote body frame.) in the x direction cannot be directly measured by the sensor.

At this point, the values in the guess matrix will be represented as

$$\begin{bmatrix} g_{11} & g_{12} & g_{13} & g_{14} \\ g_{21} & g_{22} & g_{23} & g_{24} \\ g_{31} & g_{32} & g_{33} & g_{34} \end{bmatrix}$$

Step 14:

From the guess matrix, compute the matrix $R_v$, by subtracting the fourth point from each of the first three. The procedure for performing the operation is described in Step 2 (except the guess matrix will be used instead of the matrix P). The matrix $R_v$, is represented as:

$$R_v = \begin{bmatrix} v_{11} & v_{12} & v_{13} \\ v_{21} & v_{22} & v_{23} \\ v_{31} & v_{32} & v_{33} \end{bmatrix}$$

Step 15:

Find the origin of the guess matrix.

We know from Step 4 that the coefficients $c_1$, $c_2$ and $c_3$ produce the vector to the origin of the remote body frame, under any position and orientation of the remote body frame. Thus, the following equations will derive the coordinates of the origin of the remote body frame at its guessed position and orientation, as was explained in Step 5.

$GO_x$ = x coordinate of guess matrix origin = $c_1 v_{11} + c_2 v_{12} + c_3 v_{13} + g_{14}$
$GO_y$ = y coordinate of guess matrix origin = $c_1 v_{21} + c_2 v_{22} + c_3 v_{23} + g_{24}$
$GO_z$ = z coordinate of guess matrix origin = $c_1 v_{31} + c_2 v_{32} + c_3 v_{33} + g_{34}$

Step 16:

Calculate the values for the guess matrix which will be used to compare to the values calculated in Step 6 for the sensor matrix. The rationale for each of these calculations is described in Step 6.

**R:**

$Gd = (g_{21} - GO_y) + (g_{31} - GO_z)$

$\alpha$:

$Ga = GO_y$

$\beta$:

$Gb = GO_z$

**Heading:**

$Gh = g_{21} + g_{22} + g_{23} + g_{24} - (4 * GO_y)$

**Elevation:**

$Ge = g_{31} + g_{32} + g_{33} + g_{34} - (4 * GO_z)$

24

**Roll:**

$$Gr = g_{23} - g_{24} + g_{31} - g_{33}$$

Step 17:

Compare the values calculated in Step 6 to those calculated in Step 14 to determine if further insertions through the loop are required.

Naturally, criterion for determining if the guessed values are close enough to the actual values can vary depending on the performance and accuracy requirements of the system being designed. Here, only the heading, elevation and roll values are used to determine when to fall out of the recursive loop.

The following differences are calculated:

$$Dd = Sd-Gd \qquad Dh = Sh-Gh$$

$$Da = SO_y-GO_y \qquad De = Se-Ge$$

$$Db = SO_z-GO_z \qquad Dr = Sr-Gr$$

Each of these values is then divided by a factor, found by trial and error, to allow convergence on the answer faster, as well as to avoid oscillation around the answer. In a system which has been implemented, Dd is divided by 1.5, Da is divided by 6, Db is divided by 6, Dh is divided by 4, De is divided by 4, and Dr is divided by 1.

Only Dh, De and Dr are used here to determine if the guess is close enough to the actual position and orientation of the remote body to stop. If the absolute values of all three are less than .00005, the guess is deemed to be the answer. Otherwise, the algorithm returns to Step 8 and proceeds from there using a new guess.

The new guess is calculated as follows:

New guess for R = Old guess for R - Dd

New guess for $\alpha$ = Old guess for $\alpha$ + Da

New guess for $\beta$ = Old guess for $\beta$ - Db

New guess for Heading = Old guess for Heading + Dh

New guess for Elevation = Old guess for Elevation - De

New guess for Roll = Old guess for Roll - Dr

Digital Signal Processor (DSP) Computation - Detailed Alternate Embodiment

The alternate DSP computation embodiment here described also is non-deterministic. An initial "guess" at the position and orientation of the helmet is made, and with recursive iterations the guess is modified to bring it closer and closer to the actual position and orientation of the head. Again, this is similar to Newton's recursive method for solving polynomial equations. This alternative embodiment is believed to provide an accuracy generally of around 3 or more arc minutes, and ideally of $1\frac{1}{2}$ arc minutes.

Background

A number of points (LED's) are placed on the pilot's helmet, which can be sensed by the position sensing diode which is mounted in the cockpit. For the algorithm to be effective with the system, at least four points must be detectable by the sensor under any position and orientation of the pilot's head. Unlike the preferred embodiment, these four points may be coplanar, however, also unlike the preferred embodiment, each combination of four points here must be arranged to form a square. With the matrix of the coordinates of the four points as they appear on the sensor (the data for which is received from the hardware), and a matrix of the position of the four visible points at a known position and orientation, intelligent guesses can be made in an iterative fashion as to the position and orientation of the helmet.

Two distinct (x,y,z) coordinate frames are used by the algorithm. The "remote body coordinate frame" can be thought of as being attached to the helmet. When the helmet moves and rotates, the remote body frame moves and rotates as well. The "reference frame" (also called the "sensor frame"), on the other hand, is a frame whose position and orientation is fixed, with the origin on the sensor . These two coordinate frames are illustrated in Fig. 34.

Six variables uniquely define the position and orientation of the helmet (i.e., the remote body frame):

x:     the position of the origin of the remote body frame on the x axis of the reference frame.

y:     the position of the origin of the remote body frame on the y axis of the reference frame.

z:     the position of the origin of the remote body frame on the z axis of the reference frame.

$\psi$:     the rotation of the remote body frame about the z axis of the reference frame. This rotation is also called the "heading" of the head, and is illustrated in Fig. 28.

$\Theta$:     the rotation of the remote body frame about the y axis of the remote body frame. This rotation is also called the "elevation" of the head, and is illustrated in Fig. 29.

$\phi$:     the rotation of the remote body frame about the x axis of the remote body frame. This rotation is also called the "roll" of the head, and is illustrated in Fig. 30.

These variables, known as the "six degrees of freedom" of the remote object, will be explained in more detail in the steps that follow.

The matrix of the coordinates of the four points as they appear on the sensor will be called the "sensor matrix." The algorithm also builds a "guess matrix" from the guessed values for the six variables defined above, for comparison to the sensor matrix. This guess matrix represents the readings of the coordinates of the four points which the sensor would generate if the remote body were at the guessed position and orientation. If the two matrices are close enough, the guesses for the six variables are used as the values which represent the actual position and orientation of the pilot's helmet. Otherwise, a new guess for the six values is generated, and the process is repeated.

Step 1:

The four points are represented by their x, y, and z coordinates in the remote body coordinate frame, as columns in the matrix:

$$P = \begin{bmatrix} p_{11} & p_{12} & p_{13} & p_{14} \\ p_{21} & p_{22} & p_{23} & p_{24} \\ p_{31} & p_{32} & p_{33} & p_{34} \end{bmatrix}$$

Where, for each $p_{ij}$, i represents the axis (1=x, 2=y, 3=z), and j represents which of the four points is being described. The matrix is set up by actually measuring the position of each point with the two coordinate frames aligned, and representing that measurement using (x,y,z) notation.

Each of the four columns are called "column vectors," since they can be seen to represent a vector from the zero point of the remote body coordinate frame to the identified point.

The matrix P defines the following four vectors:

Step 2:

Calculate the length between points 1 & 2, points 2 & 3, points 3 & 4, and points 1 & 4, from the sensor matrix.

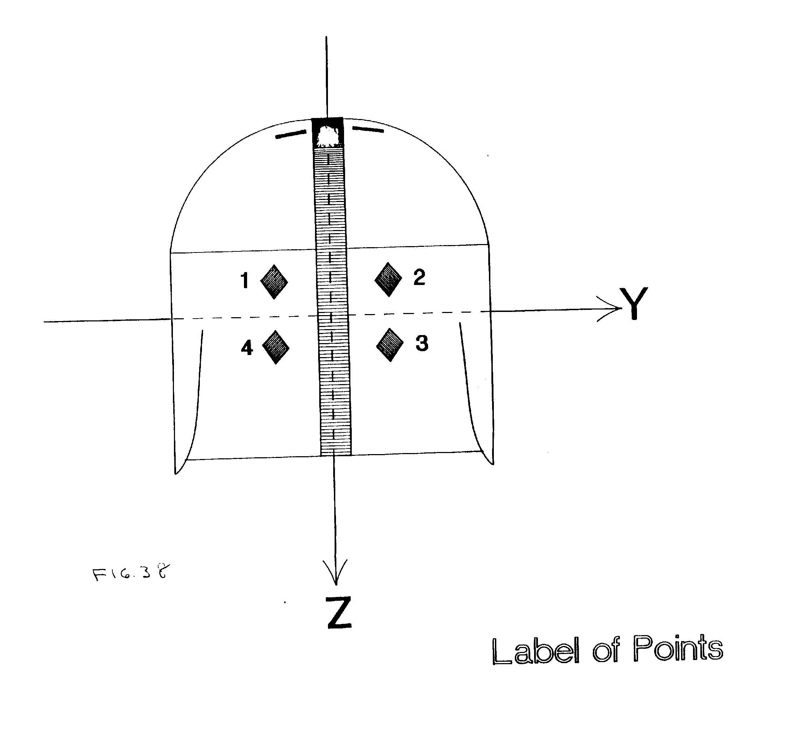

As shown in Fig. 38, the four points are arranged to form a square. As used in this document, point one is the point to the upper left, point 2 is the point to the upper right, point 3 is the point to the lower right, and point 4 is the point to the lower left.

As will be explained, the x coordinates are not represented on the sensor. The length between each of these two points, then, will be found by taking the square root of the square of the difference of the y coordinates plus the square of the difference of the z coordinates. For example,

Length between points 1 & 2 = $\sqrt{(y1 - y2)^2 + (z1 - z2)^2}$ where y1 is the y coordinate of point 1, y2 is the y coordinate of point 2, z1 is the z coordinate of point 1, and z2 is the z coordinate of point 2, all as they are represented on the sensor (which means, as explained in Step 7, they have been translated from their actual coordinates in space into coordinates on the sensor).

We will assign the following variables to represent these lengths:

s1 = length between points 1 & 2 in the sensor matrix.
s2 = length between points 2 & 3 in the sensor matrix.
s3 = length between points 3 & 4 in the sensor matrix.
s4 = length between points 1 & 4 in the sensor matrix.

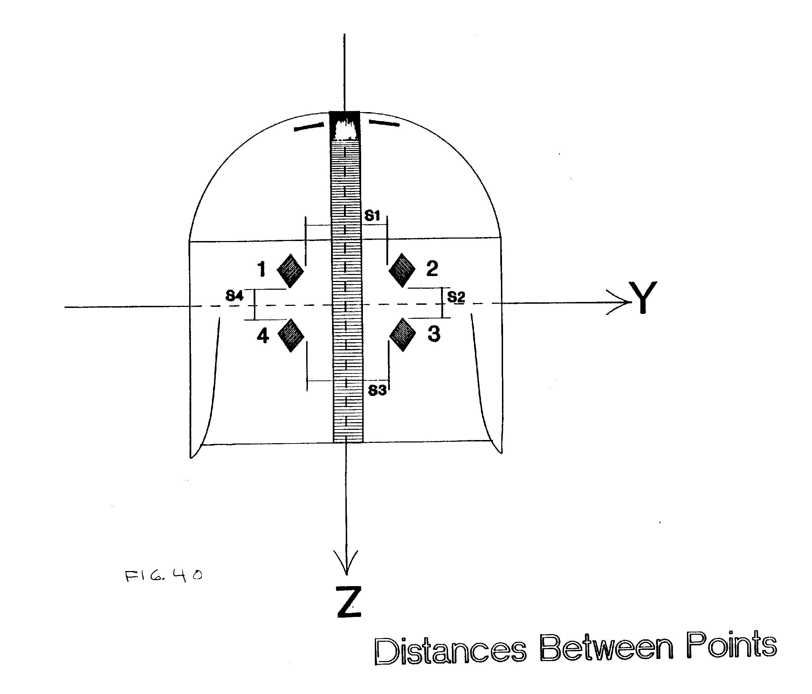

These lengths are also illustrated in Fig. 40.

Step 3:

Calculate values for the sensor matrix which will later be used to determine if the guess values for the six degrees of freedom are close enough to the actual values to stop guessing.

**Heading**

Fig. 28 shows an example of a positive heading (i.e. turning the head to the right is positive). With knowledge of the fact that as lines move closer to the sensor along the x axis to of the reference frame, they will appear longer (and will thus be measured as being longer in Step 2), the heading comparisons can be made with the following value:

s2 - s4

**Elevation:**

Fig. 29 shows an example of a positive elevation (i.e. tilting the head backwards is negative). Thus elevation comparisons can be made with the following value:

s3 - s1

**Roll:**

Fig. 30 shows an example of a positive roll (i.e. tilting the head to the right is positive). Thus, one way to calculate the value to be used for comparison, and the way that will be used here, is by using the z positions of the four points:

(z position of point 4 - z position of point 3) + (z position of point 1 - z position of point 2)

**y & z:**

The value for comparison of y for the remote body frame (as represented by the sensor matrix) is the average of the y coordinates of the four points. Similarly, the value for comparison of z is the average of the z coordinates of the four points.

This scheme is used since the position of the origin of the remote body frame is never found by the algorithm. This is the reason the four points can be coplanar. In order to determine the origin, three vectors would need to be formed which span R3, and this can only be done if the four points are non-coplanar. Thus, the values for y and z that will be used for comparison and guess modification are the averages of the corresponding coordinates of the four points.

**x:**

The value which will be used for comparison of x is the sum of the four lengths calculated in Step 2. This value will grow as the object moves closer on the x axis of the reference frame.

These calculated values will be used in later steps to determine if the guess matrix is close enough to the sensor matrix to stop, as well as to calculate a "next guess" if the guess matrix is not yet close enough to the sensor matrix.

Step 4:

Make an initial "guess" for the values of the six variables at the actual position of the remote body frame.

A convenient initial guess is zero for all degrees of freedom, meaning that the remote body frame is perfectly aligned with the reference frame. Of course, given that the origin of the reference frame lies in the sensor, it is impossible for this first guess to be correct. Here, however, 18 inches is used as the initial guess for R (the initial guess for the other five degrees of freedom is zero). This is because the lens used here is fixed focused at approximately 18 inches.

Step 5:

Multiply the matrix P by a "rotation matrix".

As discussed above, the algorithm begins with the supposition that the remote body frame and the reference frame are aligned. The matrix P, then, represents the coordinates of the four points in either of the two coordinate frames. Step 5 takes the first step toward determining what the sensor readings for the guessed position would be, by orienting the matrix P by the guessed angles.

The rotation of the helmet in three dimensions is known to be defined by the following 3 x 3 matrix:

$$A = \begin{bmatrix} 1 & 0 & 0 \\ 0 & \cos\phi & \sin\phi \\ 0 & -\sin\phi & \cos\phi \end{bmatrix} \begin{bmatrix} \cos\theta & 0 & -\sin\theta \\ 0 & 1 & 0 \\ \sin\theta & 0 & \cos\theta \end{bmatrix}$$

$$\begin{bmatrix} \cos\psi & \sin\psi & 0 \\ -\sin\psi & \cos\psi & 0 \\ 0 & 0 & 1 \end{bmatrix},$$

$$= \begin{bmatrix} a_{11} & a_{12} & a_{13} \\ a_{21} & a_{22} & a_{23} \\ a_{31} & a_{32} & a_{33} \end{bmatrix}$$

where:

$a_{11} = \cos\psi \cos\Theta$

$a_{12} = \sin\psi \cos\Theta$

$a_{13} = -\sin\Theta$

$a_{21} = \cos\psi \sin\Theta \sin\phi - \sin\psi \cos\phi$

$a_{22} = \sin\psi \sin\Theta \sin\phi + \cos\psi \cos\phi$

$a_{23} = \cos\Theta \sin\phi$

$a_{31} = \cos\psi \sin\Theta \cos\phi + \sin\psi \sin\phi$

$a_{32} = \sin\psi \sin\Theta \cos\phi - \cos\psi \sin\phi$

$a_{33} = \cos\Theta \cos\phi$

The multiplication of two 3x3 matrices forms a 3x3 matrix, calculated as follows:

$$\begin{bmatrix} a & b & c \\ d & e & f \\ g & h & i \end{bmatrix} \times \begin{bmatrix} j & k & l \\ m & n & o \\ p & q & r \end{bmatrix} =$$

$$\begin{bmatrix} aj + bm + cp & ak + bn + cq & al + bo + cr \\ dj + em + fp & dk + en + fq & dl + eo + fr \\ gj + hm + ip & gk + hn + iq & gl + ho + ir \end{bmatrix}$$

Matrix multiplication is associative, and the 3x3 matrix A represents the multiplication of the three matrices.

This matrix is used as a transfer function to rotate a point, or in this case, a set of points, in three dimensions around the origin (0, 0, 0) by each of those angles. The multiplication of the 3 x 3 orientation matrix with the 3 x 4 matrix of the points at their àpriori orientation (matrix P) is performed as follows:

$$\begin{bmatrix} a & b & c \\ d & e & f \\ g & h & i \end{bmatrix} \times \begin{bmatrix} j & k & l & m \\ n & o & p & q \\ r & s & t & u \end{bmatrix} =$$

$$\begin{bmatrix} aj + bn + cr & ak + bo + cs & al + bp + ct & am + bq + cu \\ dj + en + fr & dk + eo + fs & dl + ep + ft & dm + eq + fu \\ gj + hn + ir & gk + ho + is & gl + hp + it & gm + hq + iu \end{bmatrix}$$

This multiplication will orient the points by angles $\phi$, $\Theta$ and $\psi$ guessed in Step 4. The result of this multiplication is stored in the guess matrix. The effect of this procedure on the guessed remote body frame is illustrated in Fig. 31.

Step 6:

Translate the points by the guessed position of the remote body frame.

In Step 5, the position of the points due to the guessed change in orientation of the remote body frame was calculated. In Step 6, the remote body frame is effectively moved to its guessed new position on the x, y and z axes of the reference frame.

The x row of the guess matrix does not need to be modified. It is modified here as a convenient place to hold the guessed x coordinates of the four points. This is because the goal of the procedure is to construct a matrix representing what the sensor readings would be if the remote body were at the guessed position and orientation, in order to compare it to the actual sensor readings. The sensor is not capable of directly reading the position of the remote body in the x direction.

The sensor sits in the plane of the y - z axes, with the x axis normal to the center point of the face of the sensor, as shown:

As a result, the change in position of the zero point of the remote body frame in the x direction cannot be directly measured by the sensor. The change in position of the zero point of the remote body frame represents the change in position of the four observable points. This is distinguished from the change in orientation of the points, which is rotation about the zero point of the remote body frame.

To translate the helmet in the x, y and z directions, the guessed values for x, y and z are added to the x, y and z coordinates of each point in the guess matrix. For example, if the guess matrix was:

$$\begin{bmatrix} 1 & 2 & 3 & 4 \\ 5 & 6 & 7 & 8 \\ 9 & 10 & 11 & 12 \end{bmatrix}$$

and the guessed values for x, y and z were x = 2, y = 3, z = 5, the translated guess matrix would be:

$$\begin{bmatrix} 3 & 4 & 5 & 6 \\ 8 & 9 & 10 & 11 \\ 14 & 15 & 16 & 17 \end{bmatrix}$$

The effect of this procedure on the guessed remote body frame is illustrated in Fig. 36a.

Step 7:

Determine the readings the four points would have on the sensor at the guessed position and orientation of the remote body frame.

Fig. 39 illustrates a point on the remote body frame in its guessed position (point E) and the corresponding point as it appears on the sensor (point F). The following are the variables needed to calculated what the sensor readings for point E (i.e. the coordinates of point F) would be:

D: The distance from the focal point of the sensor lens to the x position of point E.

k: The distance from the sensor to the focal point of the sensor lens.

m′: The length of the vector from the origin of the remote body frame to point E.

z: The z coordinate of point E on the remote body frame.

y: The y coordinate of point E on the remote body frame.

φ: The angle from the positive x axis to m′.

q: The length of the vector from the origin of the reference frame to point F (the representation of point E on the sensor).

y′: The y coordinate of point F on the reference frame.

z′: The z coordinate of point F on the reference frame.

Distance D is the x position of point E, and is found from the x position of point E in the guess matrix.

y′ and z′ represent the y and z sensed coordinates of point E, and can be calculated with the following trigonometric equations:

$$m' = \sqrt{z^2 + y^2}$$

$$\phi = \text{atan}(\frac{z}{y})$$

$$q = \frac{k}{D}(m')$$

$$y' = q * \cos\phi$$

$$z' = q * \sin\phi$$

y and z, of course, are known from the guess matrix as modified in Step 6. k is the known distance from the sensor face to the focal point of the sensor lens. Using these knowns, the given steps derive values for y′ and z′, which are the sensed readings for the point E.

This procedure should be followed for each of the four points in the guess matrix, and for each point the values for y′ and z′ are substituted for the existing values of their y and z coordinates. The guess matrix now contains the values for the y and z coordinates of each of the points as they would be read by the sensor if the remote body frame were actually at its guessed position.

Step 8:

Calculate the length between points 1 & 2, points 2 & 3, points 3 & 4, and points 1 & 4, from the guess matrix.

The procedure from accomplishing this step is described in Step 2 (with the exception that the guess matrix will be used instead of the sensor matrix).

Step 9:

Calculate the values for the guess matrix which will be used to compare to the values calculated in Step 3 for the sensor matrix.

The procedure for accomplishing this step is described in Step 3 (with the exception that the guess matrix will be used instead of the sensor matrix, and that the lengths used will be those calculated in Step 8).

Step 10:

Compare the values calculated in Step 9 to those calculated in Step 3 to determine if further iterations through the loop are required.

Naturally, criterion for determining if the guessed values are close enough to the actual values can vary depending on the performance and accuracy requirements of the system being designed. Here, only the heading, elevation and roll values are used to determine whether to fall out of the loop.

Assigning the following variables:

sh = heading comparison value for the sensor matrix calculated in Step 3.
se = elevation comparison value for the sensor matrix calculated in Step 3.
sr = roll comparison value for the sensor matrix calculated in Step 3.
sx = x position comparison value of the sensor matrix calculated in Step 3.
sy = y position comparison value of the sensor matrix calculated in Step 3.
sz = z position comparison value of the sensor matrix calculated in Step 3.
gh = heading comparison value for the guess matrix calculated in Step 9.
ge = elevation comparison value for the guess matrix calculated in Step 9.
gr = roll comparison value for the guess matrix calculated in Step 9.
gx = x position comparison value of the guess matrix calculated in Step 9.
gy = y position comparison value of the guess matrix calculated in Step 9.
gz = z position comparison value of the guess matrix calculated in Step 9.

The following differences are calculated:

dh = (sh - gh)
de = (se - ge)
dr = (sr - gr)
dx = (sx - dx)

dy = (sy - gy)
dz = (sz - gz)

Each of these values is then multiplied by a factor, found by trial and error, to allow convergence on the answer faster, as well as to avoid oscillation around the answer. In a system which has been implemented, dh is multiplied by 3.15, de is multiplied by 3.15, dr is multiplied by 1/4.1, and dx, dy and dz are all multiplied by 10. These six values become the new guess.

Only dh, de and dr are used by this embodiment to determine if the answer is close enough to stop. If the absolute values of all three are less then .000005, the guess is deemed to be the answer. Otherwise, the algorithm returns to Step 5 and proceeds from there using this new guess.

It will be understood that various modifications may be made in the present invention without departing from the spirit and scope of the invention as hereafter claimed. It will also be understood that while the present invention has been described in the context of a head tracker, the present invention's systems and methods of measuring the relative position and orientation of remote bodies has numerous other applications relating to robotics, virtual reality, and other fields.

## Claims

1) A system for measuring the relative position and orientation of a remote body, comprising a plurality of high intensity infra red LED configuration means mounted on the remote body at known positional points; means to differentiate the signal of each LED configuration means from the signals of the other LED configuration means; multi-element lens means having a wide field of view, short focal length and wide aperture; linear two dimensional position sensing diode means for providing current signals representative of the position of a light spot from the LED configuration means focused by the lens means on the position sensing diode; low noise transimpedance amplifier means for amplifying current signals from the position sensing diode means and converting the current signals to analog voltage signals; analog to digital converter means for converting the said analog voltage signals to digital signals; a digital signal processor for calculating in a recursive manner the relative position and orientation of the remote body.

2) The invention of claim 1, wherein the remote body is a pilot's helmet.

3) The invention of claim 1, wherein the plurality of LED configuration means comprise at least four LED(s).

4) The invention of claim 3, wherein the four LED(s) are not all mounted in the same plane.

5) The invention of claim 1, wherein the multi-element lens means comprises at least nine optical elements.

6) The invention of claim 5, wherein the lens means has a field of view of at least substantially sixty-five degrees.

7) The invention of claim 6, wherein the lens means has a focal length of substantially .6760 and an aperture of substantially 1.4.

8) The invention of claim 1, wherein the two dimensional position sensing diode means comprises a highly linear, high resolution duo lateral device.

9) The invention of claim 8, the duo lateral device having an infra red coating and a filter on the cover glass.

10) The invention of claim 1, wherein there is a single two dimensional position sensing diode means having a single photoelectric sheet.

11) The invention of claim 1, wherein the means for differentiating comprises means for pulsing the plurality of LED configuration means individually and in known sequence.

12) The invention of claim 11, wherein the means for pulsing includes LED diode driver means.

13) The invention of claim 1, wherein a measurement accuracy of substantially three arc minutes or less is provided.

14) The invention of claim 1, wherein a measurement accuracy of substantially thirty arc seconds or less is provided.

15) The invention of claim 1, wherein a measurement accuracy of substantially three arc seconds or less is provided.

16) The invention of claim 1, having update rates of at least several hundred Hz.

17) The invention of claim 1, wherein each said LED configuration means includes an emitter chip mounted on a substrate, said substrate being darkened to avoid reflection.

18) The invention of claim 17, wherein each said LED configuration means includes an emitter chip having a plurality of heating pads attached thereto.

19) The invention of claim 18 including nine said heating pads.

20) The invention of claim 2, including an aircraft weapons system to which the position and orientation of the remote body are provided.

**21)** The invention of claim 2, including a helmet mounted display to which the position and orientation of the remote body are provided.

**22)** The invention of claim 3, wherein at least four LED(s) are positioned so as to be detected by the position sensing diode under any position or orientation of the remote body.

**23)** The invention of claim 1, wherein the digital signal processor is programed for calculating the relative position and orientation in six degrees of freedom.

**24)** The invention of claim 1, wherein the amplifiers means maintain the position sensing diode means reverse biased.

**25)** The invention of claim 1, wherein the transimpedance amplifier means have preamplifier stages including operational amplifiers providing low input voltage noise.

**26)** The invention of claim 1, wherein the transimpedance amplifier means have preamplifier stages including operational amplifiers providing low input voltage noise, the transimpedance amplifier means maintain the position sensing diode means reverse biased, and said biasing is provided by a resistive divider network connected to the non-inverting terminals of the operational amplifiers.

**27)** The invention of claim 1, wherein the analog to digital converter means utilizes sixteen bits of resolution.

**28)** The invention of claim 12, wherein the diode driver means include an NMOS device having its gate driven by an operational amplifier.

**29)** A method for determining the position and orientation of a remote body, which comprises:

a) Sensing the position of a 4 non-coplanar points, affixed to the remote body, at the actual position and orientation of the remote body,

b) Calculating a plurality of values from the coordinates of these 4 sensed points,

c) Generating a guess for the six degrees of freedom of the remote body,

d) Determining the readings of the 4 points would have on the sensor at the guessed position and orientation of the remote body,

e) Calculating a plurality of values, corresponding to the values calculated in (b), for the coordinates the 4 points would have on the sensor at the guessed position and orientation of the remote body, and

f) Comparing corresponding values from steps (b) and (e).

**30)** The invention of claim 29, wherein the remote body comprises a helmet having a plurality of LED configuration means, each defining one of the non-coplanar points, and 4 non-coplanar points being visible at any position and orientation of the helmet.

**31)** A system for measuring the relative position and orientation of a remote body, comprising at least four non-coplanar LED configuration means providing light signals at the remote body at known positional points; means to differentiate the signals of each LED configuration means from the signals of the other LED configuration means; multi-element lens means; a two dimensional position sensing diode means for providing current signals representative of the position of a light spot from the LED configuration means focused by the lens means on the position sensing diode; transimpedance amplifier means for amplifying current signals from the position sensing diode means and converting the current signals to analog voltage signals; means for converting the said analog voltage signals to digital signals; a digital signal processor means programmed for calculating the relative position and orientation of the remote body, by a) taking the sensed position of four non-coplanar LED configuration means at the actual position and orientation of the remote body, b) calculating a plurality of values from the coordinates of these four sensed points, c) generating a guess for the six degrees of freedom of the remote body,

d) determining the readings the four points would have on the sensor at the guessed position and orientation of the remote body, e) calculating a plurality of values, corresponding to the values calculated in (b), for the coordinates the four points would have on the sensor at the guessed position and orientation of the remote body, and f) comparing corresponding values from steps (b) and (e).

**32)** The invention of claim 31, including the digital signal processor means being programmed for calculating the relative position and orientation recursively to narrow the difference between the corresponding values from steps (b) and (e).

FIG. 1

FIG. 2

LED(s) 20

↑ LIGHT FROM DIODE 21

PSD(s) 22

TRANSIMPEDANCE AMPLIFIERS 23

FILTER AND ANALOG TO DIGITAL CONVERTER 24

LED DIODE DRIVERS 27

CONTROL COMPUTER 1553B, FDDI, ETHERNET, ETC. MEMORY, MASS STORAGE 26

DIGITAL SIGNAL PROCESSOR 25

FIG. 3

25

DSP

A/D
AMPLIFIERS
23,24

CANOPY
CROSSMEMBERS

DIODE DRIVER

21

22

IR DIODES
20

POSITION SENSING DIODE
OR DIODES

HELMET

COCKPIT

FIG.4

FIG. 5

FIG. 6

FIG. 7

| DESCRIPTION | DIMENSIONS (INCHES) | |
| --- | --- | --- |
| | SIDE 1 | SIDE 2 |
| RADIUS OF CURVATURE | R1          CX 19.9081 | R2          CV 1.2062 |
| RADIUS TOLERANCE | T.P. | T.P. |
| FRINGE TOLERANCE | 3.0 | 3.0 |
| IRREG. TOLERANCE | 0.5 | 0.5 |
| FINISH | MgF$_2$ | MgF$_2$ |
| COATING | 40/20 | 40/20 |
| CLEAR AP. DIAMETER | 1.500 | 1.320 |
| SAGITTA | | S2 0.240±.002 |
| DIAMETER TO FACE | | Y2 1.4441 |
| DIAMETER TO BEVEL | | |
| FACE WIDTH TO BEVEL | | |
| BEVEL WIDTH | C1 0.0050 | C2 0.0050 |
| FACE ANGLE | | |
| THICKNESS | THK 0.0800 | |
| THK. TOL. | ±0.0050 | |
| WEDGE TOL. | 2 arc min | |
| FLAT TIR | 0.002 | |
| DIAMETER | DIA 1.7400 | |
| DIA. TOL. | +0.0000 −0.0005 | |
| MATERIAL | SF 14 | |
| GRADE | B | |
| ANNEAL | FA | |
| MELT | . | |
| PAINT | | |

FIG. 7a

| DESCRIPTION | DIMENSIONS (INCHES) | |
|---|---|---|
| | SIDE 1 | SIDE 2 |
| RADIUS OF CURVATURE | R1 CX 7.4924 | R2 CX 2.4797 |
| RADIUS TOLERANCE | T.P. | T.P. |
| FRINGE TOLERANCE | 3.0 | 3.0 |
| IRREG. TOLERANCE | 0.5 | 0.5 |
| FINISH | 40/20 | 40/20 |
| COATING | MgF2 | MgF2 |
| CLEAR AP. DIAMETER | 1.1200 | 1.1200 |
| SAGITTA | | |
| DIAMETER TO FACE | | |
| DIAMETER TO BEVEL | | |
| FACE WIDTH TO BEVEL | | |
| BEVEL WIDTH | C1 0.0050 | C2 0.0050 |
| FACE ANGLE | | |
| THICKNESS | THK 0.1600 | |
| THK. TOL. | ± 0.0030 | |
| WEDGE TOL. | 2 arc min | |
| FLAT TIR | | |
| DIAMETER | DIA 1.2000 | |
| DIA. TOL. | +0.0000 −0.0005 | |
| MATERIAL | LAK N13 | |
| GRADE | B | |
| ANNEAL | FA | |
| MELT | | |
| PAINT | | |

FIG.7b

| DESCRIPTION | DIMENSIONS (INCHES) | |
|---|---|---|
| | SIDE 1 | SIDE 2 |
| RADIUS OF CURVATURE | R1    CX<br>0.9301 | R2    CV<br>2.1200 |
| RADIUS TOLERANCE | T.P. | T.P. |
| FRINGE TOLERANCE | 3.0 | 3.0 |
| IRREG. TOLERANCE | 0.5 | 0.5 |
| FINISH | 40/20 | 40/20 |
| COATING | $MgF_2$ | $MgF_2$ |
| CLEAR AP. DIAMETER | 0.9500 | 0.8100 |
| SAGITTA | | S2<br>$0.140\pm.002$ |
| DIAMETER TO FACE | | Y2<br>2.1611 |
| DIAMETER TO BEVEL | | |
| FACE WIDTH TO BEVEL | | |
| BEVEL WIDTH | C1<br>0.0050 | C2<br>0.0050 |
| FACE ANGLE | | |
| THICKNESS | THK<br>0.2100 | |
| THK. TOL. | $\pm0.0030$ | |
| WEDGE TOL. | 2 arc min | |
| FLAT TIR | | |
| DIAMETER | DIA<br>1.2000 | |
| DIA. TOL. | +0.0000<br>−0.0005 | |
| MATERIAL | LAK N13 | |
| GRADE | B | |
| ANNEAL | FA | |
| MELT | | |
| PAINT | | |

FIG. 7c

| DESCRIPTION | DIMENSIONS (INCHES) | |
|---|---|---|
| | SIDE 1 | SIDE 2 |
| RADIUS OF CURVATURE | | |
| RADIUS TOLERANCE | | |
| FRINGE TOLERANCE | | |
| IRREG. TOLERANCE | | |
| FINISH | | |
| COATING | | |
| CLEAR AP. DIAMETER | | |
| SAGITTA | | S2 0.0900 |
| DIAMETER TO FACE | | |
| DIAMETER TO BEVEL | | |
| FACE WIDTH TO BEVEL | | |
| BEVEL WIDTH | | |
| FACE ANGLE | | |
| CENTER THICKNESS | CT 0.295±0.002 | |
| THK. TOL. | ±0.0020 | |
| WEDGE TOL. | 2 arc min | |
| FLAT TIR | | |
| DIAMETER | 0.7900 | |
| DIA. TOL. | +0.0000 -0.0005 | |
| MATERIAL | | |
| GRADE | | |
| ANNEAL | | |
| MELT | | |
| PAINT | | |

ELEMENT NO. 4        ELEMENT NO. 5

(EL 4)                  (EL 5)

DIA

CT

S2 REF

FIG. 7d

43

| DESCRIPTION | DIMENSIONS (INCHES) | |
| --- | --- | --- |
| | SIDE 1 | SIDE 2 |
| RADIUS OF CURVATURE | R1    CX<br>0.6501 | R2<br>PLAND |
| RADIUS TOLERANCE | T. P. | T. P. |
| FRINGE TOLERANCE | 3.0 | 3.0 |
| IRREG. TOLERANCE | 0.5 | 0.5 |
| FINISH | | |
| COATING | MgF₂ | N/A |
| CLEAR AP. DIAMETER | 0.7100 | 0.5600 |
| SAGITTA | | |
| DIAMETER TO FACE | | |
| DIAMETER TO BEVEL | | |
| FACE WIDTH TO BEVEL | | |
| BEVEL WIDTH | C1<br>0.0050 | C2<br>0.0050 |
| FACE ANGLE | | |
| THICKNESS | THK<br>0.2150 | |
| THK. TOL. | SEE ASSY OF EL 4 & EL 5 | |
| WEDGE TOL. | 2' | |
| FLAT TIR | | |
| DIAMETER | 0.7900 | |
| DIA. TOL. | + 0.0000<br>− 0.0005 | |
| MATERIAL | LAK N13 | |
| GRADE | | |
| ANNEAL | | |
| MELT | | |
| PAINT | | |

$$FIG. 7e$$

44

| DESCRIPTION | DIMENSIONS (INCHES) | |
| --- | --- | --- |
| | SIDE 1 | SIDE 2 |
| RADIUS OF CURVATURE | R1   PLANO | R2   CV   0.3860 |
| RADIUS TOLERANCE | T.P. | T.P. |
| FRINGE TOLERANCE | 3.0 | 3.0 |
| IRREG. TOLERANCE | 0.5 | 0.5 |
| FINISH | N/A | MgF2 |
| COATING | | |
| CLEAR AP. DIAMETER | 0.5600 | 0.4650 |
| SAGITTA | | S2   0.090±.001 |
| DIAMETER TO FACE | | Y2   0.4955 |
| DIAMETER TO BEVEL | | |
| FACE WIDTH TO BEVEL | | |
| BEVEL WIDTH | C1   0.0050 | C2   0.0050 |
| FACE ANGLE | | |
| THICKNESS | THK   0.0800 | |
| THK. TOL. | SEE ASSY OF EL4 & EL5 | |
| WEDGE TOL. | 2' | |
| FLAT TIR | | |
| DIAMETER | 0,7900 | |
| DIA. TOL. | +0.0000 −0.0005 | |
| MATERIAL | F1 | |
| GRADE | | |
| ANNEAL | | |
| MELT | | |
| PAINT | | |

FIG. 7f

| DESCRIPTION | DIMENSIONS (INCHES) | |
|---|---|---|
| | SIDE 1 | SIDE 2 |
| RADIUS OF CURVATURE | | |
| RADIUS TOLERANCE | | |
| FRINGE TOLERANCE | | |
| IRREG. TOLERANCE | | |
| FINISH | | |
| COATING | | |
| CLEAR AP. DIAMETER | | |
| SAGITTA | S1 0.070 | |
| DIAMETER TO FACE | | |
| DIAMETER TO BEVEL | | |
| FACE WIDTH TO BEVEL | | |
| BEVEL WIDTH | | |
| FACE ANGLE | | |
| CENTER THICKNESS | CT 0.230 | |
| THK. TOL. | ±0.002 | |
| WEDGE TOL. | 2 arc min | |
| FLAT TIR | | |
| DIAMETER | 0.6400 | |
| DIA. TOL. | +0.0000 −0.0005 | |
| MATERIAL | | |
| GRADE | | |
| ANNEAL | | |
| MELT | | |
| PAINT | | |

ELEMENT NO°6
(EL 6)

ELEMENT N° 7
(EL 7)

DIA

CT

S1 REF

FIG. 7g

46

| DESCRIPTION | DIMENSIONS (INCHES) | |
|---|---|---|
| | SIDE 1 | SIDE 2 |
| RADIUS OF CURVATURE | R1     CV<br>0.4757 | R2     CV<br>3.7773 |
| RADIUS TOLERANCE | T.P. | T.P. |
| FRINGE TOLERANCE | 3.0 | 3.0 |
| IRREG. TOLERANCE | 0.5 | 0.5 |
| FINISH | 40/20 | 40/20 |
| COATING | $MgF_2$ | N/A |
| CLEAR AP. DIAMETER | 0.4650 | 0.4700 |
| SAGITTA | S1<br>0.140±.001 | S2<br>0.0134 |
| DIAMETER TO FACE | Y1<br>0.4968 | |
| DIAMETER TO BEVEL | | Y2<br>0.6345 |
| FACE WIDTH TO BEVEL | | |
| BEVEL WIDTH | C1<br>0.0050 | C2<br>0.0050 |
| FACE ANGLE | | |
| THICKNESS | THK<br>0.0800 | |
| THK. TOL. | SEE ASSY OF<br>EL6 & EL7 | |
| WEDGE TOL. | 2' | |
| FLAT TIR | | |
| DIAMETER | 0.6400 | |
| DIA. TOL. | +0.0000<br>-0.0005 | |
| MATERIAL | F 1 | |
| GRADE | B | |
| ANNEAL | FA | |
| MELT | | |
| PAINT | | |

FIG. 7h

| DESCRIPTION | DIMENSIONS (INCHES) | |
|---|---|---|
| | SIDE 1 | SIDE 2 |
| RADIUS OF CURVATURE | R1     CX<br>3.7773 | R2     CX<br>0.8079 |
| RADIUS TOLERANCE | T.P. | T.P. |
| FRINGE TOLERANCE | 3.0 | 3.0 |
| IRREG. TOLERANCE | 0.5 | 0.5 |
| FINISH | 40/20 | 40/20 |
| COATING | N/A | $MgF_2$ |
| CLEAR AP. DIAMETER | 0.470 | 0.560 |
| SAGITTA | | |
| DIAMETER TO FACE | | |
| DIAMETER TO BEVEL | | |
| FACE WIDTH TO BEVEL | | |
| BEVEL WIDTH | C1    0.0050 | C2    0.0050 |
| FACE ANGLE | | |
| THICKNESS | THK   0.1500 | |
| THK. TOL. | SEE ASSY OF EL6 & EL7 | |
| WEDGE TOL. | 2' | |
| FLAT TIR | | |
| DIAMETER | 0.6400 | |
| DIA. TOL. | +0.0000<br>-0.0005 | |
| MATERIAL | LAK N13 | |
| GRADE | B | |
| ANNEAL | FA | |
| MELT | | |
| PAINT | | |

## FIG. 7i

| DESCRIPTION | DIMENSIONS (INCHES) | |
| --- | --- | --- |
| | SIDE 1 | SIDE 2 |
| RADIUS OF CURVATURE | R1   CX 2.4797 | R2   CX 1.6707 |
| RADIUS TOLERANCE | T. P. | T. P. |
| FRINGE TOLERANCE | 3.0 | 3.0 |
| IRREG. TOLERANCE | 0.5 | 0.5 |
| FINISH | 40/20 | 40/20 |
| COATING | MgF$_2$ | MgF$_2$ |
| CLEAR AP. DIAMETER | 0.650 | 0.680 |
| SAGITTA | | |
| DIAMETER TO FACE | | |
| DIAMETER TO BEVEL | | |
| FACE WIDTH TO BEVEL | | |
| BEVEL WIDTH | C1  0.0050 | C2  0.0050 |
| FACE ANGLE | | |
| THICKNESS | THK  0.1400 | |
| THK. TOL. | ±0.0030 | |
| WEDGE TOL. | 2' | |
| FLAT TIR | | |
| DIAMETER | 0.8000 | |
| DIA. TOL. | +0.0000 −0.0005 | |
| MATERIAL | LAK N13 | |
| GRADE | B | |
| ANNEAL | FA | |
| MELT | | |
| PAINT | | |

FIG. 7j

| DESCRIPTION | DIMENSIONS (INCHES) | |
|---|---|---|
| | SIDE 1 | SIDE 2 |
| RADIUS OF CURVATURE | R1       CX 1.6420 | R2       CX 4.1475 |
| RADIUS TOLERANCE | T.P. | T.P. |
| FRINGE TOLERANCE | 3.0 | 3.0 |
| IRREG. TOLERANCE | 0.5 | 0.5 |
| FINISH | 40/20 | 40/20 |
| COATING | MgF$_2$ | MgF$_2$ |
| CLEAR AP. DIAMETER | 0.730 | 0.730 |
| SAGITTA | | |
| DIAMETER TO FACE | | |
| DIAMETER TO BEVEL | | |
| FACE WIDTH TO BEVEL | | |
| BEVEL WIDTH | C1 0.0050 | C2 0.0050 |
| FACE ANGLE | | |
| THICKNESS | THK 0.1200 | |
| THK. TOL. | ±0.0030 | |
| WEDGE TOL. | 2' | |
| FLAT TIR | | |
| DIAMETER | 0.8000 | |
| DIA. TOL. | +0.0000 -0.0005 | |
| MATERIAL | LAK N13 | |
| GRADE | B | |
| ANNEAL | FA | |
| MELT | | |
| PAINT | | |

C1    C2

DIA

R1    R2

EL9    THK

## FIG_7k

50

Fig. 7c

0.040 WIDE
× .040 DEEP
SLOT

1.620
±.003

60°

1.720

0.005±0.003 × 45°

0.160

P1

1.880-40UNS-2A THREAD
TO MATE WITH CELL
AFTER ANODIZE FINISH

MATL: 6061-T6/T651 ALUMINUM
FINISH: BLACK ANODIZE

EP 0 480 825 A2

-A-

| // | .0010 | A |

0.160

.750
±.003

0.005±0.003 × 45°

← 42

42 →

0.040 WIDE x
0.040 DEEP SLOT

0.880-40UNS-2A THREAD
MATES WITH CELL AFTER
ANODIZE FINISH

(P1) MATL: 6061-T6/T651 ALUMINUM
FINISH: BLACK ANODIZE

Fig 7 mv

| // | .0005 | A |
|----|-------|---|

-A-

0.782 ±0.003

1.140 DIA

20°

1.400 DIA

0.005 × 45° DESIGN NOM,
MACHINE AT OPTICAL ASSY
FOR TOLERANCE ADJUSTMENT
OF CENTER SPACING

1.734 DIA

0.02 × 45°

SPC1-2

(P1) MATL: 6061-T6/T651 ALUMINUM
FINISH: BLACK ANODIZE AFTER
OPTICAL ASSY ADJUSTMENTS

Fig 7n

53

EP 0 480 825 A2

1.124
DIA

1.194
DIA

-A-

// | .0005 | A

0.2635±0.0010

.005 × 45° DESIGN NOM,
MACHINE AT OPTICAL ASSY
FOR TOLERANCE ADJUSTMENT
OF CENTER SPACING

P1 MATL: 6061-T6/T651 ALUMINUM
FINISH: BLACK ANODIZE AFTER
OPTICAL ASSY ADJUSTMENTS

SPC 2-3

Fig. 7σ

EP 0 480 825 A2

.7566
±.0005

| -A- | // | .0005 | A |

.060±.001

.02 × 45°

.840

.005 × 45° DESIGN NOM,
MACHINE AT OPTICAL ASSY
FOR TOLERANCE ADJUSTMENT
OF CENTER SPACING

1.194

.090

SPC 3-4

(P1) MATL: 6061-T6/T651 ALUMINUM
FINISH: BLACK ANODIZE AFTER
OPTICAL ASSY ADJUSTMENTS

Fig 7 P

55

| -A- | // | .0005 | A |
|-----|-----|-------|---|

.060±.002

.480

.634±.002

SPC 5-6

(P1) MATL: 6061-T6/T651 ALUMINUM
FINISH: BLACK ANODIZE

Fig 79

EP 0 480 825 A2

| -A- | // | .0005 | A |

.092±.002

.005 x 45° DESIGN NOM,
MACHINE AT OPTICAL ASSY
FOR TOLERANCE ADJUSTMENT
OF CENTER SPACING

.7196
±.002

90°

.595
±.002

.794
±.002

SEC 7-8

P1 MATL: 6061-T6/T651 ALUMINUM
FINISH: BLACK ANODIZE AFTER
OPTICAL ASSY ADJUSTMENTS

Fig 7a

EP 0 480 825 A2

0.730
DIA

0.794
DIA

| −A− | | // | .0005 | A |

0.0887±0.0010

.005 × 45° DESIGN NOM.
MACHINE AT OPTICAL ASSY
FOR TOLERANCE ADJUSTMENT
OF CENTER SPACING

(P1) MATL: 6061-T6/T651 ALUMINUM
FINISH: BLACK ANODIZE AFTER
OPTICAL ASSY ADJUSTMENTS

SPC 8-9

Fig 7 a

INCIDENT
LIGHT

OUTPUT PHOTOCURRENT Y1.    OUTPUT PHOTOCURRENT Y2

P. LAYER                                    ELECTRODES

N. LAYER                                    BIAS

## FIG_8

INCIDENT LIGHT

Y1          Y2

Rpos Y1     Rpos Y2

D    Ip    C    Rsh

Rpos X1     Rpos X2

X1          X2

## FIG_10

X2

Y2

Y1

X1

## FIG_9

L    L

X2

L   Y1    x    Y2

L    y

X1    Sensitive surface

## FIG_11

FIG.12

EP 0 480 825 A2

FIG_13

FIG_14

FIG. 15

FIG. 16

FIG. 9.14

EP 0 480 825 A2

CHALLENGER.C30/V Block Diagram

25

FIG.18

PULSE TRIGGER

IDEAL CURREN SOURCE

A

IDEAL SWITCH

IRLED

FIG. 19

Ideal Diode Driver

+15V

RSET
5 OHMS

LM385
2.5V

7

3 +

2 −

R2
13K

Q1
IRF511

OP-827

DRIVE

R1
32.4K

−15V

FIG. 21

FIG. 20

FIG. 23

FIG. 22

FIG. 24

FIG. 25

**Sensor Plane**

**Remote Body**

**Body Frame**

**Reference Frame**

L = Center of Lens
= Reference Frame origin

FIG. 26

**Sensor Plane**

+ 0

- Actual points
+ Computed Origin

FIG. 27

Head Positive Heading

FIG. 28

90°, 0°

75°, 15°

60°, 30°

45°, 45°

Positive Elevation

FIG. 29

90°, 0°

80°, 10°

70°, 20°

60°, 30°

Positive Roll

FIG 30

FIG. 31a

FIG. 31

Composite Orientation

Negative Track on Alpha

FIG. 32

FIG. 33

Negative Track on Beta

FIG. 34

Displacement on X by Length R

R = DISTANCE FROM THE ORIGIN OF THE REFERENCE FRAME TO THE ORIGIN OF THE REMOTE BODY AS SHOWN BY LINE □ □ □ □

SENSOR PLANE

REMOTE BODY

REFERENCE FRAME

R

FIG. 36

Track on Beta

EP 0 480 825 A2

REFERENCE FRAME

SENSOR PLANE

REMOTE BODY

FIG. 36a

EP 0 480 825 A2

FIG. 37

Label of Points

EP 0 480 825 A2

FIG. 38

Label of Points

EP 0 480 825 A2

(face of sensor)

distance K

E

y

z

∅

x

y

z

F

∅

distance D
(distance along the X axis from the sensor
frame to point E)

FIG. 39

EP 0 480 825 A2

Distances Between Points

FIG. 40

$$D = R\cos\alpha\cos\beta$$

FIG.41